# EUROPEAN PATENT APPLICATION

(11) **EP 2 457 932 A1**
(43) Date of publication of application: **30.05.2012**
(21) Application number: 10802148.6
(22) Date of filing: 25.06.2010
(51) Int. Cl.: C08F 138/00, C08F 136/00, C08L 49/00, H01L 21/312, H01L 21/768, H01L 23/522

(54) **COMPOSITION FOR FILM FORMATION, INSULATING FILM, AND SEMICONDUCTOR DEVICE**

(30) Priority: 21.07.2009 JP 2009170557; 19.02.2010 JP 2010034898; 19.02.2010 JP 2010035289
(71) Applicant: Sumitomo Bakelite Company Limited, Shinagawa-ku Tokyo 140-0002 (JP)
(72) Inventor: NAKAJIMA Michio, Tokyo 140-0002 (JP); SAITO Hidenori, Tokyo 140-0002 (JP); HARADA Takahiro, Tokyo 140-0002 (JP); MATSUTANI Mihoko, Tokyo 140-0002 (JP); TADA Masahiro, Tokyo 140-0002 (JP); NAKATANI Koji, Tokyo 140-0002 (JP)
(74) Representative: TER MEER - STEINMEISTER & PARTNER GbR
(86) International application number: PCT/JP2010/060847
(87) International publication number: WO 2011/010527

(57) **Abstract**

A composition for film formation according to the present invention includes polymerizable compounds each having at least one polymerizable functional group, and the polymerizable compound includes a partial structure containing an adamantane type cage structure and at least one polymerizable reactive group contributing to polymerization reaction in one molecule thereof. Further, the polymerizable reactive group contains an aromatic ring and at least one ethynyl or vinyl group directly bonded to the aromatic ring as the polymerizable functional group, and the number of carbon atoms derived from the aromatic ring is in the range of 15 to 38% with respect to the number of total carbon atoms of the polymerizable compound.

## Description

### TECHNICAL FIELD

The present invention relates to a composition for film formation (that is, a composition for forming insulating film), an insulating film and a semiconductor device.

### BACKGROUND ART

Recently, in the electronic material field, a delay time caused by increase of resistance among wirings of a semiconductor integrated circuit and increase of capacitance is becoming a serious problem in progressing high integration, speed up and superior performance of semiconductor devices. In order to decrease such a delay time to thereby make semiconductor devices more speed up, it is required that an insulating film having low permittivity is used in the circuit.

As such an insulating film, conventionally, an inorganic type interlayer insulating film mainly constituted of silicon such as HSQ (hydrogen-silsesquioxane) and MSQ (methyl-silsesquioxane) is widely used.

However, such an inorganic type interlayer insulating film is likely to be damaged during an etching step where such an interlayer insulating film is formed by patterning.

Namely, during the etching step of the interlayer insulating film, C atoms are removed from the film due to breakage of Si-C bonds contained in the film. As a result, unsaturated bonding hands are generated in the Si atoms. Since the Si atoms are unstable in this state, they are reacted with, for example, water molecules existing in the air, to thereby generate Si-OH bonds. This makes the interlayer insulating film high permittivity.

In order to resolve such a problem, it is considered that properties of the interlayer insulating film are recovered by a damage recovery treatment carried out using a surface treatment of the interlayer insulating film or a damage component removal treatment of the interlayer insulating film using irradiation of an electron beam (see, for example, Patent Document 1: JP-A 2007-266099, Patent Document 2: JP-A 2007-317817).
However, according to these methods, in the case where wirings insulated by the interlayer insulating film are formed so as to have smaller widths, there is a problem in that the damage which the interlayer insulating film suffers cannot be sufficiently recovered or the number of steps of recovering the properties of the interlayer insulating film increases.

Further, it is also considered that an organic type interlayer insulating film is used instead of the inorganic type interlayer insulating film. However, the use of the organic type interlayer insulating film has not yet led to sufficiently decrease the damage which would be generated during the etching step.

### OUTLINE OF THE INVENTION

It is an object of the present invention to provide a composition for film formation which hardly suffers damage during an etching step and can form an insulating film maintaining film properties thereof, an insulating film formed using such a composition for film formation, and a semiconductor device provided with such an insulating film.

In order to achieve the object described above, the present invention includes the following features (1) to (18).
(1) A composition for film formation comprising:
   polymerizable compounds each having at least one polymerizable functional group,
   wherein each of the polymerizable compounds includes a partial structure containing an adamantane type cage structure and at least one polymerizable reactive group contributing to polymerization reaction in one molecule thereof,
   wherein the polymerizable reactive group contains an aromatic ring and at least one ethynyl or vinyl group directly bonded to the aromatic ring as the polymerizable functional group, and
   wherein the number of carbon atoms derived from the aromatic ring is in the range of 15 to 38% with respect to the number of total carbon atoms of the polymerizable compound.

(2) The composition for film formation according to the above feature (1), wherein the at least one polymerizable reactive group comprises two polymerizable reactive groups which are symmetrically located about the partial structure.

(3) The composition for film formation according to the above feature (1) or (2), wherein the aromatic ring is directly bonded to the cage structure.

(4) The composition for film formation according to any one of the above features (1) to (3), wherein the at least one ethynyl or vinyl group of the polymerizable reactive group comprises two ethynyl or vinyl groups, and one of the ethynyl or vinyl groups is located in a meta position relative to the other ethynyl or vinyl group.

(5) The composition for film formation according to the above feature (4), wherein both the two ethynyl or vinyl groups are located in meta positions relative to a position of the aromatic ring to which the cage structure is bonded.

(6) The composition for film formation according to the above feature (4) or (5), wherein some of the polymerizable compounds are polymerized with each other via the one ethynyl or vinyl groups to form a polymer.

(7) The composition for film formation according to any one of the above features (1) to (6), wherein the partial structure contains an adamantane structure as the adamantane type cage structure.

(8) The composition for film formation according to the above feature (7), wherein the adamantane structure has a methyl group as a substituent thereof.

(9) The composition for film formation according to the above feature (8), wherein the polymerizable compound has a structure represented by the following formula (1) :

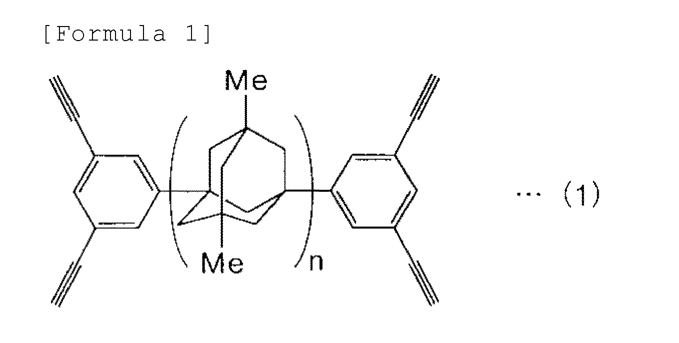

where n is an integral number of 1 to 5.

(10) The composition for film formation according to any one of the above features (1) to (6), wherein the partial structure contains a diamantane structure as the adamantane type cage structure.

(11) The composition for film formation according to any one of the above features (1) to (10), wherein the composition does not contain any pore generation agent having a function of generating pores into an obtained insulating film due to thermal decomposition thereof.

(12) An insulating film formed using the composition for film formation according to any one of the above features (1) to (11).

(13) The insulating film according to the above feature (12), wherein in the case where a surface of the insulating film is etched by a reactive ion etching method using a mixture gas of nitrogen gas and hydrogen gas or ammonia gas as a treatment gas, a changing ratio of permittivity of the surface before and after being etched is 10% or less.

(14) The insulating film according to the above feature (12) or (13), wherein in the case where the insulating film is etched by a reactive ion etching method using a mixture gas of nitrogen gas and hydrogen gas or ammonia gas, an etching rate thereof is in the range of 10 to 90 Å/sec.
(15) The insulating film according to any one of the above features (12) to (14), wherein permittivity of the insulating film is in the range of 1.80 to 2.30.
(16) The insulating film according to any one of the above features (12) to (15), wherein in the case where the insulating film and a SiO film are etched using a fluorine-based gas, an etching rate of the insulating film is 0.75 times or less that of the SiO film.
(17) The insulating film according to any one of the above features (12) to (16), wherein adhesive strength between the insulating film and a SiCN film, which is measured by a m-ELT method (Modified-Edge Lift off Test), is in the range of 0.15 to 0.35 MPa · m^{(1/2)}.

(18) A semiconductor device comprising the insulating film according to any one of the above features (12) to (17).

### BRIEF DESCRIPTION OF THE DRAWINGS

FIG. 1 is a longitudinal sectional view showing one example of a method for forming an interlayer insulating film patterned in a predetermined shape.
FIG. 2 is a longitudinal sectional view schematically showing one example of the semiconductor device of the present invention.
FIG. 3 is a longitudinal sectional view showing a preferred embodiment of a method for manufacturing a semiconductor device.
FIG. 4 is a longitudinal sectional view showing the preferred embodiment of the method for manufacturing a semiconductor device, which is continued from FIG. 3.
FIG. 5 is a longitudinal sectional view showing the preferred embodiment of the method for manufacturing a semiconductor device, which is continued from FIG. 4.

### MODE FOR CARRYING OUT THE INVENTION

Hereinbelow, the present invention will be described in detail.

### <Composition for Film Formation>

First, a composition for film formation of the present invention will be described.

The composition for film formation of the present invention includes polymerizable compounds X each having at least one polymerizable reactive functional group. Each of the polymerizable compounds X is **characterized in that** it includes a partial structure A containing an adamantane type cage structure and at least one polymerizable reactive group B contributing to polymerization reaction in one molecule thereof, the polymerizable reactive group B contains an aromatic ring and at least one ethynyl or vinyl group directly bonded to the aromatic ring, and the number of carbon atoms derived from the aromatic ring is in the range of 15 to 38% with respect to the number of total carbon atoms of the polymerizable compound X.
Use of such a composition for film formation makes it possible to reliably form an insulating film which hardly suffers damage damages even in the case where an etching treatment is subjected thereto. Such an insulating film does not tend to have high permittivity so that it can maintain film properties thereof.

Hereinbelow, the polymerizable compound X will be described.
In this regard, although the polymerizable compounds X are polymerized with each other via polymerizable functional groups thereof, each of the polymerizable functional groups is the ethynyl or vinyl group contained in the polymerizable reactive group B. Since the ethynyl group and the vinyl group exhibit the same function, the following description will be made on the polymerizable reactive group B containing the ethynyl group(s) as one example.

### [1] Polymerizable Compound X

The polymerizable compound X includes the partial structure A containing the adamantane type cage structure and the at least one polymerizable reactive group B contributing to the polymerization reaction in one molecule thereof.

Hereinbelow, the partial structure A and the polymerizable reactive group B will be described, respectively.

### [1.1] Partial Structure A

The partial structure A included in the polymerizable compound X contains the adamantane type cage structure. This makes it possible to form a film (insulating film) having low density and low permittivity (dielectric constant) using the composition for film formation. Further, this also makes it possible to appropriately control reactivity of the polymerizable compound X including the polymerizable reactive group B as described below in detail.
Therefore, it is possible to reliably adjust viscosity of the composition for film formation to an optimal value when being applied onto a member for film formation (e.g., a semiconductor substrate), to thereby suppress involuntary thickness or property variation of every portions of a film to be formed, and to finally obtain a film having superior strength.
Furthermore, this also makes it possible to set an etching rate of a film (insulating film), which is to be formed using the composition for film formation, to a relatively low value during an etching step of patterning it into a predetermined shape.

Examples of the partial structure A, which the polymerizable compound X has, include: a divalent group which is a structure obtained by removing two constituent hydrogen atoms from a compound such as adamantane, poly-adamantane (e.g., bi-adamantane, triadamantane, tetra-adamantane, penta-adamantane, hexa-adamantane, hepta-adamantane), poly-amantane (e.g., di-amantane, tri-amantane, tetra-amantane, penta-amantane, hexa-amantane, hepta-amantane) or derivatives thereof in which at least one constituent hydrogen atom is substituted into an alkyl group or a halogen atom; a group containing two or more of these divalent groups such as a group containing a poly(di-amantane) skeleton formed by bonding a plurality of di-amantane skeletons (e.g., a bi(di-amantane) skeleton, a tri(di-amantane) skeleton, a tetra(di-amantane) skeleton), a group containing a poly(tri-amantane) skeleton formed by bonding a plurality of tri-amantane skeletons (e.g., a bi(tri-amantane) skeleton, a tri(tri-amantane) skeleton, a tetra(tri-amantane) skeleton) or a group formed by bonding an adamantane skeleton (or a poly-adamantane skeleton) to a poly-amantane skeleton.
Hereinbelow, although some examples of the partial structure A are shown by the following chemical constitution formulas, the partial structure A is limited thereto. In this regard, it is to be noted that each of R¹ and R² is independently a hydrogen atom, an alkyl group or a halogen group, each of 1, m and n is independently an integral number of 1 or more in each of the following formulas (A-1) to (A-7).

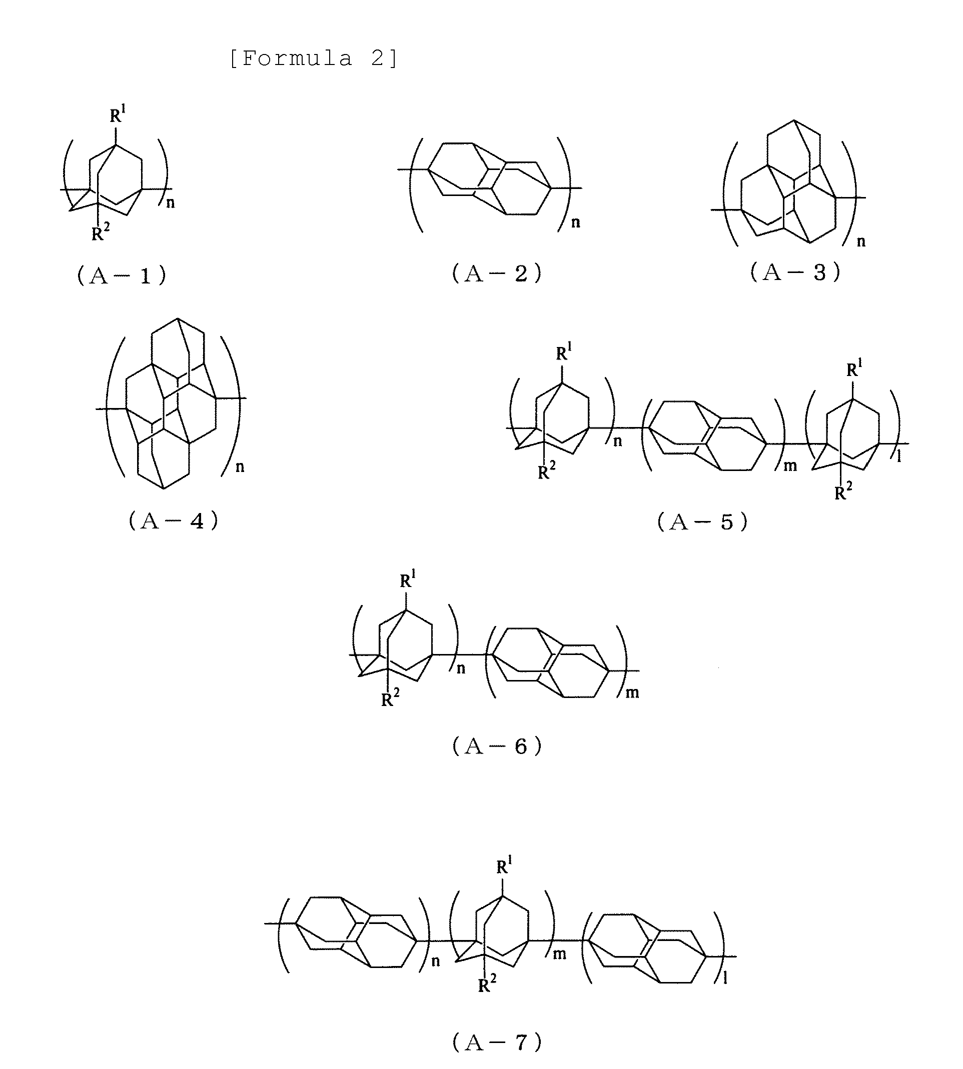

Further, it is preferred that the partial structure A contains an adamantane structure as the adamantane type cage structure. This makes it possible to form a film (insulating film) having lower permittivity using the composition for film formation, to thereby effectively prevent or suppress the film from having high permittivity during an etching step of patterning it into a predetermined shape.
Further, this also makes it possible to more appropriately control the reactivity of the polymerizable compound X. Therefore, it is possible to more reliably adjust the viscosity of the composition for film formation to an optimal value when being applied onto the member for film formation (e.g., the semiconductor substrate), to thereby more effectively suppress the involuntary thickness or property variation of every portions of the film to be formed, and to finally obtain a film having especially superior strength.

Furthermore, it is preferred that the adamantane structure has a methyl groups as a substituent thereof. This makes it possible to form a film having especially low permittivity using the composition for film formation. Further, this also makes it possible to more appropriately control the reactivity of the polymerizable compound X.
Therefore, it is possible to more reliably adjust the viscosity of the composition for film formation to an optimal value when being applied onto the member for film formation (e.g., the semiconductor substrate), to thereby more effectively suppress the involuntary thickness or property variation of every portions of the film to be formed, and to finally obtain a film having especially superior strength.
Furthermore, this also makes it possible to set the etching rate of the film (insulating film), which is to be formed using the composition for film formation, to a relatively low value during the etching step of patterning it into the predetermined shape.

For these reasons, a group having a structure represented by the following formula (2) is preferably used as the partial structure A. In this regard, it is to be noted that n is an integral number of 1 or more in the following formula (2).

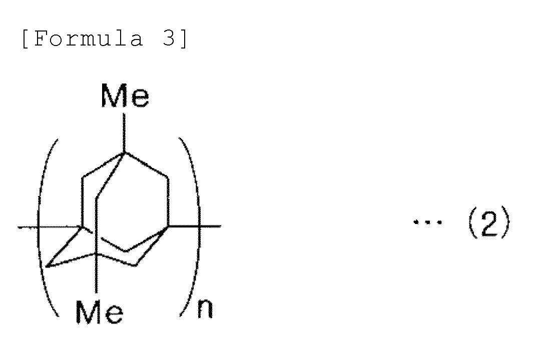

By selecting the group having such a structure as the partial structure A, the film to be formed using the composition for film formation can exhibit more remarkably the above mentioned effects.

In this regard, it is preferred that such a partial structure A itself is a symmetric structure. Namely, it is preferred that n is an even number in the above formula (2). This makes it possible to more appropriately control the reactivity of the polymerizable compound X. Therefore, it is possible to more reliably adjust the viscosity of the composition for film formation to an optimal value when being applied onto the member for film formation (e.g., the semiconductor substrate), to thereby more effectively suppress the involuntary thickness or property variation of every portions of the film to be formed, and to finally obtain a film having especially superior strength.

Further, the partial structure A may contain a diamantane structure as the adamantane type cage structure. This makes it possible to form a film having especially low permittivity using the composition for film formation. Further, this also makes it possible to more appropriately control the reactivity of the polymerizable compound X.
Therefore, it is possible to more reliably adjust the viscosity of the composition for film formation to an optimal value when being applied onto the member for film formation (e.g., the semiconductor substrate), to thereby more effectively suppress the involuntary thickness or property variation of every portions of the film to be formed, and to finally obtain a film having especially superior strength.

### [1.2] Polymerizable Reactive Group B

The polymerizable compound X contains the at least one polymerizable reactive group B in addition to the partial structure A as described above.

The polymerizable reactive group B contains the aromatic ring and the at least one ethynyl group directly bonded to the aromatic ring. The polymerizable compound X may contain one polymerizable reactive group B, but preferably contains two polymerizable reactive groups B which are symmetrically located about the partial structure A.
This makes it possible to appropriately control the reactivity of the polymerizable compound X. Therefore, it is possible to reliably adjust viscosity of the composition for film formation to an optimal value when being applied onto the member for film formation (e.g., the semiconductor substrate), to thereby suppress the involuntary thickness or property variation of every portions of the film to be formed, and to finally obtain a film having especially superior strength.

As described above, the polymerizable compound X contains the two polymerizable reactive groups B together with the partial structure A, and they are located in a predetermined positional relationship. This makes it possible for the polymerizable compound X to exhibit especially excellent effects.

Examples of the aromatic ring constituting the polymerizable reactive group B include: but are not limited to; a hydrocarbon ring type aromatic ring such as a benzene ring, a naphthalene ring, an anthracene ring, a naphthacene ring, a phenanthrene ring, a chrysene ring, a pyrene ring, a perylene ring, a coronene ring, a biphenyl ring, a terphenyl ring or a azulene ring; a hetero ring type aromatic ring such as a pyridine ring, a furan ring, a thiofuran ring, a pyrrole ring, an oxazole ring, an indole ring, a purine ring, a benzofuran ring, a benzothiophene ring, a carbazole ring, an imidazole ring, a thiazol ring, a pyrazole ring, an isoxazole ring, an isothiazole ring, a quinoline ring or a terthienyl ring; and the like.
Among them, the benzene ring is preferable as the aromatic ring. This makes it possible to easily apply the composition for film formation onto the member for film formation (e.g., the semiconductor substrate). Further, this also makes it possible to from a film having good elastic modulus using the composition for film formation. Such a film becomes more excellent in strength, heat resistance, an adhesive property with respect to the member (e.g., the semiconductor substrate) or the like.

Although the aromatic ring constituting the polymerizable reactive group B may be bonded to the cage structure constituting the partial structure A via at least one atom, it is preferred that the aromatic ring is directly bonded to the cage structure constituting the partial structure A. This makes it possible to more appropriately control the reactivity of the polymerizable compound X.
Therefore, it is possible to more reliably adjust the viscosity of the composition for film formation to an optimal value when being applied onto the member for film formation (e.g., a semiconductor substrate), to thereby more effectively suppress the involuntary thickness or property variation of every portions of the film to be formed, and to finally obtain a film having especially superior strength.

The polymerizable reactive group B may contain one ethynyl group, but preferably contains two ethynyl groups each of which is directly bonded to the aromatic ring described above. In this case, since the polymerizable reactive group B contains the two ethynyl groups as reactive portions, initial reaction between the polymerizable compounds X easily occurs. On the other hand, in the case where one of the ethynyl groups, which the polymerizable reactive group B contains, is used for the reaction (polymerization reaction), an electronic state of the aromatic ring is changed so that reactivity of the other ethynyl group is rapidly lowered.
For this reason, only one of the ethynyl groups, which the polymerizable reactive group B contains, is selectively used for the reaction under relatively mild conditions. Since each of the polymerizable compounds X preferably includes the two polymerizable reactive groups B in one molecule thereof, the polymerizable compounds X can selectively use only the one ethynyl groups of the polymerizable reactive groups B existing in one molecule thereof for the reaction.
In this case, it is possible to obtain a polymer (linear polymer) in which the plurality of polymerizable compounds X are polymerized with each other in one-dimensional manner through the reaction represented by the following formula (3).

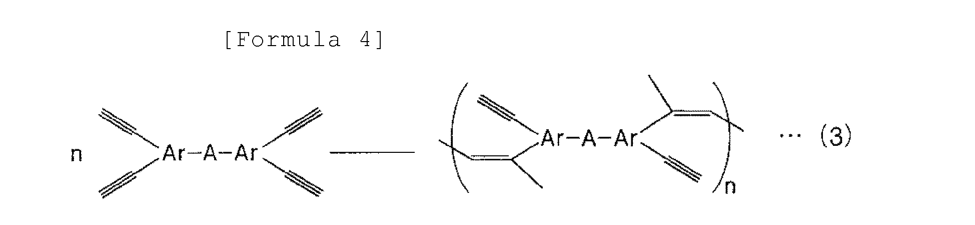

where A is the partial structure A, Ar is the aromatic ring constituting the polymerizable reactive group B and n is an integral number of 2 or more.

In this regard, in the case where the polymerizable reactive group B includes the vinyl groups instead of the ethynyl groups, it is possible to obtain a polymer (linear polymer) in which the plurality of polymerizable compounds X are polymerized with each other in one-dimensional manner through the reaction represented by the following formula (3').

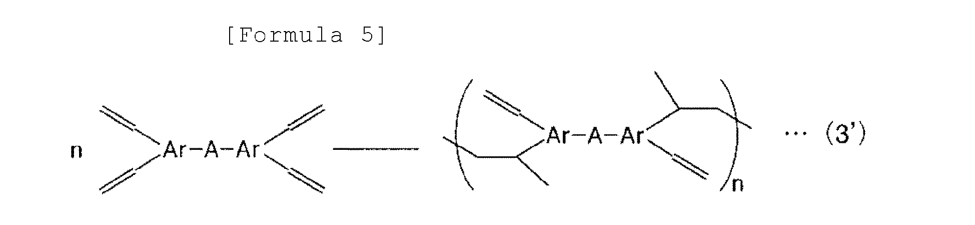

where A is the partial structure A, Ar is the aromatic ring constituting the polymerizable reactive group B and n is an integral number of 2 or more.

In the case where the above reaction occurs, it is possible to reliably prevent excessive reaction between the polymerizable compounds X so that the viscosity of the composition for film formation does not become too high (that is, the composition for film formation does not gelate or gelatinize) during storage thereof or the like. This makes it possible to reliably adjust the viscosity of the composition for film formation to an optimal value when being applied onto the member for film formation (e.g., the semiconductor substrate). As a result, it is possible to reliably suppress the involuntary thickness or property variation of every portions of the film to be formed from being generated.

On the other hand, the polymer obtained through the above reaction (that is, the polymer obtained by partial polymerization reaction) has the unreacted ethynyl groups. Therefore, the polymers are reacted with each other via the remaining ethynyl groups under the below mentioned baking conditions (that is, heating conditions on a semiconductor substrate), to thereby form a three-dimensional crosslinking structure within the finally obtained film. As a result, the formed film can have more excellent heat resistance or the like.

In the case where each polymerizable reactive group B constituting the polymerizable compound X contains the two ethynyl groups as described above, it is preferred that one of the ethynyl groups is located in a meta position relative to the other ethynyl group in the polymerizable reactive group B. In this case, in a state that the one ethynyl group among the two ethynyl groups, which the polymerizable reactive group B contains, is used for the reaction (polymerization reaction), the aromatic ring or the like can exhibit electronic effects thereof more remarkably, to thereby more reliably lower the reactivity of the other ethynyl group.
Further, in the above state, the portions formed by the reaction also become moderate steric hindrances, which makes it possible to more appropriately control the reactivity of the other ethynyl group (that is, the unreacted ethynyl group). As a result, it is possible to further improve selectivity of the reactivities of the two ethynyl groups, which the polymerizable reactive group B contains, (that is, the reactivity in the first reaction and the reactivity in the second reaction) and to carry out a baking step described below under the more preferable conditions in which the film can be formed in superior productivity while preventing a semiconductor substrate from suffering damage.

Further, in the case where the polymerizable reactive group B contains the two ethynyl groups, it is preferred that both the two ethynyl groups are located in meta positions relative to a position of the aromatic ring to which the cage structure is bonded. In this case, in a state that the one ethynyl group among the two ethynyl groups, which the polymerizable reactive group B contains, is used for the reaction (polymerization reaction), the aromatic ring or the like can exhibit electronic effects thereof more remarkably, to thereby more reliably lower the reactivity of the other ethynyl group.
Further, in the above state, the portions formed by the reaction and the above mentioned partial structure A also become moderate steric hindrances, which makes it possible to more appropriately control the reactivity of the other ethynyl group (that is, the unreacted ethynyl group). As a result, it is possible to further improve selectivity of the reactivities of the two ethynyl groups, which the polymerizable reactive group B contains, (that is, the reactivity in the first reaction and the reactivity in the second reaction) and to carry out a baking step described below under the more preferable conditions in which the film can be formed in superior productivity while preventing a semiconductor substrate from suffering damage.

Here, as described above, the polymerizable compound X includes the partial structure A and the polymerizable reactive group(s) B in one molecule thereof. In the present invention, the number of carbon atoms derived from the aromatic ring is in the range of 15 to 38%, and preferably in the range of 18 to 27% with respect to the number of total carbon atoms of the polymerizable compound X. By setting the number of the carbon atoms derived from the aromatic ring to a value falling within the above range, an abundance ratio between the partial structure A and the polymerizable reactive group(s) B becomes appropriate. This makes it possible to synergistically obtain the effect resulting from the existence of the partial structure A and the effect resulting from the existence of the polymerizable reactive group(s) B.

Especially, it is possible to more effectively suppress or prevent the film (insulating film) formed using the composition for film formation from having high permittivity during the etching step of patterning such a film into a predetermined shape, to thereby reliably maintain the film properties thereof.

In this regard, it is conceived that increase of the permittivity of the film is caused by, for example, the following physical effect and chemical effect during the etching step.

In the physical effect, an etching gas accelerated by plasma is impacted to the film so that irregularities are formed on a surface thereof, and then moisture absorbs on the surface of the film. This is likely to cause a film property change of the film.

Further, in the chemical effect, an etching gas is changed into ion or radical by plasma, and then they are impacted to the film so that structural change thereof is produced due to breakage of chemical bonds in the film. This is also likely to cause the film property change of the film.

By setting the number of the carbon atoms derived from the aromatic ring in the polymerizable compound X to a value falling within the above range, it is possible to more effectively suppress or prevent the permittivity of the film from increasing by such a physical effect and chemical effect.

Further, since an etching rate of the insulating film is reduced during the etching step, it is possible to etch the surface of the insulating film relatively mildly. Therefore, the physical effect and chemical effect act on the insulating film restrictively in the vicinity of the surface thereof. This makes it possible to suppress a modified layer (etching damage layer), which would be formed in the surface of the insulating film by the etching, from being also formed inside thereof. From such a viewpoint, it is also possible to effectively suppress or prevent the properties of this film form being deteriorated or altered.

As the polymerizable compound X satisfying the above conditions, that is, the polymerizable compound X in which the number of the carbon atoms derived from the aromatic ring is set to an appropriate value by selecting a preferable partial structure A and polymerizable reactive group B, exemplified is one having a structure represented by the following formula (1). In this regard, it is to be noted that n is an integral number of 1 to 5 in the following formula (1) .

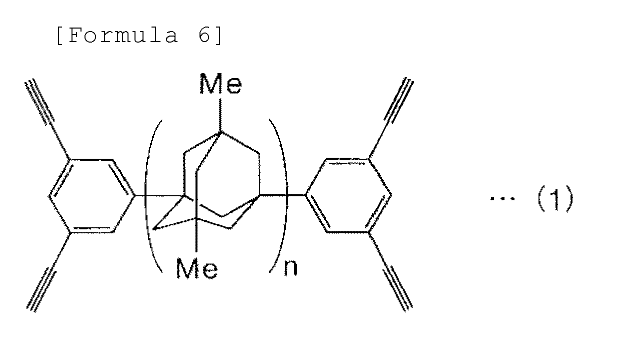

By selecting the polymerizable compound X having such a structure, the film (insulating film) formed using the composition for film formation can more remarkably exhibit the above mentioned effects.

In this regard, although the polymerizable compound X having the structure represented by the above formula (1) includes the two polymerizable reactive groups B, as a polymerizable compound X including one polymerizable reactive group B, exemplified is one having a structure represented by the following formula (1'). In this regard, it is to be noted that n is an integral number of 1 or 2 in the following formula (1').

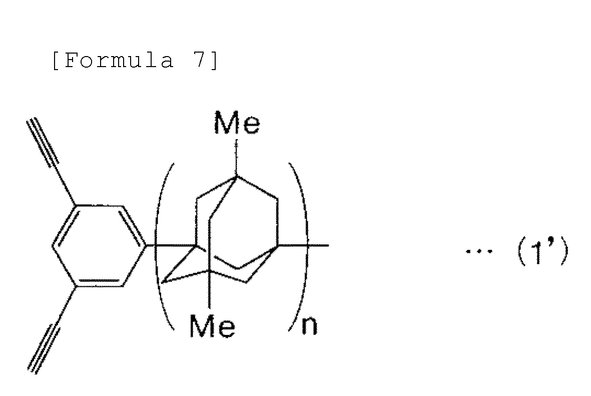

In this regard, it is to be noted that the polymerizable compound X may further include a partial structure other than the partial structure A and the polymerizable reactive group(s) B.

In the case of the polymerizable compound X including the two polymerizable reactive groups B each containing the two ethynyl groups, such a polymerizable compound X can be, for example, synthesized as follows.

Namely, the desired polymerizable compound X can be obtained by a method including: a step of reacting a compound A' corresponding to the partial structure A (that is, a compound in which two hydrogen atoms are bonded to the partial structure A as the divalent group) with bromine to obtain a dibromo body of the compound A' (that is, a compound in which two bromo groups are bonded to the partial structure A); a step of reacting the dibromo body of the compound A' with dibromobenzene to obtain a bis(dibromo phenyl) body of the compound A' (that is, a compound in which two dibromo phenyl groups are bonded to the partial structure A); a step of reacting the bis(dibromo phenyl) body of the compound A' with trimethyl silyl acetylene to obtain a bis(di(trimethyl silyl ethynyl) phenyl) body of the compound A' (that is, a compound in which two di(trimethyl silyl ethynyl) phenyl groups are bonded to the partial structure A); and a step of hydrolyzing (demethyl silanizing) the bis(di(trimethyl silyl ethynyl) phenyl) body of the compound A'.

In this regard, in the case where the polymerizable reactive group B contains two vinyl groups instead of the two ethynyl groups, such a polymerizable compound X can be, for example, synthesized as follows.

Namely, the desired polymerizable compound X can be obtained by synthesizing the above mentioned polymerizable compound X containing the two ethynyl groups, and then subjecting the same to, for example, Lindlar reduction using hydrogen gas, Brich reduction using sodium and liquid ammonia, diimide reduction using diimide or the like.

The composition for film formation may include the above mentioned polymerizable compounds X alone. Further, in the case where, for example, the polymerizable compound X includes the two polymerizable reactive groups B and/or the polymerizable reactive group contains the two ethynyl groups, the composition for film formation further may include a polymer obtained by partially polymerizing some of the polymerizable compounds X with each other (that is, a prepolymer obtained by polymerizing some of the polymerizable compounds X with each other via one of the two polymerizable reactive groups B or a prepolymer obtained by polymerizing some of the polymerizable compounds X with each other via one of the two ethynyl groups which the polymerizable reactive group B contains).
In the case where the composition for film formation includes the polymer (prepolymer) obtained by partially polymerizing some of the polymerizable compounds X with each other, it is possible to more reliably adjust the viscosity of the composition for film formation to an optimal value. This makes it possible to more effectively suppress the involuntary thickness or property variation of every portions of the film to be formed, and to finally obtain a film having superior strength. Further, by subjecting the composition for film formation to a heat treatment prior to being applied onto the member for film formation (e.g., the semiconductor substrate), it is possible to suitably form a film having a reliable thick thickness.
Further, in the case where the composition for film formation includes the prepolymer of the polymerizable compounds X, when the film is formed on the member (e.g., the semiconductor substrate), heat quantity applied to the composition for film formation on the member can be reduced. This makes it possible to more reliably prevent damages of the member due to the heat from being suffered. Such a composition for film formation including the prepolymer of the polymerizable compounds X can be appropriately used as a varnish for insulating film.

The composition for film formation including the polymer (prepolymer) obtained by partially polymerizing some of the polymerizable compounds X with each other can be suitably prepared by, for example, subjecting the polymerizable compounds X to a heat treatment. In this case, as a condition for the heat treatment, it is preferred that a heat temperature is in the range of 120 to 190°C and a heat time is in the range of 3 to 11 hours, and more preferred that the heat temperature is in the range of 140 to 180°C and a heat time is in the range of 3 to 9 hours.
Further, the heat treatment to the polymerizable compounds X may be carried out by combining different conditions. For example, the polymerizable compounds X may be subjected to a first heat treatment at a condition in which the heat temperature is in the range of 150 to 190°C and a heat time is in the range of 1 to 6 hours and a second heat treatment at a condition in which the heat temperature is in the range of 120 to 160°C and a heat time is in the range of 2 to 9 hours.
In this regard, it is preferred that the above heat treatment(s) is(are) carried out in a state that the polymerizable compounds X are dissolved into a solvent. Further, the synthesis of the prepolymer by the heat treatment(s) described above may be performed in a solvent which is a below mentioned component of the composition for film formation or performed in a solvent constituted from a component different from the component of the composition for film formation. Namely, the prepolymer is obtained by polymerizing the polymerizable compounds X with each other in a predetermined solvent, and then the solvent may be replaced by a solvent which is a component of a desired composition for film formation.
Examples of the solvent (reaction solvent) capable of being used for synthesizing the polymer (prepolymer) obtained by partially polymerizing some of the polymerizable compounds X with each other include: an alcohol type solvent such as methanol, ethanol, isopropanol, 1-butanol or 2-butanol; a ketone type solvent such as acetone, acetyl acetone, methyl ethyl ketone, methyl isobutyl ketone, cyclohexanone, cyclopentanone, 2-pentanone or 2-heptanone; an ester type solvent such as ethyl acetate, propyl acetate, butyl acetate, pentyl acetate or propylene glycol monomethyl ether acetate; an ether type solvent such as diisopropyl ether, dibutyl ether, diphenyl ether, tetrahydrofuran, anisole, 1,2-dimethoxy benzene, 1,3-dimethoxy benzene or 1,4-dimethoxy benzene; an aromatic or aliphatic hydrocarbon type solvent such as benzene, toluene, mesitylene, ethyl benzene, diethyl benzene, propyl benzene, heptane, hexane or n-octane; a halide type solvent such as chloromethane, dichloromethane, chloroform, dichloroethane or carbon tetrachloride; an amide type solvent such as N-methyl pyrrolidone; and the like. One selected from these solvents or a combination of two or more selected therefrom can be used.
Further, the step of obtaining the prepolymer of the polymerizable compounds X may be performed by a heat polymerization method in which they are reacted with each other by being heated without using a catalyst; a radical polymerization method in which they are reacted with each other using a radical initiator such as benzoyl peroxide, t-butyl peroxide or azobis isobutyronitrile; a photoradical polymerization method in which they are reacted with each other using photoirradiation or the like; a polymerization method in which they are reacted with each other using a palladium catalyst such as dichloro bis(triphenyl phosphine) palladium(II), bis(benzonitrile) palladium(II) dichloride or tetrakis(triphenyl phosphine) palladium(0); a polymerization method in which they are reacted with each other using a transition metal catalyst such as copper acetate(II); a polymerization method in which they are reacted with each other using a transition metal chloride such as molybdenum(V) chloride, tungsten(VI) chloride or tantalum(V) chloride; and the like.
Among them, the heat polymerization method or the radical polymerization method using the radical initiator is preferable. This is because it is easy to obtain the desired polymer by controlling the reaction of the polymerizable compounds X and because it does not need to remove impurities which would be produced by remaining the metal catalyst or the like.
In the case of the preparation by the heat polymerization, as a condition for the heat treatment, it is preferred that a heat temperature is in the range of 120 to 190°C and a heat time is in the range of 3 to 11 hours, and more preferred that the heat temperature is in the range of 140 to 180°C and a heat time is in the range of 3 to 9 hours. Further, in the case of the preparation by the radical polymerization method using the radical initiator, as a condition for the heat treatment, it is preferred that a heat temperature is in the range of 40 to 190°C and a heat time is in the range of 0.5 to 11 hours, and more preferred that the heat temperature is in the range of 60 to 180°C and a heat time is in the range of 0.5 to 9 hours.
Further, the heat treatment to the composition obtained in the above step (that is, the composition including the polymerizable compounds) may be carried out by combining different conditions. For example, in the heat polymerization method, the composition obtained in the above step (that is, the composition including the polymerizable compounds) may be subjected to a first heat treatment at a condition in which the heat temperature is in the range of 150 to 190°C and a heat time is in the range of 1 to 6 hours and a second heat treatment at a condition in which the heat temperature is in the range of 120 to 160°C and a heat time is in the range of 2 to 9 hours, or further additional heat treatments, if needed.
Further, in the radical polymerization method using the radical initiator, the composition obtained in the above step (that is, the composition including the polymerizable compounds) may be subjected to a first heat treatment at a condition in which the heat temperature is in the range of 60 to 190°C and a heat time is in the range of 0.5 to 6 hours and a second heat treatment at a condition in which the heat temperature is in the range of 40 to 160°C and a heat time is in the range of 0.5 to 9 hours, or further additional heat treatments, if needed.
In this regard, it is preferred that the above heat treatment(s) is(are) carried out in a state that the composition obtained in the above step (that is, the composition including the polymerizable compounds) is dissolved into a solvent. Further, the synthesis of the prepolymer by the heat treatment(s) described above may be performed in a solvent which is a component of the composition for film formation to be prepared or performed in a solvent constituted from a component different from the component of the composition for film formation. Namely, the prepolymer is obtained by polymerizing the polymerizable compounds X with each other in a predetermined solvent, and then the solvent may be replaced by a solvent which is a component of a desired composition for film formation.
Examples of the solvent (reaction solvent) capable of being used for synthesizing the polymer (prepolymer) obtained by partially polymerizing some of the polymerizable compounds X with each other include: an alcohol type solvent such as methanol, ethanol, isopropanol, 1-butanol or 2-butanol; a ketone type solvent such as acetone, acetyl acetone, methyl ethyl ketone, methyl isobutyl ketone, cyclohexanone, cyclopentanone, 2-pentanone or 2-heptanone; an ester type solvent such as ethyl acetate, propyl acetate, butyl acetate, pentyl acetate or propylene glycol monomethyl ether acetate; an ether type solvent such as diisopropyl ether, dibutyl ether, diphenyl ether, tetrahydrofuran, anisole, 1,2-dimethoxy benzene, 1,3-dimethoxy benzene or 1,4-dimethoxy benzene; an aromatic or aliphatic hydrocarbon type solvent such as benzene, toluene, mesitylene, ethyl benzene, diethyl benzene, propyl benzene, heptane, hexane or n-octane; a halide type solvent such as chloromethane, dichloromethane, chloroform, dichloroethane or carbon tetrachloride; an amide type solvent such as N-methyl pyrrolidone; and the like. One selected from these solvents or a combination of two or more selected therefrom can be used.

In this regard, in the case where the composition for film formation includes the prepolymer of the polymerizable compounds X, it is preferred that the unreacted polymerizable compounds X are removed therefrom by purification (that is, the unreacted polymerizable compounds X are not included therein as much as possible). This makes it possible to further improve various properties such as strength of the film formed using the composition for film formation in a more reliable manner.

It is preferred that a sum of an amount of the polymerizable compounds X included in the composition for film formation and an amount of the polymer obtained by partially polymerizing some of the polymerizable compounds X with each other (that is, the prepolymer obtained by polymerizing some of the polymerizable compounds X with each other via one of the two polymerizable reactive groups B or the prepolymer obtained by polymerizing some of the polymerizable compounds X with each other via one of the two ethynyl groups which the polymerizable reactive group B contains) included therein is in the range of 1.0 to 30 wt%.

### [2] Solvent

As described above, the composition for film formation may include the polymerizable compounds X, and further the polymer obtained by partially polymerizing some of the polymerizable compounds X with each other (that is, the prepolymer obtained by polymerizing some of the polymerizable compounds X with each other via only one of the two polymerizable reactive groups B or the prepolymer obtained by polymerizing some of the polymerizable compounds X with each other via one of the two ethynyl groups which the polymerizable reactive group B contains) in the case of the polymerizable compound including the two polymerizable reactive groups B and/or the polymerizable reactive group B containing the two ethynyl groups, but generally contains a solvent capable of dissolving them.

Examples of the solvent include N-methyl-2-pyrolidone, γ-butyrolactone, N,N-dimethyl acetamide, dimethyl sulfoxide, diethylene glycol dimethyl ether, diethylene glycol diethyl ether, diethylene glycol dibutyl ether, propylene glycol monomethyl ether, dipropylene glycol monomethyl ether, propylene glycol monomethyl ether acetate, methyl lactate, ethyl lactate, butyl lactate, methyl-1,3-butylene glycol acetate, 1,3-butylene glycol-3-monomethyl ether, methyl pyruvate, ethyl pyruvate, methyl-3-methoxy propionate, methyl ethyl ketone, methyl isobuthyl ketone, cyclopentanone, cyclohexanone, tetrahydrofuran, anisole, mesitylene and the like. One selected from these solvents or a combination of two or more selected therefrom can be used.
Among them, the cyclopentanone and the cyclohexanone are preferable as the solvent. The solvent constituting the composition for film formation may contain, for example, the solvent (reaction solvent) used for the synthesis of the polymerizable compound X or the synthesis of the above mentioned polymer (that is, the prepolymer obtained by partially polymerizing some of the polymerizable compounds X with each other) or the like.

An amount of the solvent included in the composition for film formation is not limited to a specific value, but is in the range of 70 to 99 wt%.

### [Other Ingredients]

The composition for film formation may include ingredients other than the above ingredients. Examples of such ingredients include a surface active agent, a coupling agent such as silane coupling agent, a catalyst such as a radical initiator or disulfides, and the like.

Further, the composition for film formation may include a naphthoquinone diazide compound or the like as a photosensitizer. This makes it possible to appropriately use the composition for film formation for forming a surface protective film having photosensitivity.

In this regard, in the present invention, it is preferred that the composition for film formation does not include any pore generation agent which foams due to thermal decomposition thereof, to thereby generate pores into a film to be formed. Although a pore generation agent is, conventionally, used in order to lower permittivity of a film, use of such a pore generation agent causes problems such as lowering of strength of a film to be formed and involuntary thickness or property variation of every portions of the film.
On the other hand, in the present invention, since the composition for film formation includes the polymerizable compounds X as described above, and further the polymer obtained by partially polymerizing some of the polymerizable compounds X with each other (that is, the prepolymer obtained by polymerizing some of the polymerizable compounds X with each other via one of the two polymerizable reactive groups B or the prepolymer obtained by polymerizing some of the polymerizable compounds X with each other via one of the two ethynyl groups which the polymerizable reactive group B contains) in the case of the polymerizable compound X including the two polymerizable reactive groups B and/or the polymerizable reactive group B containing the two ethynyl groups, it is possible to sufficiently lower permittivity of a film to be formed even if the pore generation agent is not used. In the case where the composition for film formation includes no pore generation agent, it is possible to reliably prevent occurrence of the above problems.

The composition for film formation as described above may be directly used for forming a film. However, in the case where the polymerizable compound X includes the two polymerizable reactive groups B and/or the polymerizable reactive group B contains the two ethynyl groups, the composition for film formation may be subjected to a heat treatment prior to being applied onto the member for film formation (e.g., the semiconductor substrate). This makes it possible for the composition for film formation to include the polymer (prepolymer) obtained by partially polymerizing some of the polymerizable compounds X with each other. Therefore, it is possible to more reliably adjust the viscosity of the composition for film formation to an optimal, to thereby more effectively suppress the involuntary thickness or property variation of every portions of the film to be formed, and to finally obtain a film having more superior strength.
Further, by subjecting to the composition for film formation the heat treatment prior to being applied onto the member for film formation (e.g., the semiconductor substrate), it is possible to appropriately form a film having a relatively thick thickness. Furthermore, by subjecting to the composition for film formation the heat treatment prior to being applied onto the member for film formation (e.g., the semiconductor substrate), it is possible to reduce heat quantity applied to the composition for film formation on the member, to thereby more reliably prevent the member from suffering damages due to the heat.
In the case where the composition for film formation is subjected to the heat treatment, as a condition for the heat treatment, it is preferred that a heat temperature is in the range of 120 to 190°C and a heat time is in the range of 3 to 11 hours, and more preferred that the heat temperature is in the range of 140 to 180°C and a heat time is in the range of 3 to 9 hours.
Further, the above mentioned heat treatment may be carried out by combining different conditions. For example, the composition for film formation may be subjected to a first heat treatment at a condition in which the heat temperature is in the range of 150 to 190°C and a heat time is in the range of 1 to 6 hours and a second heat treatment at a condition in which the heat temperature is in the range of 120 to 160°C and a heat time is in the range of 2 to 9 hours.

### <Insulating Film>

An insulating film of the present invention is formed using the composition for film formation described above.

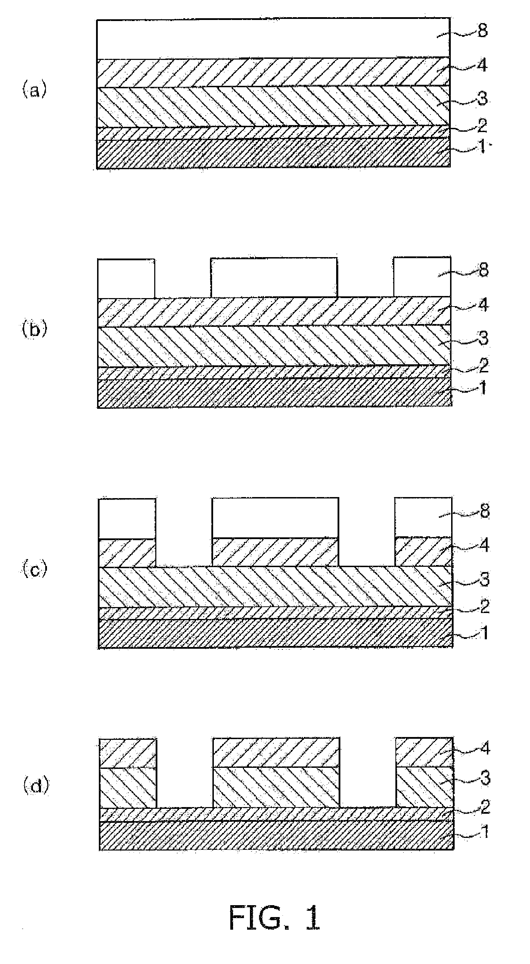

FIG. 1 is a longitudinal sectional view showing one example of a method for forming an interlayer insulating film patterned in a predetermined shape. In this regard, in the following description, the upper side in FIG. 1 will be referred to as "upper" and the lower side thereof will be referred to as "lower".

The insulating film of the present invention can be formed by, for example, applying the above mentioned composition for film formation onto a member such as a semiconductor substrate, and then subjecting the same to a treatment (baking treatment) such as heat or irradiation of an activation energy beam.

in the case where the polymerizable compound X includes the two polymerizable reactive groups B and/or the polymerizable reactive group B contains the two ethynyl groups, it is preferred that the composition for film formation includes the prepolymer obtained by partially polymerizing some of the polymerizable compounds X with each other when being applied onto the member. This makes it possible to more reliably adjust the viscosity of the composition for film formation to an optimal, to thereby more effectively suppress the involuntary thickness or property variation of every portions of the film to be formed, and to finally obtain a film having more superior strength. Further, this also makes it possible to form a film having a relatively thick thickness.

By performing the above mentioned baking treatment, the polymerizable compounds X and/or the prepolymers obtained by partially polymerizing some of the polymerizable compounds X with each other are polymerized with each other via the unreacted ethynyl groups thereof. As a result, it is possible to obtain a film (insulating film) formed from a polymer (cured product) having a three-dimensional crosslinking structure. The film (insulating film) formed from the polymer (cured product) having such a chemical structure becomes excellent in strength, heat resistance or the like.
Further, the film obtained in the above way has low permittivity. Furthermore, in the film obtained in the above way, the involuntary thickness or property variation of every portions thereof is suppressed. For these reasons, the above mentioned film can be suitably used as an insulating film for constituting a semiconductor device.

Examples of a method for applying the composition for film formation onto the member include a spin application method using a spinner, a spray application method using a spray coater, a dipping method, a printing method, a roll coating method and the like.

Prior to the baking treatment, for example, the composition for film formation applied on the member may be subjected to a treatment (desolvation treatment) for removing the solvent therefrom. Such a desolvation treatment can be performed by a heat treatment, a decompression treatment or the like.

The baking treatment is carried out preferably at a condition in which a baking temperature is in the range of 200 to 450°C and a baking time is in the range of 1 to 60 minutes, and more preferably at a condition in which a baking temperature is in the range of 250 to 400°C and a baking time is in the range of 5 to 30 minutes. Further, the baking step may be carried out by combining heat treatments of different conditions.

Further, in the case where such an insulating film is, for example, used as an interlayer insulating film for insulating wiring layers each formed on a semiconductor substrate, vias (conductor posts) electrically connecting the wiring layers, each of which the semiconductor substrate includes, are formed so as to pass through the interlayer insulating film in a thickness direction thereof. Therefore, the interlayer insulating film has need to be of a predetermined shape patterned so as to correspond to shapes of the vias (conductor posts).

Such an interlayer insulating film having the predetermined shape can be, for example, formed as follows.

First, prepared is a semiconductor substrate 1 on which a SiCN film 2 as a silicon-containing film has been formed. Thereafter, an interlayer insulating film 3, a hard mask layer 4 as a cap layer (cap film) and a photoresist layer (resist film) 8 are formed on the SiCN film 2 in this order (see FIG. 1(a)).

In this regard, it is to be noted that the interlayer insulating film 3 is formed using the composition for film formation by the above mentioned method.

Next, the photoresist layer 8 is exposed and developed using a photo mask, so as to be patterned into a shape having an opening portion corresponding to a portion at which the vias (conductor posts) are to be formed (see FIG. 1(b)).

Next, the hard mask layer 4 is etched through the photoresist layer 8 as a mask by a reactive ion etching method using a gas such as a fluorine-based gas (e.g., CF₄), which is generally used for patterning a hard mask material, as a treatment gas, to thereby be converted into a predetermined shape (see FIG. 1(C)).

Next, the interlayer insulating film 3 is etched through the photoresist layer 8 as a mask by a reactive ion etching method using a mixture gas of nitrogen gas and hydrogen gas, ammonia gas or the like, which is generally used for etching an organic film or the like, as a treatment gas, to thereby be converted into a predetermined shape (see FIG. 1(d)).

Although the interlayer insulating film 3 having the predetermined shape is obtained in this way, since the interlayer insulating film 3 is formed of the composition for film formation as described above, it is possible to more effectively suppress or prevent the interlayer insulating film 3 from having high permittivity, to thereby reliably maintain the properties thereof.

Specifically, in the case where a surface of the interlayer insulating film 3 is etched by the reactive ion etching method using the mixture gas of nitrogen gas and hydrogen gas or the ammonia gas, which is generally used for etching the organic film or the like, as the treatment gas, and a changing ratio of permittivities of the surface before and after being etched is down to preferably 10% or less (except for 0%), and more preferably 6.5% or less.

Further, since an etching rate of the insulating film is reduced during the etching step, it is possible to etch the surface of the insulating film relatively mildly. This makes it possible to prevent a modified layer (etching damage layer) from being formed inside the insulating film by the etching. From such a viewpoint, deterioration or alteration of the properties of this film can be effectively suppressed or prevented.

Specifically, in the case where the interlayer insulating film 3 is etched by a reactive ion etching method using a mixture gas of nitrogen gas and hydrogen gas (nitrogen gas flow rate: 7.5 sccm, hydrogen gas flow rate: 2.5 sccm) or ammonia gas (ammonia gas flow rate: 10.0 sccm) under the conditions in which frequency is 13.56 MHz, pressure is 12.5 Pa and power is 100 W, an etching rate thereof is preferably in the range of 10 to 90 Å/sec, and more preferably in the range of 10 to 50 Å/sec. This makes it possible to more effectively suppress or prevent the properties of the interlayer insulating film 3 from being deteriorated or altered.

Furthermore, it is preferred that the insulating film makes contact with a member formed of SiOC, SiCN or SiO (e.g., a semiconductor substrate, an intermediate film). In this case, it is possible to further improve an adhesive property or the like of the insulating film with respect to the member.

The permittivity of the insulating film of the present invention (that is, the permittivity of insulating film before being etched by the reactive ion etching method using the mixture gas of nitrogen gas and hydrogen gas or the ammonia gas) is preferably 2.32 or less, more preferably 2.30 or less, even more preferably in the range of 1.80 to 2.30, and much more preferably in the range of 1.80 to 2.25, as shown in concrete Examples described below. This makes it possible to achieve further speed up of a semiconductor device.
In this regard, it is to be noted that the permittivity of the insulating film can be measured using an automatic mercury probe CV measuring apparatus ("SSM495" produced by JAPAN SSM corporation) or the like.

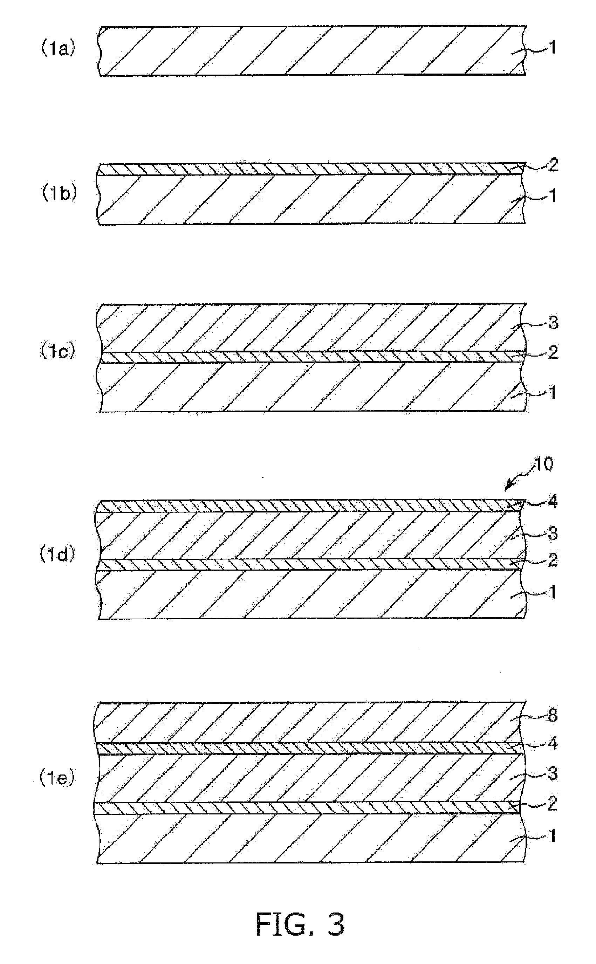

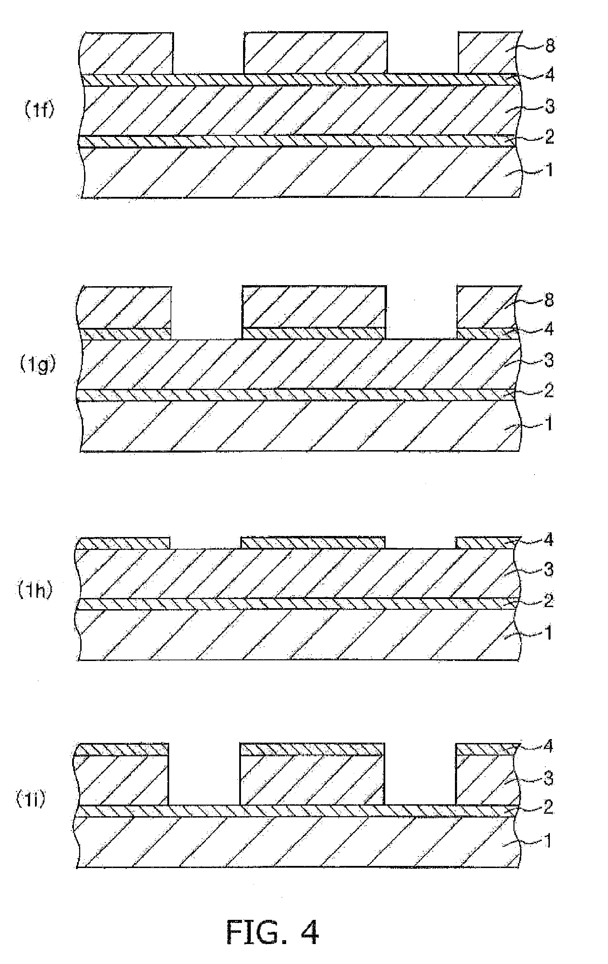

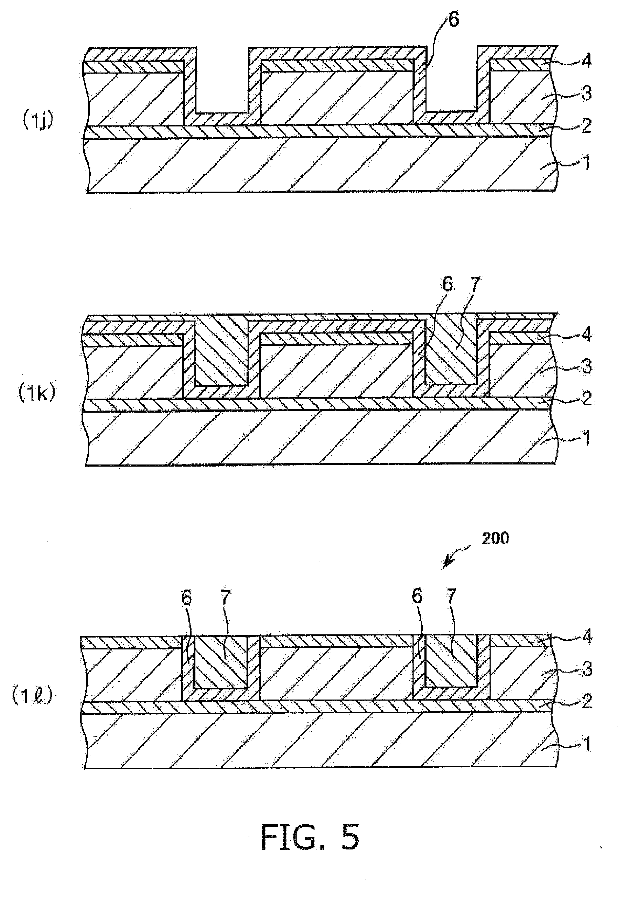

Further, in the present invention, in the case where an etching rate of the insulating film when being etched using a fluorine-based gas is defined as V₁ [nm/min] and an etching rate of a SiO film when being etched under the same conditions is defined as V₂ [nm/min], V₁ and V₂ satisfy preferably a relationship of V₁/V₂ ≤ 0.75, more preferably a relationship of V₁/V₂ ≤ 0.70, and even more preferably a relationship of V₁/V₂ ≤ 0.65.
This makes it possible to keep the permittivity of the insulating film sufficiently low, and to reliably prevent the insulating film from being etched when the cap layer is etched during manufacture of a semiconductor device as described below (see FIGs. 3 to 5) (that is, a first etching step). Therefore, it is possible to finally obtain a semiconductor device having high reliability in which occurrence of problems such as poor insulation is more reliably prevented.
Further, V₁ and V₂ satisfy preferably a relationship of 0.10 ≤ V₁/V₂, more preferably a relationship of 0.15 ≤ V₁/V₂, and even more preferably a relationship of 0.48 ≤ V₁/V₂, as shown in concrete Examples described below.

Furthermore, it is preferred that the insulating film of the present invention satisfies the following condition. Namely, adhesive strength between the insulating film of the present invention and a SiCN film, which is measured by a m-ELT method (Modified-Edge Lift off Test), is preferably in the range of 0.15 to 0.35 MPa·m^{(1/2)}, more preferably in the range of 0.20 to 0.35 MPa · m^{(1/2)}, and even more preferably in the range of 0.20 to 0.30 MPa·m^{(1/2)}. By manufacturing a semiconductor device using the insulating film, such a semiconductor device can have especially high reliability.

Hereinbelow, description will be made on a measuring method with regard to the m-ELT method.
First, a film, whose adhesive strength with respect to the insulating film is to be measured, (e.g., an inorganic film, an organic film, a metal film) is formed onto a silicon wafer by a vapor phase film formation method or the like. In this way, the wafer with film is prepared. In this embodiment, a SiCN film having a thickness of 50 nm is formed on the silicon wafer.
Next, the insulating film of the present invention is formed onto the SiCN film, to obtain a wafer with SiCN film/insulating film. Thereafter, an epoxy resin whose low temperature residual stress is known is applied onto the insulating film, and then treated in an oven heated at 170°C for 1 hour, to cure the epoxy resin. The same is cooled down to room temperature, and then cut into measurement samples each having about 0.5 inches square. This measurement sample is set to Laminar Series2 (produced by FSM corporation), heated up to 90°C, and then cooled down to -170°C at a speed of -3°C/min. At this time, an image thereof is shot at intervals of 1°C from 20°C. In a measurement sample in which delamination occurs, a peeling energy is calculated based on a temperature measured.
In the above example, by laminating the SiCN film, the insulating film and the epoxy resin in this order onto the silicon wafer, prepared is the measurement sample for the m-ELT method. In this case, adhesive strength between an upper portion of the SiCN film and a lower portion of the insulating film can be measured. In the case where the insulating film, the SiCN film and the epoxy resin are laminated in this order onto the silicon wafer instead of the above laminating order, adhesive strength between an upper portion of the insulating film and a lower portion of the SiCN film can be measured.
In the case where the measurement sample indicates a result satisfying a value of the adhesive strength defined in the present invention, it is possible to obtain effects described below. Therefore, the laminated structure of the measurement sample to be used for the m-ELT method is not limited to any type.
If the adhesive strength measured by the m-ELT method is the above lower limit value or more, in the laminated structure of the semiconductor device, adhesive strength between the insulating film and another film adjacent thereto, which is used as a barrier film or a cap film, such as a SiCN film, a SiC film, a SiO film, a SiN film or a SiOC film becomes sufficient. Therefore, hillock is hardly generated on a surface of a copper wiring due to thermal hysteresis thereof during a wiring step, to thereby finally obtain a semiconductor device having high reliability in which occurrence of problems such as poor insulation is reliably prevented.
On the other hand, if the adhesive strength measured by the m-ELT method is the above upper limit value or less, since an interface between the films having different thermal expansion coefficients is not affected to maintain appropriate adhesive strength thereof, the wiring step is reliably carried out. This makes it possible to further improve a yield ratio and reliability of the semiconductor device.

Further, the insulating film of the present invention is formed by applying the composition for film formation of the present invention onto a member such as a semiconductor substrate, and then subjecting the same to a treatment (baking treatment) such as heat or irradiation of an activation energy beam. A temperature of the baking treatment is preferably in the range of 300 to 370°C, and more preferably in the range of 330 to 350°C.
If the baking is carried out at 300°C or more, since tree-dimensional crosslinking reaction is sufficiently progressed by reliably reacting the remaining polymerizable groups with each other, the thus formed film can have sufficient heat resistance. On the other hand, if the baking is carried out at 370°C or less, since the heat treatment becomes appropriate, the hillock is hardly generated at a local portion of the surface of the copper wiring, to thereby further improve the reliably of the semiconductor device manufactured using the insulating film.

Although a thickness of the insulating film is not limited to a specific value, in the case where the insulating film is used as an interlayer insulating film for semiconductor, it is preferably in the range of 0.01 to 20 µm, more preferably in the range of 0.02 to 10 µm, and even more preferably in the range of 0.05 to 0.7 µm.

Further, in the case where the insulating film is used as a protective film for semiconductor, the thickness of the insulating film is preferably in the range of 0.01 to 70 µm, and more preferably in the range of 0.05 to 50 µm.

### <Semiconductor Device>

Next, a semiconductor device of the present invention will be described based on a preferred embodiment.

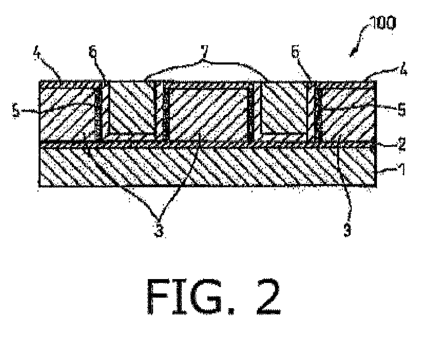

FIG. 2 is a longitudinal sectional view schematically showing one example of the semiconductor device of the present invention.
As shown in FIG. 2, a semiconductor device 100 includes a semiconductor substrate 1 on which an element is formed, a SiCN film 2 provided at an upper side (upper side of FIG. 2) of the semiconductor substrate 1, an interlayer insulating film 3 provided on the SiCN film 2 and a copper wiring layer (wiring layer) 7 surrounded by a barrier metal layer 6. The semiconductor device 100 of this embodiment includes the interlayer insulating film 3 as the insulating film of the present invention.

The interlayer insulating film 3 has a concave portion corresponding to a wiring pattern to be formed, and the copper wiring layer 7 is provided inside the concave portion.

Further, a modified treatment layer 5 is provided between the interlayer insulating film 3 and the copper wiring layer 7.
Furthermore, a hard mask layer 4 is formed at an upper side of the interlayer insulating film 3 (that is, on a surface of the interlayer insulating film 3 opposite to the SiCN film 2).

For example, the semiconductor device 100 can be manufactured as follows.
First, a groove for wiring is formed so as to pass through an insulating film constituted from the interlayer insulating film 3 and the hard mask layer 4 at a predetermined portion thereof by the method described in the insulating film, to thereby bring the insulating film into a desired shape.

Next, the modified treatment layer 5 is formed by subjecting an inner surface of the groove for wiring using to a plasma treatment or the like, and then the barrier metal layer 6 is formed using Ta, Ti, TaN, TiN, WN or the like by a method such as a PVD method or a CVD method.

Thereafter, the copper wiring layer 7 which becomes a wiring portion is formed by an electrolytic plating method or the like, and then a portion of the copper wiring layer and barrier metal layer other than the wiring portion is polished and removed by a CMP method, to thereby flatten it. In this way, the semiconductor device 100 can be manufactured.

In this regard, although the interlayer insulating film 3 can be formed by the above method described in the insulating film of the present invention, it also may be formed by preparing, in advance, a dry film of a resin film, and then laminating the dry film onto the SiCN film 2 of the semiconductor substrate 1.
More specifically, the interlayer insulating film 3 may be formed by preparing, in advance, a dry film obtained by forming a resin film onto a member using the composition for film formation and then drying it, removing this dry film form the member, laminating it onto the SiCN film 2 of the semiconductor substrate 1, and then heating it and/or irradiating it with a radioactive ray.

Since the above mentioned semiconductor device of the present invention includes the above interlayer insulating film (that is, the insulating film of the present invention), it has high dimensional accuracy and a sufficient insulating property, to thereby exhibit excellent connection reliability.

Further, the above mentioned interlayer insulating film (that is, the insulating film of the present invention) has a superior adhesive property with respect to the wiring layer. This makes it possible to further improve the connection reliability of the semiconductor device.

Furthermore, the above mentioned interlayer insulating film (that is, the insulating film of the present invention) has a high elastic modulus. This makes it possible to appropriately fit it into the step of forming the wiring layer of the semiconductor device (that is, the baking step).

Moreover, in the above mentioned interlayer insulating film (that is, the insulating film of the present invention), the occurrence of the etching damage is suppressed or prevented during the wiring formation. This makes it possible to suppress or prevent the properties of the insulating film from being changed during the semiconductor device manufacture.

In addition, the above mentioned interlayer insulating film (that is, the insulating film of the present invention) has a superior dielectric property. This makes it possible to reduce loss of signal of the semiconductor device.

In addition, the above mentioned interlayer insulating film (that is, the insulating film of the present invention) has the superior dielectric property. This makes it possible to decrease wiring delay.

### <Method for Manufacturing Semiconductor Device, Laminated Body, Semiconductor Device>

Next, another preferred embodiment of the present invention will be described. Hereinbelow, the other embodiment will be described with emphasis placed on points differing from the above mentioned embodiment. No description will be made on the same points.
FIGs. 3 to 5 are longitudinal sectional views each showing a preferred embodiment of the method for manufacturing a semiconductor device. In this regard, in the following description, the upper side in each of FIGs. 3 to 5 will be referred to as "upper" and the lower side thereof will be referred to as "lower".

As shown in FIGs. 3 to 5, a manufacturing method of this embodiment includes: a semiconductor substrate preparation step (la) of preparing a semiconductor substrate 1 on which an element is formed; a silicon-containing film formation step (lb) of forming a silicon-containing film 2 onto a surface of the semiconductor substrate 1; an insulating film formation step (1c) of forming an interlayer insulating film 3 as the insulating film of the present invention onto a surface of the silicon-containing film 2; a cap layer formation step (1d) of forming a cap layer 4 onto a surface of the interlayer insulating film 3 to obtain a laminated body 10 including a laminated structure of the interlayer insulating film 3 and the cap layer 4; a resist film formation step (1e) of forming a resist film 8 onto a surface of the cap layer 4; a resist film patterning step (1f) of forming an opening portion (groove portion) into the resist film 8 so as to correspond to a portion, at which vias (conductor posts) or a groove for wiring are to be formed, by subjecting the resist film 8 to an expose and development treatment using a photo mask; a first etching step (1g) of etching the cap layer 4 using the resist film 8 as a mask; a resist film removal step (1h) of optionally removing the resist film 8; a second etching step (li) of forming the opening portion (groove portion) into the interlayer insulating film 3 by etching it using the cap layer 4 as a mask; a barrier metal layer formation step (1j) of forming a barrier metal layer 6 for preventing components of a wiring layer 7 described below from being diffused at a side of a surface of the laminated body 10 at which the interlayer insulating film 3 is positioned; a wiring layer formation step (1k) of forming the wiring layer 7 inside the groove portion of the interlayer insulating film 3 covered by the barrier metal layer 6; and a polish step (11) of polishing a portion constituted from a wiring material outside the groove portion and a portion constituted from a constituent material of the barrier metal layer 6 outside the groove portion to remove them.

The silicon-containing film formation step can be appropriately carried out by a vapor phase film formation method.
The insulating film formation step can be appropriately carried out by applying the composition for film formation onto the surface of the silicon-containing film 2 by the above mentioned method. In this regard, it is to be noted that the interlayer insulating film 3 also can be formed by separately preparing, in advance, a resin film (insulating film) as a dry film, and then laminating the resin film onto the silicon-containing film 2. More specifically, the interlayer insulating film 3 may be formed by preparing, in advance, a dry film obtained by forming a resin film (insulating film) onto a member using the composition for film formation and then drying it, removing this dry film form the member, laminating it onto the silicon-containing film 2, and then heating it and/or irradiating it with a radioactive ray.
In this regard, the silicon-containing film 2 is formed using a known material for a barrier film or an etching stopper film to person skilled in the art, but may be appropriately formed using SiCN or SiC.

The cap layer formation step also can be appropriately carried out by a vapor phase film formation method. The cap layer 4 is generally formed of SiO, but may be formed of SiN, SiC, SiCN, SiOC or the like.

The resist film formation step can be carried out using, for example, various kinds of application methods, but can be appropriately carried out by a spin application method using a spinner, a spray application method using a spray coater, a dipping method, a printing method, a roll coating method and the like.

The first etching step is carried out by an etching method (reactive ion etching method) using a fluorine-based gas such as CF₄ as a treatment gas. In the case where the interlayer insulating film 3 satisfies the condition of etching rate ratio as described above, it is possible to reliably prevent a part of the interlayer insulating film 3 from being removed by an involuntary etching such as side etching together with the cap layer 4. As a result, it is possible to finally obtain a semiconductor device having high reliability, in which occurrence of problems such as poor insulation is prevented.
As described above, it is preferred that in the present invention, the etching rate V₁ of the insulating film when being etched using the fluorine-based gas and the etching rate V₂ of the SiO film when being etched under the same conditions satisfy a predetermined relationship. In the case where such a relationship is satisfied, the above mentioned excellent effects are exhibited in the cap layer 4 formed of not only SiO but also SiN, SiC, SiCN, SiOC or the like.
This is because of the following reason. Namely, when the film formed of SiN, SiC, SiCN, SiOC or the like is etched using the fluorine-based gas, it exhibits the same behavior as the film formed of SiO. Therefore, in the case where the etching rate of the insulating film and the etching rate of the SiO film are vastly different from each other, even if the cap layer 4 is formed of SiCN, SiOC or the like, it reliably prevents the interlayer insulating film 3 from being etched during the first etching step.

The second etching step can be carried out by an etching method (reactive ion etching method) using a mixture gas of nitrogen gas and hydrogen gas, ammonia gas or the like as a treatment gas.

In this regard, it is to be noted that the resist film removal step accordingly may be carried out by ashing the resist film, before the second etching step, after the second etching step or the like.

The barrier metal layer formation step can be carried out by a method such as a PVD method or a CVD method. Examples of a constituent material of the barrier metal layer 6 include Ta, Ti, TaN, TiN, WN and the like.

It is preferred that the wiring layer formation step is carried out by combining a vapor phase film formation method such as a PVD method and a wet plating method such as an electrolytic plating method. This makes it possible to further improve efficiency of forming the wiring layer 7 while sufficiently imparting an excellent adhesive property of the wiring layer 7 with respect to the barrier metal layer 6. Although a constituent material of the wiring layer 7 is not limited to a specific kind, copper (Cu) is appropriately used.
The polish step can be appropriately carried out by a CMP method (chemical mechanical polishing method).

Through the above steps, it is possible to obtain a semiconductor device 200.
The above mentioned semiconductor device of the present invention includes the above mentioned interlayer insulating film (that is, the insulating film of the present invention). Therefore, problems such as poor insulation hardly occur in the semiconductor device, thus it can have high reliability.

Further, in the case where the insulating film constituting the semiconductor device satisfies a predetermined condition with regard to the adhesive strength measured by the m-ETL method, the insulating film has sufficient adhesive strength with respect to another film adjacent thereto such as a SiCN film, a SiC film, a SiO film, a SiN film, a SiOC film or the like in the laminated body of the semiconductor device. Therefore, hillock is hardly generated on a surface of the copper wiring due to heat history applied during the wiring formation step, to thereby finally obtain a semiconductor device having high reliability, in which occurrence of problems such as poor insulation is reliably prevented.
In this regard, in the case where the adhesive strength between the insulating film and the SiCN film measured by the m-ELT method satisfies the predetermined condition, even if the barrier film or the cap layer is formed of SiO, SiN, SiC, SiCN, SiOC or the like other than SiCN, the above mentioned excellent effects are exhibited.

While the descriptions are made on the present invention based on the preferred embodiments, the present invention is not limited thereto.

For example, in the above representative description, the interlayer insulating film 3 is formed on the SiCN film (silicon-containing film) 2 as the insulating film of the present invention. However, the position of forming the interlayer insulating film 3 is not limited thereto.

Further, in the representative description on the above embodiment, the insulating film of the present invention is used as the interlayer insulating film 3. However, the insulating film may be used as a film other than the interlayer insulating film.

### Examples

Hereinbelow, the present invention will be described in detail based on Examples and Comparative Examples, but is not limited thereto.

### <Example Group A>

### [A1] Synthesis of Polymerizable Compound

### (Synthesis Example A1)

First, 1,3-dimethyl adamantane was prepared, 700 mL of carbon tetrachloride and 35 g (0.22 mol) of bromine were put into a 2000 mL four neck flask provided with a thermometer, a stirrer and a reflux tube, and then 32.9 g (0.2 mol) of the prepared 1,3-dimethyl adamantane was added thereto little by little while stirring them. In this regard, while adding it, an inside temperature was kept at 20 to 30°C.

After the addition was finished, and then the temperature increase was stopped, they were reacted with each other for another hour.
Thereafter, about 2000 mL of cold water was poured into the flask to produce a crude product, and then the crude product was filtrated and collected, washed with deionized water, and then dried.

Further, the crude product was recrystallized using heat ethanol to obtain a recrystallized product. The obtained recrystallized product was dried under reduced pressure to thereby obtain 37.4 g of a product. Absorption derived from a bromo group was observed within 690 to 515 cm⁻¹ by IR analysis and a molecular weight thereof was 322 by mass analysis. This result showed that the product was 3,5-dimethyl-1,7-dibromo adamantane.

Next, 33.2 g (103.2 mmol) of the above obtained 3,5-dimethyl-1,7-dibromo adamantane and 1,217g (5,161.6 mmol) of 1,3-dibromo benzene were stirred in the flask, and then 24.8 g (93.0 mmol) of aluminium bromide(III) was added thereto at 25°C under dry nitrogen little by little. The same was heated up to 60°C and stirred for 8 hours, and then returned to room temperature, to thereby obtain a reaction liquid.
The reaction liquid was added to 700 mL of a 5% hydrochloric acid solution and stirred. A water phase was removed and an organic phase was added to 2,000 mL of acetone to obtain a precipitate. The precipitate was filtrated and washed three times with 1,000 mL of acetone, to thereby obtain 57 g of 3,5-dimethyl-1,7-bis(3,5-dibromo phenyl) adamantane. A molecular weight thereof was 632 by mass analysis. This result showed that the product was 3,5-dimethyl-1,7-bis(3,5-dibromo phenyl) adamantane.

39.8 g (62.9 mmol) of 3,5-dimethyl-1,7-bis(3,5-dibromo phenyl) adamantane obtained above, 3.53 g (5.0 mmol) of dichloro bistriphenyl phosphine palladium, 6.60 g (25.2 mmol) of triphenyl phosphine, 4.79 g (25.2 mmol) of copper iodide(II) and 750 mL of triethyl amine were put into the flask and stirred. The same was heated up to 75°C, and then 37.1 g (377.7 mmol) of trimethyl silyl acetylene was slowly added thereto. This was stirred at 75°C for 7 hours, and then heated up to 120°C to remove the triethyl amine therefrom.
Thereafter, this was returned to room temperature, 1,000 mL of dichloro methane was added to the reaction liquid and stirred for 20 minutes to obtain a precipitate. The precipitate was removed by filtration to obtain a filtrate, and then 1,000 mL of a 5% hydrochloric acid solution was added to the filtrate so that it was separated. An organic phase was washed three times with 1,000 mL of water, and then a solvent was removed from the organic phase under reduced pressure, to thereby obtain a compound.
The obtained compound was dissolved into 1,500 mL of hexane to produce an insoluble product. The insoluble product was removed by filtration to obtain a filtrate, and then the hexane was removed from the filtrate. 1,000 mL of acetone was added thereto to produce a precipitate, and then the precipitate was washed three times with acetone, to thereby obtain 36.1 g of 3,5-dimethyl-1,7-bis(3,5-ditrimethyl silyl ethynyl phenyl) adamantane. A molecular weight thereof was 701 by mass analysis. This result showed that the product was 3,5-dimethyl-1,7-bis(3,5-ditrimethyl silyl ethynyl phenyl) adamantane.

Further, 32.3 g (46.1 mmol) of the 3,5-dimethyl-1,7-bis(3,5-ditrimethyl silyl ethynyl phenyl) adamantane obtained above and 1.46 g (10.6 mmol) of potassium carbonate were reacted with each other in a mixture solvent containing 600 mL of tetrahydrofuran and 300 mL of methanol under nitrogen atmosphere at room temperature for 4 hours. The same was added to 1,000 mL of a 10% hydrochloric acid solution to obtain a precipitate, and then the precipitate was filtrated. Thereafter, the obtained precipitate was washed with 1,000 mL of water, washed with 1,000 mL of acetone, and then dried, to thereby obtain 15.0 g of 3,5-dimethyl-1,7-bis(3,5-diethynyl phenyl) adamantane as a polymerizable compound X.

Hereinbelow, the appearance of the product and the results of the mass analysis and an elemental analysis are shown. These data indicates that the above obtained product is 3,5-dimethyl-1,7-bis(3,5-diethynyl phenyl) adamantane.

Appearance: White Solid
MS (FD) (m/z) : 413 (M+)
Elemental Analysis: Theoretical Value (/o) C; 93.16, H; 6.84, Actual Measured Value (/%) C; 93.11, H; 6.82

### (Synthesis Examples A2 to A6)

A polymerizable compound X was obtained in the same manner as Synthesis Example A1 except that tetramethyl biadamantane, hexamethyl triadamantane, octamethyl tetraadamantane, decamethyl pentaadamantane or dodecamethyl hexaadamantane was prepared instead of the dimethyl adamantane.

In this regard, it is to be noted that a structural formula of the polymerizable compound X obtained in each of Synthesis Examples A1 to A6 is shown in the following formula (1). In the following formula (1), n is an integral number of 1 to 6 and the number of n corresponds to the number (figure) of each Synthesis Example.

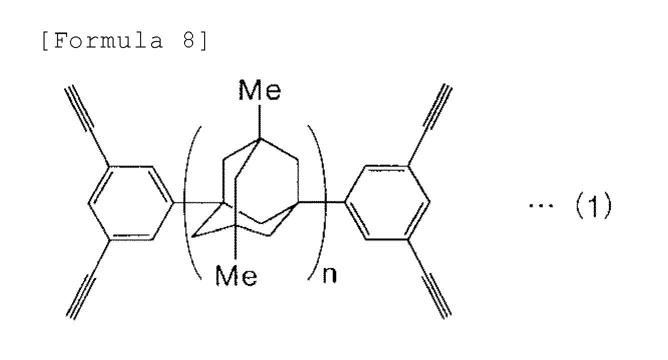

Here, the appearance of the polymerizable compound X in which n is 2 in the above formula (1) (Synthesis Example A2) and the results of the mass analysis and the elemental analysis are shown.

Appearance: White Solid
MS (FD) (m/z) : 574 (M+)
Elemental Analysis: Theoretical Value (/%) C; 91.93, H; 8.07, Actual Measured Value (/%) C; 91.87, H; 8.00

Further, the appearance of the polymerizable compound X in which n is 3 in the above formula (1) (Synthesis Example A3) and the results of the mass analysis and the elemental analysis are shown.

Appearance: White Solid
MS(FD)(m/z): 737 (M+)
Elemental Analysis: Theoretical Value (/%) C; 91.25, H; 8.75, Actual Measured Value (/%) C; 91.21, H; 8.77

Further, the appearance of the polymerizable compound X in which n is 4 in the above formula (1) (Synthesis Example A4) and the results of the mass analysis and the elemental analysis are shown.

Appearance: White Solid
MS(FD)(m/z): 899(M+)
Elemental Analysis: Theoretical Value (/%) C; 90.81, H; 9.19, Actual Measured Value (/%) C; 90.75, H; 9.16

Further, the appearance of the polymerizable compound X in which n is 5 in the above formula (1) (Synthesis Example A5) and the results of the mass analysis and the elemental analysis are shown.

Appearance: White Solid
MS(FD)(m/z): 1,062(M+)
Elemental Analysis: Theoretical Value (/%) C; 90.51, H; 9.49, Actual Measured Value (/%) C; 90.49, H; 9.47

Further, the appearance of the polymerizable compound X in which n is 6 in the above formula (1) (Synthesis Example A6) and the results of the mass analysis and the elemental analysis are shown.

Appearance: White Solid
MS(FD)(m/z): 1,223(M+)
Elemental Analysis: Theoretical Value (/%) C; 90.28, H; 9.72, Actual Measured Value (/%) C; 90.26, H; 9.70

### (Synthesis Example A7)

First, according to a synthesis method described in Journal of Organic Chemistry., 39, 2987-3003 (1974), 4,9-dibromo diamantane was synthesized. Absorption derived from a bromo group was observed within 690 to 515 cm⁻¹ by IR analysis and a molecular weight thereof was 346 by mass analysis. This result showed that the product was 4,9-dibromo diamantane.

Next, in the synthesis of the 3,5-dimethyl-1,7-bis(3,5-dibromo phenyl) adamantane as the synthetic intermediate of Synthesis Example Al, the reaction was carried out in the same manner as Synthesis Example A1 except that 35.7 g (103.1 mmol) of the above obtained 4,9-dibromo diamantane was used instead of the 3,5-dimethyl-1,7-dibromo adamantane. In this way, 56 g of 4,9-bis(3,5-dibromo phenyl) diamantane was obtained. A molecular weight thereof was 656 by mass analysis. This result showed that the product was 4,9-bis(3,5-dibromo phenyl) diamantane.

Next, in the synthesis of the 3,5-dimethyl-1,7-bis(3,5-ditrimethyl silyl ethynyl phenyl) adamantane as the synthetic intermediate of Synthesis Example A1, the reaction was carried out in the same manner as Synthesis Example A1 except that 41.2 g (62.8 mmol) of the above obtained 4,9-bis(3,5-dibromo phenyl) diamantane was used instead of the 3,5-dimethyl-1,7-bis(3,5-dibromo phenyl) adamantane. In this way, 35.5 g of 4,9-bis(3,5-ditrimethyl silyl ethynyl phenyl) diamantane was obtained. A molecular weight thereof was 725 by mass analysis. This result showed that the product was 4,9-bis(3,5-ditrimethyl silyl ethynyl phenyl) diamantane.

Further, in the synthesis of the 3,5-dimethyl-1,7-bis(3,5-diethynyl phenyl) adamantane as the final product of Synthesis Example Al, the reaction was carried out in the same manner as Synthesis Example A1 except that 38.8 g (53.5 mmol) of the above obtained 4,9-bis(3,5-ditrimethyl silyl ethynyl phenyl) diamantane was used instead of the 3,5-dimethyl-1,7-bis(3,5-ditrimethyl silyl ethynyl phenyl) adamantane. In this way, 14.3 g of 4,9-bis(3,5-diethynyl phenyl) diamantane was obtained as a polymerizable compound X.

Hereinbelow, the appearance of the product and the results of the mass analysis and an elemental analysis are shown. These data indicates that the above obtained product is 4,9-bis(3,5-diethynyl phenyl) diamantane.

Appearance: White Solid
MS(FD)(m/z): 436(M+)
Elemental Analysis: Theoretical Value (/%) C; 93.54, H; 6.46, Actual Measured Value (/%) C; 93.46, H; 6.38

### (Synthesis Examples A8 to A11)

A polymerizable compound X was obtained in the same manner as Synthesis Example A1 except that dibromo di(diamantane), dibromo tri(diamantane), dibromo tetra(diamantane) or dibromo penta(diamantane) was prepared instead of the dibromo diamantane.

In this regard, it is to be noted that a structural formula of the polymerizable compound X obtained in each of Synthesis Examples A7 to A11 is shown in the following formula (4). In the following formula (4), n is an integral number of 1 to 5 and the number of n corresponds to (the figure of each Synthesis Example - 6).

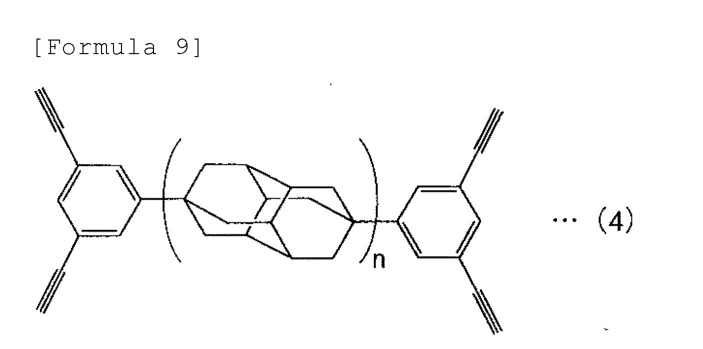

Here, the appearance of the polymerizable compound X in which n is 2 in the above formula (4) (Synthesis Example A8) and the results of the mass analysis and the elemental analysis are shown.

Appearance: White Solid
MS (FD) (m/z) : 622 (M+)
Elemental Analysis: Theoretical Value (/%) C; 92.56, H; 7.44, Actual Measured Value (/%) C; 92.53, H; 7.41

Further, the appearance of the polymerizable compound X in which n is 3 in the above formula (4) (Synthesis Example A9) and the results of the mass analysis and the elemental analysis are shown.

Appearance: White Solid
MS(FD)(m/z): 809 (M+)
Elemental Analysis: Theoretical Value (/%) C; 92.03, H; 7.97, Actual Measured Value (/%) C; 92.01, H; 7.94

The appearance of the polymerizable compound X in which n is 4 in the above formula (4) (Synthesis Example A10) and the results of the mass analysis and the elemental analysis are shown.

Appearance: White Solid
MS(FD)(m/z): 995(M+)
Elemental Analysis: Theoretical Value (/%) C; 91.70, H; 8.30, Actual Measured Value (/%) C; 91.67, H; 8.28

Furthermore, the appearance of the polymerizable compound X in which n is 5 in the above formula (4) (Synthesis Example A11) and the results of the mass analysis and the elemental analysis are shown.

Appearance: White Solid
MS(FD)(m/z): 1,181(M+)
Elemental Analysis: Theoretical Value (/%) C; 91.47, H; 8.53, Actual Measured Value (/%) C; 91.42, H; 8.50

### (Synthesis Example A12)

First, 45.5 g (187.1 mmol) of 3,5-dimethyl-1-bromo adamantane and 1,217 g (5161.6 mmol) of 1,3-dibromo benzene were put into a 2000 mL four neck flask provided with a thermometer, a stirrer and a reflux tube and stirred, and then 24.8 g (93.0 mmol) of aluminium bromide(III) was added thereto at 25°C under dry nitrogen little by little. The same was heated up to 60°C and stirred for 8 hours, and then returned to room temperature, to thereby obtain a reaction liquid.

Next, the reaction liquid was added to 700 mL of a 5% hydrochloric acid solution and stirred. A water phase was removed and an organic phase was added to 2,000 mL of acetone to obtain a precipitate. The precipitate was filtrated and washed three times with 1,000 mL of acetone, to thereby obtain 51.4 g of 3,5-dimethyl-1-(3,5-dibromo phenyl) adamantane. A molecular weight thereof was 398 by mass analysis. This result showed that the product was 3,5-dimethyl-1-(3,5-dibromo phenyl) adamantane.

Next, 47.1 g (118.4 mmol) of 3,5-dimethyl-1-(3,5-dibromo phenyl) adamantane obtained above, 6.66 g (9.5 mmol) of dichloro bistriphenyl phosphine palladium, 179.5 g (47.3 mmol) of triphenyl phosphine, 248.7 g (47.3 mmol) of copper iodide(II) and 750 mL of triethyl amine were put into the flask and stirred. The same was heated up to 75°C, and then 34.9 g (355.2 mmol) of trimethyl silyl acetylene was slowly added thereto. This was stirred at 75°C for 7 hours, and then heated up to 120°C to remove the triethyl amine therefrom.
Thereafter, this was returned to room temperature, 1,000 mL of dichloro methane was added to the reaction liquid and stirred for 20 minutes to obtain a precipitate. The precipitate was removed by filtration to obtain a filtrate, and then 1,000 mL of a 5% hydrochloric acid solution was added to the filtrate so that it was separated. An organic phase was washed three times with 1,000 mL of water, and then a solvent was removed from the organic phase under reduced pressure, to thereby obtain a compound.
The obtained compound was dissolved into 1,500 mL of hexane to produce an insoluble product. The insoluble product was removed by filtration to obtain a filtrate, and then the hexane was removed from the filtrate. 1,000 mL of acetone was added thereto to produce a precipitate, and then the precipitate was washed three times with acetone, to thereby obtain 37 g of 3,5-dimethyl-1-(3,5-ditrimethyl silyl ethynyl phenyl) adamantane. A molecular weight thereof was 432 by mass analysis. This result showed that the product was 3,5-dimethyl-1-(3,5-ditrimethyl silyl ethynyl phenyl) adamantane.

Further, 36 g (83.1 mmol) of the 3,5-dimethyl-1-(3,5-ditrimethyl silyl ethynyl phenyl) adamantane obtained above and 2.7 g (19.3 mmol) of potassium carbonate were reacted with each other in a mixture solvent containing 600 mL of tetrahydrofuran and 300 mL of methanol under nitrogen atmosphere at room temperature for 4 hours. The same was added to 1,000 mL of a 10% hydrochloric acid solution to obtain a precipitate, and then the precipitate was filtrated. Thereafter, the obtained precipitate was washed with 1,000 mL of water, washed with 1,000 mL of acetone, and then dried, to thereby obtain 19 g of 3,5-dimethyl-1-(3,5-diethynyl phenyl) adamantane as a polymerizable compound X.

Hereinbelow, the appearance of the product and the results of the mass analysis and an elemental analysis are shown. These data indicates that the above obtained product is 3,5-dimethyl-1-(3,5-diethynyl phenyl) adamantane.

Appearance: White Solid
MS(FD)(m/z): 288 (M+)
Elemental Analysis: Theoretical Value (/%) C; 91.61, H; 8.39, Actual Measured Value (/%) C; 91.59, H; 8.37

### (Synthesis Examples A13 and A14)

A polymerizable compound X was obtained in the same manner as Synthesis Example A12 except that tetramethyl bromo biadamantane or hexamethyl bromo triadamantane was prepared instead of the dimethyl bromo adamantane.

In this regard, it is to be noted that a structural formula of the polymerizable compound X obtained in each of Synthesis Examples A13 and A14 is shown in the following formula (1'). In the following formula (1'), n is an integral number of 1 to 3 and the number of n corresponds to (the figure of each Synthesis Example - 11).

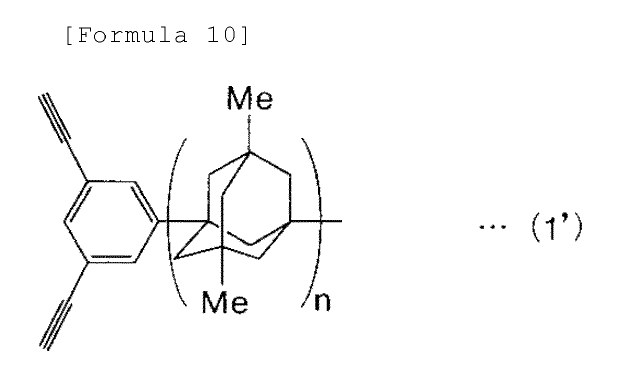

Here, the appearance of the polymerizable compound X in which n is 2 in the above formula (1') (Synthesis Example A13) and the results of the mass analysis and the elemental analysis are shown.

Appearance: White Solid
MS(FD)(m/z): 450 (M+)
Elemental Analysis: Theoretical Value (/%) C; 90.61, H; 9.39, Actual Measured Value (/%) C; 90.59, H; 9.36

Further, the appearance of the polymerizable compound X in which n is 3 in the above formula (1') (Synthesis Example A14) and the results of the mass analysis and the elemental analysis are shown.

Appearance: White Solid
MS(FD)(m/z): 612 (M+)
Elemental Analysis: Theoretical Value (/%) C; 90.13, H; 9.87, Actual Measured Value (/%) C; 90.10, H; 9.86

### (Synthesis Example A15)

First, 50 g (187.1 mmol) of 4-bromo diamantane and 1,217 g (5161.6 mmol) of 1,3-dibromo benzene were put into a 2000 mL four neck flask provided with a thermometer, a stirrer and a reflux tube and stirred, and then 24.8 g (93.0 mmol) of aluminium bromide(III) was added thereto at 25°C under dry nitrogen little by little. The same was heated up to 60°C and stirred for 8 hours, and then returned to room temperature, to thereby obtain a reaction liquid.

Next, the reaction liquid was added to 700 mL of a 5% hydrochloric acid solution and stirred. A water phase was removed and an organic phase was added to 2,000 mL of acetone to obtain a precipitate. The precipitate was filtrated and washed three times with 1,000 mL of acetone, to thereby obtain 56 g of 4-(3,5-dibromo phenyl) diamantane. A molecular weight thereof was 422 by mass analysis. This result showed that the product was 4-(3,5-dibromo phenyl) diamantane.

Next, 50 g (118.4 mmol) of 4-(3,5-dibromo phenyl) diamantane obtained above, 6.66 g (9.5 mmol) of dichloro bistriphenyl phosphine palladium, 179.5 g (47.3 mmol) of triphenyl phosphine, 248.7 g (47.3 mmol) of copper iodide(II) and 750 mL of triethyl amine were put into the flask and stirred. The same was heated up to 75°C, and then 34.9 g (355.2 mmol) of trimethyl silyl acetylene was slowly added thereto. This was stirred at 75°C for 7 hours, and then heated up to 120°C to remove the triethyl amine therefrom.
Thereafter, this was returned to room temperature, 1,000 mL of dichloro methane was added to the reaction liquid and stirred for 20 minutes to obtain a precipitate. The precipitate was removed by filtration to obtain a filtrate, and then 1,000 mL of a 5% hydrochloric acid solution was added to the filtrate so that it was separated. An organic phase was washed three times with 1,000 mL of water, and then a solvent was removed from the organic phase under reduced pressure, to thereby obtain a compound.
The obtained compound was dissolved into 1,500 mL of hexane to produce an insoluble product. The insoluble product was removed by filtration to obtain a filtrate, and then the hexane was removed from the filtrate. 1,000 mL of acetone was added thereto to produce a precipitate, and then the precipitate was washed three times with acetone, to thereby obtain 41 g of 4-(3,5-ditrimethyl silyl ethynyl phenyl) diamantane. A molecular weight thereof was 456 by mass analysis. This result showed that the product was 4-(3,5-ditrimethyl silyl ethynyl phenyl) diamantane.

Further, 40 g (87.6 mmol) of the 4-(3,5-ditrimethyl silyl ethynyl phenyl) diamantane obtained above and 2.7 g (19.3 mmol) of potassium carbonate were reacted with each other in a mixture solvent containing 600 mL of tetrahydrofuran and 300 mL of methanol under nitrogen atmosphere at room temperature for 4 hours. The same was added to 1,000 mL of a 10% hydrochloric acid solution to obtain a precipitate, and then the precipitate was filtrated. Thereafter, the obtained precipitate was washed with 1,000 mL of water, washed with 1,000 mL of acetone, and then dried, to thereby obtain 23 g of 4-(3,5-diethynyl phenyl) diamantane as a polymerizable compound X.

Hereinbelow, the appearance of the product and the results of the mass analysis and an elemental analysis are shown. These data indicates that the above obtained product is 4-(3,5-diethynyl phenyl) diamantane.

Appearance: White Solid
MS(FD)(m/z): 312 (M+)
Elemental Analysis: Theoretical Value (/%) C; 92.26, H; 7.74, Actual Measured Value (/%) C; 92.12, H; 7.70

### (Synthesis Examples A16 and A17)

A polymerizable compound X was obtained in the same manner as Synthesis Example A15 except that bromo bi(diamantane) or bromo tri(diamantane) was prepared instead of the bromo diamantane.

In this regard, it is to be noted that a structural formula of the polymerizable compound X obtained in each of Synthesis Examples A15 to A17 is shown in the following formula (4'). In the following formula (4'), n is an integral number of 1 to 3 and the number of n corresponds to (the figure of each Synthesis Example - 14).

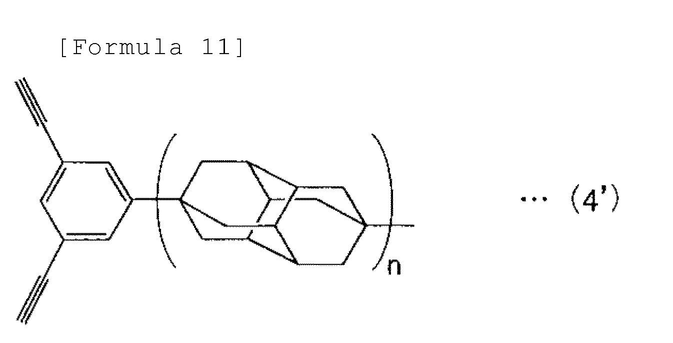

Here, the appearance of the polymerizable compound X in which n is 2 in the above formula (4') (Synthesis Example A16) and the results of the mass analysis and the elemental analysis are shown.

Appearance: White Solid
MS(FD)(m/z): 498 (M+)
Elemental Analysis: Theoretical Value (/%) C; 91.51, H; 8.94, Actual Measured Value (/%) C; 91.49, H; 8.46

Further, the appearance of the polymerizable compound X in which n is 3 in the above formula (4') (Synthesis Example A17) and the results of the mass analysis and the elemental analysis are shown.

Appearance: White Solid
MS(FD)(m/z): 685(M+)
Elemental Analysis: Theoretical Value (/%) C; 91.17, H; 8.83, Actual Measured Value (/%) C; 91.15, H; 8.80

### (Synthesis Example A18)

14.4 g (34.9 mmol) of the 3,5-dimethyl-1,7-bis(3,5-diethynyl phenyl) adamantane obtained in Synthesis Example Al, 67.4 g (522 mmol) of quinoline, 0.37 g (0.174 mmol) of 5% palladium-calcium carbonate and 1,000 mL of tetrahydrofuran were put into a 5 L eggplant flask together with a stirring bar, and then stirring was started at room temperature while flowing hydrogen gas. When 3.35 L (139 mmol) of the hydrogen gas was consumed, the reaction was stopped by introducing nitrogen gas into the flask, to thereby obtain a reaction liquid.
Thereafter, the reaction liquid was filtrated to obtain a filtration, and then the solvent was removed from the filtration to obtain a solid. The obtained solid was purified using a silica gel chromatography, to thereby obtain 18.1 g of 3,5-dimethyl-1,7-bis(3,5-divinyl phenyl) adamantane as a polymerizable compound X.

Hereinbelow, the appearance of the product and the results of the mass analysis and an elemental analysis are shown. These data indicates that the above obtained product is 3,5-dimethyl-1,7-bis(3,5-divinyl phenyl) adamantane.

Appearance: White Solid
MS(FD)(m/z): 420 (M+)
Elemental Analysis: Theoretical Value (/%) C; 91.37, H; 8.63, Actual Measured Value (/%) C; 91.35, H; 8.60

### (Synthesis Examples A19 to A28)

A polymerizable compound X was obtained in the same manner as Synthesis Example A18 except that the polymerizable compound obtained in each of Synthesis Examples A2 to A11 was prepared instead of the 3,5-dimethyl-1,7-bis(3,5-diethynyl phenyl) adamantane.

In this regard, it is to be noted that a structural formula of the polymerizable compound X obtained in each of Synthesis Examples A18 to A23 is shown in the following formula (5) and a structural formula of the polymerizable compound X obtained in each of Synthesis Examples A24 to A28 is shown in the following formula (6). Further, in the following formula (5), n is an integral number of 1 to 6 and the number of n corresponds to (the figure of each Synthesis Example - 17) and in the following formula (6), n is an integral number of 1 to 5 and the number of n corresponds to (the figure of each Synthesis Example - 23).

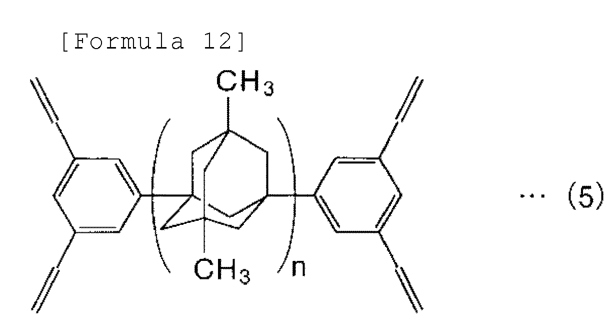

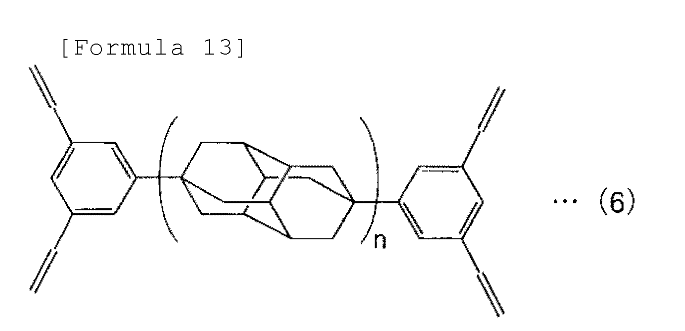

Here, the appearance of the polymerizable compound X in which n is 2 in the above formula (5) (Synthesis Example A19) and the results of the mass analysis and the elemental analysis are shown.

Appearance: White Solid
MS(FD)(m/z): 582 (M+)
Elemental Analysis: Theoretical Value (/%) C; 90.66, H; 9.34, Actual Measured Value (/%) C; 90.63, H; 9.31

Further, the appearance of the polymerizable compound X in which n is 3 in the above formula (5) (Synthesis Example A20) and the results of the mass analysis and the elemental analysis are shown.

Appearance: White Solid
MS(FD)(m/z): 745(M+)
Elemental Analysis: Theoretical Value (/%) C; 90.26, H; 9.74, Actual Measured Value (/%) C; 90.24, H; 9.70

The appearance of the polymerizable compound X in which n is 4 in the above formula (5) (Synthesis Example A21) and the results of the mass analysis and the elemental analysis are shown.

Appearance: White Solid
MS(FD)(m/z): 907 (M+)
Elemental Analysis: Theoretical Value (/%) C; 90.00, H; 10.00, Actual Measured Value (/%) C; 89.96, H; 9.97

The appearance of the polymerizable compound X in which n is 5 in the above formula (5) (Synthesis Example A22) and the results of the mass analysis and the elemental analysis are shown.

Appearance: White Solid
MS(FD)(m/z): 1,069(M+)
Elemental Analysis: Theoretical Value (/%) C; 89.82, H; 10.18, Actual Measured Value (/%) C; 89.80, H; 10.14

The appearance of the polymerizable compound X in which n is 6 in the above formula (5) (Synthesis Example A23) and the results of the mass analysis and the elemental analysis are shown.

Appearance: White Solid
MS(FD)(m/z): 1,231(M+)
Elemental Analysis: Theoretical Value (/%) C; 89.69, H; 10.31, Actual Measured Value (/%) C; 89.66, H; 10.29

The appearance of the polymerizable compound X in which n is 1 in the above formula (6) (Synthesis Example A24) and the results of the mass analysis and the elemental analysis are shown.

Appearance: White Solid
MS(FD)(m/z): 444 (M+)
Elemental Analysis: Theoretical Value (/%) C; 91.84, H; 8.16, Actual Measured Value (/%) C; 91.81, H; 8.13
The appearance of the polymerizable compound X in which n is 2 in the above formula (6) (Synthesis Example A25) and the results of the mass analysis and the elemental analysis are shown.
Appearance: White Solid
MS(FD)(m/z): 630 (M+)
Elemental Analysis: Theoretical Value (/%) C; 91.37, H; 8.63, Actual Measured Value (/%) C; 91.32, H; 8.61

The appearance of the polymerizable compound X in which n is 3 in the above formula (6) (Synthesis Example A26) and the results of the mass analysis and the elemental analysis are shown.

Appearance: White Solid
MS(FD)(m/z): 817 (M+)
Elemental Analysis: Theoretical Value (/%) C; 91.12, H; 8.88, Actual Measured Value (/%) C; 91.10, H; 8.84

The appearance of the polymerizable compound X in which n is 4 in the above formula (6) (Synthesis Example A27) and the results of the mass analysis and the elemental analysis are shown.

Appearance: White Solid
MS(FD)(m/z): 1,003(M+)
Elemental Analysis: Theoretical Value (/%) C; 90.96, H; 9.04, Actual Measured Value (/%) C; 90.93, H; 9.01

Furthermore, the appearance of the polymerizable compound X in which n is 5 in the above formula (6) (Synthesis Example A28) and the results of the mass analysis and the elemental analysis are shown.

Appearance: White Solid
MS(FD)(m/z): 1,189(M+)
Elemental Analysis: Theoretical Value (/%) C; 90.85, H; 9.15, Actual Measured Value (/%) C; 90.82, H; 9.11

### [A2] Preparation of Composition for Film Formation

### (Example A1)

5 g of the 3,5-dimethyl-1,7-bis(3,5-diethynyl phenyl) adamantane synthesized in Synthesis Example A1 as the polymerizable compound was dissolved into 45 g of 1,3-dimethoxy benzene and reacted under dry nitrogen gas at 170°C for 3 hours to obtain a reaction liquid, and then the reaction liquid was once cooled down to room temperature. When a molecular weight of a product contained in the reaction liquid was measured using GPC, a number average molecular weight thereof was 46,000.
The reaction liquid was heated once again, the 3,5-dimethyl-1,7-bis(3,5-diethynyl phenyl) adamantane was reacted at 150°C for 6 hours. Thereafter, the reaction liquid was dropped into 10 times of volume of a mixture solution containing methanol/tetrahydrofuran = 3/1 to produce a precipitate, and then the precipitate was collected, to thereby 2.8 g of a prepolymer (yield: 56%). 2 g of the obtained prepolymer was dissolved into 18 g of cyclopentanone, and then filtrated by the filter, to thereby obtain a composition for film formation as a varnish for organic insulating film.

### (Examples A2 to A5)

The polymerization reaction was carried out in the same manner as Example A1 to obtain a prepolymer except that the polymerizable compound synthesized in each of Synthesis Examples A2 to A5 was used. Further, the same treatment as described in Example A1 was performed using 2 g of the obtained prepolymer, to thereby prepare a composition for film formation as a varnish for organic insulating film.

### (Comparative Example A1)

The polymerization reaction was carried out in the same manner as Example A1 to obtain a prepolymer except that the polymerizable compound synthesized in Synthesis Example A6 was used. Further, the same treatment as described in Example A1 was performed using 2 g of the obtained prepolymer, to thereby prepare a composition for film formation as a varnish for organic insulating film.

### (Examples A6 to A9)

The polymerization reaction was carried out in the same manner as Example A1 to obtain a prepolymer except that the polymerizable compound synthesized in each of Synthesis Examples A7 to A10 was used. Further, the same treatment as described in Example A1 was performed using 2 g of the obtained prepolymer, to thereby prepare a composition for film formation as a varnish for organic insulating film.

### (Comparative Example A2)

The polymerization reaction was carried out in the same manner as Example A1 to obtain a prepolymer except that the polymerizable compound synthesized in Synthesis Example A11 was used. Further, the same treatment as described in Example A1 was performed using 2 g of the obtained prepolymer, to thereby prepare a composition for film formation as a varnish for organic insulating film.

### (Examples A10 and A11)

The polymerization reaction was carried out in the same manner as Example A1 to obtain a prepolymer except that the polymerizable compound synthesized in each of Synthesis Examples A12 and A13 was used. Further, the same treatment as described in Example A1 was performed using 2 g of the obtained prepolymer, to thereby prepare a composition for film formation as a varnish for organic insulating film.

### (Comparative Example A3)

The polymerization reaction was carried out in the same manner as Example A1 to obtain a prepolymer except that the polymerizable compound synthesized in Synthesis Example A14 was used. Further, the same treatment as described in Example A1 was performed using 2 g of the obtained prepolymer, to thereby prepare a composition for film formation as a varnish for organic insulating film.

### (Examples A12 and A13)

The polymerization reaction was carried out in the same manner as Example A1 to obtain a prepolymer except that the polymerizable compound synthesized in each of Synthesis Examples A15 and A16 was used. Further, the same treatment as described in Example A1 was performed using 2 g of the obtained prepolymer, to thereby prepare a composition for film formation as a varnish for organic insulating film.

### (Comparative Example A4)

The polymerization reaction was carried out in the same manner as Example A1 to obtain a prepolymer except that the polymerizable compound synthesized in Synthesis Example A17 was used. Further, the same treatment as described in Example A1 was performed using 2 g of the obtained prepolymer, to thereby prepare a composition for film formation as a varnish for organic insulating film.

### (Examples A14 to A18)

The polymerization reaction was carried out in the same manner as Example A1 to obtain a prepolymer except that the polymerizable compound synthesized in each of Synthesis Examples A18 to A22 was used. Further, the same treatment as described in Example A1 was performed using 2 g of the obtained prepolymer, to thereby prepare a composition for film formation as a varnish for organic insulating film.

### (Comparative Example A5)

The polymerization reaction was carried out in the same manner as Example A1 to obtain a prepolymer except that the polymerizable compound synthesized in Synthesis Example A23 was used. Further, the same treatment as described in Example A1 was performed using 2 g of the obtained prepolymer, to thereby prepare a composition for film formation as a varnish for organic insulating film.

### (Examples A19 to A22)

The polymerization reaction was carried out in the same manner as Example A1 to obtain a prepolymer except that the polymerizable compound synthesized in each of Synthesis Examples A24 to A27 was used. Further, the same treatment as described in Example A1 was performed using 2 g of the obtained prepolymer, to thereby prepare a composition for film formation as a varnish for organic insulating film.

### (Comparative Example A6)

The polymerization reaction was carried out in the same manner as Example A1 to obtain a prepolymer except that the polymerizable compound synthesized in Synthesis Example A28 was used. Further, the same treatment as described in Example A1 was performed using 2 g of the obtained prepolymer, to thereby prepare a composition for film formation as a varnish for organic insulating film.

Here, with regard to the polymerizable compound contained in the composition for film formation prepared in each of Examples and Comparative Examples, the number of carbon atoms derived from the aromatic ring, the number of carbon atoms derived from the polymerizable reactive group, the number of carbon atoms derived from the partial structure and a ratio of the carbon atoms derived from the aromatic ring are, respectively, shown in Table 1.

[Table 1]

**Table 1**

| | Number of Carbon Atoms Derived from Aromatic Ring | Number of Carbon Atoms Derived from Polymerizable Reactive Group | Number of Carbon Atoms Derived from Partial Structure | Ratio of Carbon Atoms Derived from Aromatic Ring (%) |
|---|---|---|---|---|
| Ex. A1 | 12 | 20 | 12 | 38 |
| Ex. A2 | 12 | 20 | 24 | 27 |
| Ex. A3 | 12 | 20 | 36 | 21 |
| Ex. A4 | 12 | 20 | 48 | 18 |
| Ex. A5 | 12 | 20 | 60 | 15 |
| Comp. Ex. A1 | 12 | 20 | 72 | 13 |
| Ex. A6 | 12 | 20 | 14 | 35 |
| Ex. A7 | 12 | 20 | 28 | 25 |
| Ex. A8 | 12 | 20 | 42 | 19 |
| Ex. A9 | 12 | 20 | 56 | 16 |
| Comp. Ex. A2 | 12 | 20 | 70 | 13 |
| Ex. A10 | 6 | 10 | 12 | 27 |
| Ex. A11 | 6 | 10 | 24 | 18 |
| Comp. Ex. A3 | 6 | 10 | 36 | 13 |
| Ex. A12 | 6 | 10 | 14 | 25 |
| Ex. A13 | 6 | 10 | 28 | 16 |
| Comp. Ex. A4 | 6 | 10 | 42 | 12 |
| Ex. A14 | 12 | 20 | 12 | 38 |
| Ex. A15 | 12 | 20 | 24 | 27 |
| Ex. A16 | 12 | 20 | 36 | 21 |
| Ex. A17 | 12 | 20 | 48 | 18 |
| Ex. A18 | 12 | 20 | 60 | 15 |
| Comp. Ex. A5 | 12 | 20 | 72 | 13 |
| Ex. A19 | 12 | 20 | 14 | 35 |
| Ex. A20 | 12 | 20 | 28 | 25 |
| Ex. A21 | 12 | 20 | 42 | 19 |
| Ex. A22 | 12 | 20 | 56 | 16 |
| Comp. Ex. A6 | 12 | 20 | 70 | 13 |

### [A3] Formation of Insulating Film (Production of Substrate with Film)

A plurality of insulating films were formed using the composition for film formation as the varnish for organic insulating film obtained in each of Examples and Comparative Examples as follows.

First, the composition for film formation as the varnish for organic insulating film was applied onto a silicon wafer using a spin coater to form a coating film. At this time, a rotation speed and a time of the spin coater was set so that a thickness of the insulating film after being subjected to a heat treatment would become 100 nm to form a coating film. Further, as for an insulating film for etching treatment, a rotation speed and a time of the spin coater was set so that a thickness of the insulating film after being subjected to a heat treatment would become 1,000 nm.

Next, the silicon wafer having the coating film formed in this way was placed on a hot plate heated at 200°C for 1 minute, to remove the solvent (cyclopentanone) from the coating film.

Thereafter, the silicon wafer having the dried coating film was subjected to a heat treatment (baking treatment) in which it was placed in an oven heated at 400°C under the nitrogen atmosphere for 30 minutes. In this way, an insulating film was formed by curing the prepolymer constituting the coating film, to thereby obtain a substrate with film (a substrate with insulating film).

Further, an etching treatment was carried out according to conditions shown in an item [A4.4] J for an etching rate evaluation.

### [A4] Evaluation of Insulating Film (Substrate with Film)

Before and after the insulating film (substrate with film) obtained in each of Examples and Comparative Examples was subjected to a reactive ion etching, permittivity, a breakdown voltage, a leak current and heat resistance thereof were evaluated according to the following evaluation method, respectively. Further, during the reactive ion etching, an etching rate of the insulating film was measured according to the following method.

### [A4.1] Permittivity

The permittivity was measured using an automatic mercury probe CV measuring apparatus ("SSM495" produced by JAPAN SSM corporation). In this regard, it is to be noted that a changing ratio of the permittivity was calculated by a formula: ((a value measured after etching) - (a value measured before etching) / (a value measured before etching)) × 100.

### [A4.2] Breakdown Voltage and Leak Current

The breakdown voltage and the leak current were measured using the automatic mercury probe CV measuring apparatus ("SSM495" produced by JAPAN SSM corporation) like the permittivity.

The breakdown voltage was defined as a voltage (MV) applied to the insulating film when a current of 1 × 10⁻² A flows therethrough, and was indicated by a field intensity (unit: MV/cm) which was a value obtained by dividing the voltage (MV) by a thickness of the insulating film. In this regard, it is to be noted that a changing ratio of the breakdown voltage was calculated by a formula: ((a value measured before etching) - (a value measured after etching) / (a value measured before etching)) × 100.

The leak current was defined as a current value (A) flowing through the insulating film when a field intensity of 1 MV/cm was applied thereto, and was indicated by a field density (unit: A/cm²) which was a value obtained by dividing the current value (A) by an area of a mercury electrode provided in the automatic mercury probe CV measuring apparatus. In this regard, it is to be noted that a change of the leak current was evaluated according to a ratio of a value of the leak current after the etching to a value of the leak current before the etching, which was calculated by dividing the former by the latter.

### [A4.3] Heat Resistance

The heat resistance was evaluated according to a thermal decomposition temperature of the obtained insulating film. A weight of the insulating film was measured using a TG/DTA measuring apparatus ("TG/DTA220" produced by Seiko Instruments, Inc.) under the nitrogen gas flow of 200 mL/min at a heating speed of 10°C/min, and then a temperature at which the weight of the insulating film decreased 5% was defined as the thermal decomposition temperature thereof. In this regard, it is to be noted that a changing ratio of the breakdown voltage was calculated by a formula: ((a value measured before etching) - (a value measured after etching) / (a value measured before etching)) × 100 like the changing ratio of the permittivity.

### [A4.4] Etching Rate

In each of Examples and Comparative Examples, an insulating film was formed on a silicon wafer having a diameter of 76 mm according to the formation of insulating film described in the item [A3], and then etched using a reactive ion etching method. Thereafter, a thickness of the insulating film before and after the etching was measured using a n&k Analyzer 1500 (produced by n&k Technology. Inc.). In this regard, in the case where a central coordinates was defined as (0, 0) and an orifla portion coordinates was (0, -38), 9 points existing in regular intervals on a line-coordinates from a coordinates (-38, 0) to a coordinates (38, 0) were selected as measurement points.
The etching rate was defined as a value obtained by dividing a changing ratio of an average value of the thicknesses in the 9 points after the etching to an average value of the thicknesses in the 9 points before the etching by the processing time of the reactive ion etching.

In this regard, it is to be noted that the reactive ion etching was carried out using L-201D-L (produced by ANELVA Corporation) at a frequency of 13.56 MHz, a pressure of 12.5 Pa, a power of 100 W and a flow rate (Nitrogen gas: 7.5 sccm, Hydrogen gas: 2.5 sccm) for a treatment time of 1 hour.

Further, a weight average molecular weight (Mw), a number average molecular weight (Mn) and a variance ratio (Mw/Mn) of the varnish for organic insulating film (composition for film formation) prepared in each of Examples and Comparative Examples were measured using a gel permeation chromatograph (GPC) apparatus ("HLC-8220GPC" produced by Tosoh Corporation).
A column was configured by serially connecting two TSKgel GMHXL (an exclusion limit in polystyrene conversion thereof was 4 × 10² (estimation)) and two TSKgel G2000HXL (an exclusion limit in polystyrene conversion thereof was 1 × 10⁴) to each other. Further, a detector was configured using a refractive index meter (RI) or a ultraviolet and visible detector (UV (254nm)).
The weight average molecular weight (Mw), the number average molecular weight (Mn) and the variance ratio (Mw/Mn) were obtained by analyzing the result measured using RI or UV. Further, as for measurement conditions, a moving phase was tetrahydrofuran, a temperature was 40°C, a flow rate was 1.00 mL/min, a sample concentration was 0.1 wt% in tetrahydrofuran solution.
These results are shown in Tables 2 to 4.

[Table 2]

**Table 2**

| | Permittivity | | | Breakdown Voltage | | |
|---|---|---|---|---|---|---|
| | Before Etching | After Etching | Changing Ratio [%] | Before Etching [MV/cm] | After Etching [MV/cm] | Changing Ratio [%] |
| Ex. A1 | 2.30 | 2.48 | 7.9 | 3.9 | 3.6 | 7.7 |
| Ex. A2 | 2.24 | 2.35 | 4.8 | 4.2 | 4.0 | 4.9 |
| Ex. A3 | 2.22 | 2.32 | 4.5 | 4.1 | 3.8 | 7.1 |
| Ex. A4 | 2.18 | 2.32 | 6.4 | 4.1 | 3.8 | 7.3 |
| Ex. A5 | 2.10 | 2.26 | 7.6 | 3.7 | 3.4 | 8.1 |
| Comp. Ex. A1 | 2.06 | 2.28 | 10.7 | 3.6 | 3.2 | 11.1 |
| Ex. A6 | 2.25 | 2.42 | 7.4 | 4.1 | 3.8 | 7.3 |
| Ex. A7 | 2.23 | 2.33 | 4.4 | 4.0 | 3.7 | 7.3 |
| Ex. A8 | 2.21 | 2.31 | 4.5 | 3.9 | 3.7 | 5.1 |
| Ex. A9 | 2.13 | 2.30 | 8.0 | 3.4 | 3.1 | 8.8 |
| Comp. Ex. A2 | 2.09 | 2.32 | 11.0 | 3.2 | 2.8 | 12.5 |
| Ex. A10 | 2.32 | 2.43 | 4.7 | 3.9 | 3.7 | 5.1 |
| Ex. A11 | 2.19 | 2.31 | 5.5 | 4.1 | 3.9 | 4.9 |
| Comp. Ex. A3 | 2.26 | 2.54 | 12.4 | 3.6 | 3.2 | 11.1 |
| Ex. A12 | 2.37 | 2.48 | 4.6 | 1.9 | 1.8 | 5.3 |
| Ex. A13 | 2.32 | 2.52 | 8.6 | 1.9 | 1.8 | 5.3 |
| Comp. Ex. A4 | 2.26 | 2.52 | 11.5 | 1.7 | 1.5 | 11.8 |
| Ex. A14 | 2.33 | 2.51 | 7.9 | 3.6 | 3.3 | 8.3 |
| Ex. A15 | 2.27 | 2.38 | 4.8 | 4.2 | 4.0 | 5.0 |
| Ex. A16 | 2.21 | 2.33 | 5.3 | 4.0 | 3.8 | 4.8 |
| Ex. A17 | 2.20 | 2.33 | 5.9 | 3.9 | 3.7 | 5.1 |
| Ex. A18 | 2.11 | 2.28 | 8.1 | 3.4 | 3.1 | 8.8 |
| Comp. Ex. A5 | 2.08 | 2.31 | 11.1 | 3.4 | 3.0 | 11.8 |
| Ex. A19 | 2.28 | 2.44 | 7.0 | 4.1 | 3.8 | 7.5 |
| Ex. A20 | 2.21 | 2.33 | 5.3 | 4.0 | 3.7 | 7.3 |
| Ex. A21 | 2.19 | 2.30 | 5.0 | 3.9 | 3.7 | 5.1 |
| Ex. A22 | 2.11 | 2.28 | 8.1 | 3.7 | 3.4 | 8.1 |
| Comp. Ex. A6 | 2.03 | 2.27 | 11.8 | 3.6 | 3.0 | 16.7 |

[Table 3]

**Table 3**

| | Leak Current | | | Thermal Decomposition Temperature | | |
|---|---|---|---|---|---|---|
| | Before Etching [A/cm²] | After Etching [A/cm²] | (After Etching)÷ (Before Etching) | Before Etching [°C] | After Etching [°C] | Changing Ratio [%] |
| Ex. A1 | 5.9×10⁻¹¹ | 3.3×10⁻⁹ | 56 | 486 | 457 | 6.0 |
| Ex. A2 | 1.8×10⁻¹¹ | 4.5×10⁻¹⁰ | 25 | 510 | 495 | 3.0 |
| Ex. A3 | 2.0×10⁻¹¹ | 9.6×10⁻¹⁰ | 48 | 504 | 489 | 2.9 |
| Ex. A4 | 3.8×10¹¹ | 2.1×10⁻⁹ | 55 | 498 | 473 | 5.0 |
| Ex. A5 | 8.7×10⁻¹¹ | 5.4×10⁻⁹ | 62 | 463 | 421 | 9.1 |
| Comp. Ex. A1 | 1.1×10⁻¹⁰ | 2.3×10⁻⁸ | 209 | 452 | 404 | 10.6 |
| Ex. A6 | 2.3×10⁻¹⁰ | 8.7×10⁻⁹ | 38 | 502 | 461 | 8.1 |
| Ex. A7 | 2.1×10⁻¹⁰ | 6.7×10⁻⁹ | 32 | 498 | 463 | 7.0 |
| Ex. A8 | 3.5×10⁻¹⁰ | 8.8×10⁻⁹ | 25 | 479 | 450 | 6.1 |
| Ex. A9 | 6.7×10⁻¹⁰ | 4.5×10⁻⁸ | 67 | 448 | 405 | 9.6 |
| Comp. Ex. A2 | 6.5×10⁻¹⁰ | 1.8×10⁻⁷ | 277 | 438 | 377 | 13.9 |
| Ex. A10 | 3.2×10⁻¹¹ | 9.0×10⁻¹⁰ | 28 | 386 | 355 | 8.0 |
| Ex. A11 | 3.9×10⁻¹¹ | 2.2×10⁻⁹ | 56 | 496 | 470 | 5.2 |
| Comp. Ex. A3 | 9.1×10⁻¹¹ | 2.3×10⁻⁸ | 253 | 352 | 311 | 11.6 |
| Ex. A12 | 8.3×10⁻⁸ | 2.6×10⁻⁶ | 31 | 367 | 334 | 9.0 |
| Ex. A13 | 8.6×10⁻⁸ | 7.9×10⁻⁶ | 92 | 352 | 299 | 15.1 |
| Comp. Ex. A4 | 9.6×10⁻⁸ | 3.4×10⁻⁵ | 354 | 338 | 267 | 21.0 |
| Ex. A14 | 4.7×10⁻¹¹ | 2.4×10⁻⁹ | 51 | 476 | 433 | 9.0 |
| Ex. A15 | 1.8×10⁻¹¹ | 5.9×10⁻¹⁰ | 33 | 510 | 490 | 3.9 |
| Ex. A16 | 2.6×10⁻¹¹ | 1.3×10⁻⁹ | 48 | 501 | 486 | 3.0 |
| Ex. A17 | 2.8×10⁻¹¹ | 1.8×10⁻⁹ | 64 | 492 | 467 | 5.1 |
| Ex. A18 | 6.8×10⁻¹¹ | 4.7×10⁻⁹ | 69 | 471 | 433 | 8.1 |
| Comp. Ex. A5 | 8.7×10⁻¹¹ | 12×10⁻⁸ | 138 | 459 | 409 | 10.9 |
| Ex. A19 | 2.0×10⁻¹¹ | 1.2×10⁻⁹ | 61 | 501 | 456 | 9.0 |
| Ex. A20 | 2.0×10⁻¹¹ | 5.6×10⁻¹⁰ | 28 | 496 | 466 | 6.0 |
| Ex. A21 | 2.3×10⁻¹¹ | 7.6×10⁻¹⁰ | 33 | 476 | 438 | 8.0 |
| Ex. A22 | 5.9×10⁻¹¹ | 5.6×10⁻⁹ | 95 | 453 | 394 | 13.0 |
| Comp. Ex. A6 | 6.2×10⁻¹¹ | 1.3×10⁻⁸ | 210 | 428 | 355 | 17.1 |

[Table 4]

**Table 4**

| | Etching Rate Å/sec | Molecular Weight of Prepolymer | | |
|---|---|---|---|---|
| | | Mw | Mn | Mw/Mn |
| Ex. A1 | 43 | 109800 | 38700 | 2.8 |
| Ex. A2 | 11 | 111400 | 39800 | 2.8 |
| Ex. A3 | 13 | 123500 | 44700 | 2.8 |
| Ex. A4 | 26 | 136700 | 48500 | 2.8 |
| Ex. A5 | 75 | 128600 | 47800 | 2.7 |
| Comp. Ex. A1 | 97 | 101200 | 14900 | 6.8 |
| Ex. A6 | 46 | 135400 | 42300 | 3.2 |
| Ex. A7 | 21 | 148300 | 42400 | 3.5 |
| Ex. A8 | 38 | 173400 | 54100 | 3.2 |
| Ex. A9 | 86 | 157900 | 53500 | 3.0 |
| Comp. Ex. A2 | 102 | 165300 | 17100 | 9.7 |
| Ex. A10 | 15 | 62300 | 23100 | 2.7 |
| Ex. A11 | 28 | 43800 | 15600 | 2.8 |
| Comp. Ex. A3 | 96 | 39700 | 4461 | 8.9 |
| Ex. A12 | 47 | 359500 | 32100 | 11.2 |
| Ex. A13 | 88 | 326500 | 25500 | 12.8 |
| Comp. Ex. A4 | 117 | 297300 | 25600 | 11.6 |
| Ex. A14 | 53 | 117600 | 41990 | 2.8 |
| Ex. A15 | 12 | 133400 | 40100 | 3.3 |
| Ex. A16 | 19 | 122700 | 44800 | 2.7 |
| Ex. A17 | 31 | 132500 | 49300 | 2.7 |
| Ex. A18 | 74 | 142800 | 50800 | 2.8 |
| Comp. Ex. A5 | 99 | 118700 | 12700 | 9.4 |
| Ex. A19 | 53 | 125200 | 39800 | 3.1 |
| Ex. A20 | 23 | 141800 | 45900 | 3.1 |
| Ex. A21 | 41 | 165400 | 51400 | 3.2 |
| Ex. A22 | 79 | 182200 | 52700 | 3.5 |
| Comp. Ex. A6 | 115 | 359500 | 32100 | 11.2 |

As evidenced by Tables 2 and 3, in each of Examples, with respect to each of the evaluation items such as the permittivity, the breakdown voltage, the leak current and the thermal decomposition temperature, the changing ratio thereof before and after the etching is kept down. Especially, such a tendency is remarkably found with respect to the permittivity, and the changing ratio thereof is kept down 10% or less.

Further, in Examples shown in Table 4, the etching rate when the insulating film is etched is kept down in the range of 10 to 90 Å/sec.

On the other hand, in each of Comparative Examples, the number of carbon atoms derived from the aromatic ring is less than 15% with respect to the number of total carbon atoms of the polymerizable compound. For this reason, with respect to each of the evaluation items, the changing ratio thereof before and after the etching is large. Especially, such a tendency is remarkably found with respect to the permittivity. Further, in each of Comparative Examples, the etching rate when the insulating film is etched is high. This is likely to cause alteration of deterioration of the insulating film.

### <Example Group B>

### [B1] Synthesis of Polymerizable Compound

### (Synthesis Example B1)

First, 1,3-dimethyl adamantane was prepared, 700 mL of carbon tetrachloride and 35 g (0.22 mol) of bromine were put into a 2000 mL four neck flask provided with a thermometer, a stirrer and a reflux tube, and then 32.9 g (0.2 mol) of the prepared 1,3-dimethyl adamantane was added thereto little by little while stirring them. In this regard, while adding it, an inside temperature was kept at 20 to 30°C.

After the addition was finished, and then the temperature increase was stopped, they were reacted with each other for another hour.
Thereafter, about 2000 mL of cold water was poured into the flask to produce a crude product, and then the crude product was filtrated and collected, washed with deionized water, and then dried.

Further, the crude product was recrystallized using heat ethanol to obtain a recrystallized product. The obtained recrystallized product was dried under reduced pressure to thereby obtain 37.4 g of a product. Absorption derived from a bromo group was observed within 690 to 515 cm⁻¹ by IR analysis and a molecular weight thereof was 322 by mass analysis. This result showed that the product was 3,5-dimethyl-1,7-dibromo adamantane.

Next, 33.2g (103.2 mmol) of the above obtained 3,5-dimethyl-1,7-dibromo adamantane and 1,217 g (5,161.6 mmol) of 1,3-dibromo benzene were stirred in the flask, and then 24.8g (93.0 mmol) of aluminium bromide(III) was added thereto at 25°C under dry nitrogen little by little. The same was heated up to 60°C and stirred for 8 hours, and then returned to room temperature, to thereby obtain a reaction liquid.
The reaction liquid was added to 700 mL of a 5% hydrochloric acid solution and stirred. A water phase was removed and an organic phase was added to 2,000 mL of acetone to obtain a precipitate. The precipitate was filtrated and washed three times with 1,000 mL of acetone, to thereby obtain 57 g of 3,5-dimethyl-1,7-bis(3,5-dibromo phenyl) adamantane. A molecular weight thereof was 632 by mass analysis. This result showed that the product was 3,5-dimethyl-1,7-bis(3,5-dibromo phenyl) adamantane.

39.8 g (62.9 mmol) of 3,5-dimethyl-1,7-bis(3,5-dibromo phenyl) adamantane obtained above, 3.53 g (5.0 mmol) of dichloro bistriphenyl phosphine palladium, 6.60 g (25.2 mmol) of triphenyl phosphine, 4.79 g (25.2 mmol) of copper iodide(II) and 750 mL of triethyl amine were put into the flask and stirred. The same was heated up to 75°C, and then 37.1 g (377.7 mmol) of trimethyl silyl acetylene was slowly added thereto. This was stirred at 75°C for 7 hours, and then heated up to 120°C to remove the triethyl amine therefrom.
Thereafter, this was returned to room temperature, 1,000 mL of dichloro methane was added to the reaction liquid and stirred for 20 minutes to obtain a precipitate. The precipitate was removed by filtration to obtain a filtrate, and then 1,000 mL of a 5% hydrochloric acid solution was added to the filtrate so that it was separated. An organic phase was washed three times with 1,000 mL of water, and then a solvent was removed from the organic phase under reduced pressure, to thereby obtain a compound.
The obtained compound was dissolved into 1,500 mL of hexane to produce an insoluble product. The insoluble product was removed by filtration to obtain a filtrate, and then the hexane was removed from the filtrate. 1,000 mL of acetone was added thereto to produce a precipitate, and then the precipitate was washed three times with acetone, to thereby obtain 36.1 g of 3,5-dimethyl-1,7-bis(3,5-ditrimethyl silyl ethynyl phenyl) adamantane. A molecular weight thereof was 701 by mass analysis. This result showed that the product was 3,5-dimethyl-1,7-bis(3,5-ditrimethyl silyl ethynyl phenyl) adamantane.

Further, 32.3 g (46.1 mmol) of the 3,5-dimethyl-1,7-bis(3,5-ditrimethyl silyl ethynyl phenyl) adamantane obtained above and 1.46 g (10.6 mmol) of potassium carbonate were reacted with each other in a mixture solvent containing 600 mL of tetrahydrofuran and 300 mL of methanol under nitrogen atmosphere at room temperature for 4 hours. The same was added to 1,000 mL of a 10% hydrochloric acid solution to obtain a precipitate, and then the precipitate was filtrated. Thereafter, the obtained precipitate was washed with 1,000 mL of water, washed with 1,000 mL of acetone, and then dried, to thereby obtain 15.0 g of 3,5-dimethyl-1,7-bis(3,5-diethynyl phenyl) adamantane as a polymerizable compound X.

Hereinbelow, the appearance of the product and the results of the mass analysis and an elemental analysis are shown. These data indicates that the above obtained product is 3,5-dimethyl-1,7-bis(3,5-diethynyl phenyl) adamantane.

Appearance: White Solid
MS(FD)(m/z) : 413 (M+)
Elemental Analysis: Theoretical Value (/%) C; 93.16, H; 6.84, Actual Measured Value (/%) C; 93.11, H; 6.82

### (Synthesis Examples B2 to B5)

A polymerizable compound X was obtained in the same manner as Synthesis Example B1 except that tetramethyl biadamantane, hexamethyl triadamantane, octamethyl tetraadamantane or decamethyl pentaadamantane was prepared instead of the dimethyl adamantane.

In this regard, it is to be noted that a structural formula of the polymerizable compound X obtained in each of Synthesis Examples B1 to B5 is shown in the following formula (1). In the following formula (1), n is an integral number of 1 to 5 and the number of n corresponds to the number (figure) of each Synthesis Example.

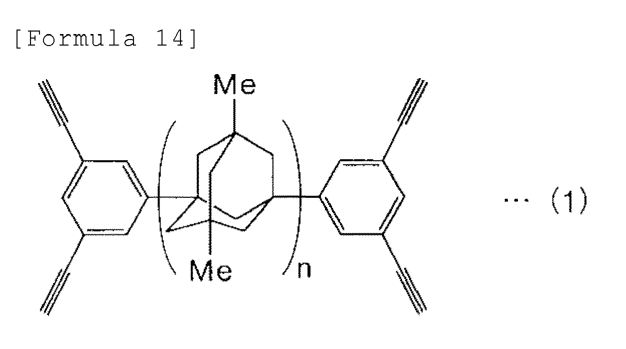

Here, the appearance of the polymerizable compound X in which n is 2 in the above formula (1) (Synthesis Example B2) and the results of the mass analysis and the elemental analysis are shown.

Appearance: White Solid
MS(FD)(m/z) : 574 (M+)
Elemental Analysis: Theoretical Value (/%) C; 91.93, H; 8.07, Actual Measured Value (/%) C; 91.87, H; 8.00

Further, the appearance of the polymerizable compound X in which n is 3 in the above formula (1) (Synthesis Example B3) and the results of the mass analysis and the elemental analysis are shown.

Appearance: White Solid
MS(FD)(m/z) : 737 (M+)
Elemental Analysis: Theoretical Value (/%) C; 91.25, H; 8.75, Actual Measured Value (/%) C; 91.21, H; 8.77

Further, the appearance of the polymerizable compound X in which n is 4 in the above formula (1) (Synthesis Example B4) and the results of the mass analysis and the elemental analysis are shown.

Appearance: White Solid
MS(FD)(m/z) : 899(M+)
Elemental Analysis: Theoretical Value (/%) C; 90.81, H; 9.19, Actual Measured Value (/%) C; 90.75, H; 9.16

Further, the appearance of the polymerizable compound X in which n is 5 in the above formula (1) (Synthesis Example B5) and the results of the mass analysis and the elemental analysis are shown.

Appearance: White Solid
MS(FD)(m/z) : 1,062(M+)
Elemental Analysis: Theoretical Value (/%) C; 90.51, H; 9.49, Actual Measured Value (/%) C; 90.49, H; 9.47

### (Synthesis Example B6)

First, according to a synthesis method described in Journal of Organic Chemistry., 39, 2987-3003 (1974), 4,9-dibromo diamantane was synthesized. Absorption derived from a bromo group was observed within 690 to 515 cm⁻¹ by IR analysis and a molecular weight thereof was 346 by mass analysis. This result showed that the product was 4,9-dibromo diamantane.

Next, in the synthesis of the 3,5-dimethyl-1,7-bis(3,5-dibromo phenyl) adamantane as the synthetic intermediate of Synthesis Example B1, the reaction was carried out in the same manner as Synthesis Example B1 except that 35.7 g (103.1 mmol) of the above obtained 4,9-dibromo diamantane was used instead of the 3,5-dimethyl-1,7-dibromo adamantane. In this way, 56 g of 4,9-bis(3,5-dibromo phenyl) diamantane was obtained. A molecular weight thereof was 656 by mass analysis. This result showed that the product was 4,9-bis(3,5-dibromo phenyl) diamantane.

Next, in the synthesis of the 3,5-dimethyl-1,7-bis(3,5-ditrimethyl silyl ethynyl phenyl) adamantane as the synthetic intermediate of Synthesis Example B1, the reaction was carried out in the same manner as Synthesis Example B1 except that 41.2 g (62.8 mmol) of the above obtained 4,9-bis(3,5-dibromo phenyl) diamantane was used instead of the 3,5-dimethyl-1,7-bis(3,5-dibromo phenyl) adamantane. In this way, 35.5 g of 4,9-bis(3,5-ditrimethyl silyl ethynyl phenyl) diamantane was obtained. A molecular weight thereof was 725 by mass analysis. This result showed that the product was 4,9-bis(3,5-ditrimethyl silyl ethynyl phenyl) diamantane.

Further, in the synthesis of the 3,5-dimethyl-1,7-bis(3,5-diethynyl phenyl) adamantane as the final product of Synthesis Example B1, the reaction was carried out in the same manner as Synthesis Example B1 except that 38.8 g (53.5 mmol) of the above obtained 4,9-bis(3,5-ditrimethyl silyl ethynyl phenyl) diamantane was used instead of the 3,5-dimethyl-1,7-bis(3,5-ditrimethyl silyl ethynyl phenyl) adamantane. In this way, 14.3 g of 4,9-bis(3,5-diethynyl phenyl) diamantane was obtained as a polymerizable compound X.

Hereinbelow, the appearance of the product and the results of the mass analysis and an elemental analysis are shown. These data indicates that the above obtained product is 4,9-bis(3,5-diethynyl phenyl) diamantane.

Appearance: White Solid
MS(FD)(m/z) : 436(M+)
Elemental Analysis: Theoretical Value (/%) C; 93.54, H; 6.46, Actual Measured Value (/%) C; 93.46, H; 6.38

### (Synthesis Examples B7 to B9)

A polymerizable compound X was obtained in the same manner as Synthesis Example B6 except that dibromo di(diamantane), dibromo tri(diamantane) or dibromo tetra(diamantane) was prepared instead of the dibromo diamantane.

In this regard, it is to be noted that a structural formula of the polymerizable compound X obtained in each of Synthesis Examples B6 to B9 is shown in the following formula (4). In the following formula (4), n is an integral number of 1 to 4 and the number of n corresponds to (the figure of each Synthesis Example - 5).

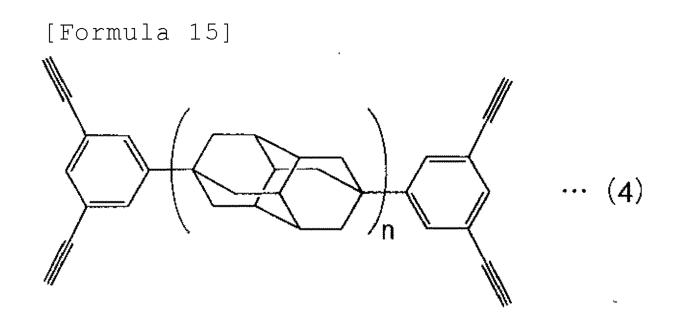

Here, the appearance of the polymerizable compound X in which n is 2 in the above formula (4) (Synthesis Example B7) and the results of the mass analysis and the elemental analysis are shown.

Appearance: White Solid
MS(FD)(m/z): 622 (M+)
Elemental Analysis: Theoretical Value (/%) C; 92.56, H; 7.44, Actual Measured Value (/%) C; 92.53, H; 7.41

Further, the appearance of the polymerizable compound X in which n is 3 in the above formula (4) (Synthesis Example B8) and the results of the mass analysis and the elemental analysis are shown.

Appearance: White Solid
MS(FD)(m/z) : 809(M+)
Elemental Analysis: Theoretical Value (/%) C; 92.03, H; 7.97, Actual Measured Value (/%) C; 92.01, H; 7.94

The appearance of the polymerizable compound X in which n is 4 in the above formula (4) (Synthesis Example B9) and the results of the mass analysis and the elemental analysis are shown.

Appearance: White Solid
MS(FD)(m/z) : 995(M+)
Elemental Analysis: Theoretical Value (/%) C; 91.70, H; 8.30, Actual Measured Value (/%) C; 91.67, H; 8.28

### (Synthesis Example B10)

First, 45.5 g (187.1 mmol) of 3,5-dimethyl-1-bromo adamantane and 1,217 g (5161.6 mmol) of 1,3-dibromo benzene were put into a 2000 mL four neck flask provided with a thermometer, a stirrer and a reflux tube and stirred, and then 24.8 g (93.0 mmol) of aluminium bromide(III) was added thereto at 25°C under dry nitrogen little by little. The same was heated up to 60°C and stirred for 8 hours, and then returned to room temperature, to thereby obtain a reaction liquid.

Next, the reaction liquid was added to 700 mL of a 5% hydrochloric acid solution and stirred. A water phase was removed and an organic phase was added to 2,000 mL of acetone to obtain a precipitate. The precipitate was filtrated and washed three times with 1,000 mL of acetone, to thereby obtain 51.4 g of 3,5-dimethyl-1-(3,5-dibromo phenyl) adamantane. A molecular weight thereof was 398 by mass analysis. This result showed that the product was 3,5-dimethyl-1-(3,5-dibromo phenyl) adamantane.

Next, 47.1 g (118.4 mmol) of 3,5-dimethyl-1-(3,5-dibromo phenyl) adamantane obtained above, 6.66 g (9.5 mmol) of dichloro bistriphenyl phosphine palladium, 179.5 g (47.3 mmol) of triphenyl phosphine, 248.7 g (47.3 mmol) of copper iodide(II) and 750 mL of triethyl amine were put into the flask and stirred. The same was heated up to 75°C, and then 34.9 g (355.2 mmol) of trimethyl silyl acetylene was slowly added thereto. This was stirred at 75°C for 7 hours, and then heated up to 120°C to remove the triethyl amine therefrom.
Thereafter, this was returned to room temperature, 1,000 mL of dichloro methane was added to the reaction liquid and stirred for 20 minutes to obtain a precipitate. The precipitate was removed by filtration to obtain a filtrate, and then 1,000 mL of a 5% hydrochloric acid solution was added to the filtrate so that it was separated. An organic phase was washed three times with 1,000 mL of water, and then a solvent was removed from the organic phase under reduced pressure, to thereby obtain a compound.
The obtained compound was dissolved into 1,500 mL of hexane to produce an insoluble product. The insoluble product was removed by filtration to obtain a filtrate, and then the hexane was removed from the filtrate. 1,000 mL of acetone was added thereto to produce a precipitate, and then the precipitate was washed three times with acetone, to thereby obtain 37 g of 3,5-dimethyl-1-(3,5-ditrimethyl silyl ethynyl phenyl) adamantane. A molecular weight thereof was 432 by mass analysis. This result showed that the product was 3,5-dimethyl-1-(3,5-ditrimethyl silyl ethynyl phenyl) adamantane.

Further, 36 g (83.1 mmol) of the 3,5-dimethyl-1-(3,5-ditrimethyl silyl ethynyl phenyl) adamantane obtained above and 2.7 g (19.3 mmol) of potassium carbonate were reacted with each other in a mixture solvent containing 600 mL of tetrahydrofuran and 300 mL of methanol under nitrogen atmosphere at room temperature for 4 hours. The same was added to 1,000 mL of a 10% hydrochloric acid solution to obtain a precipitate, and then the precipitate was filtrated. Thereafter, the obtained precipitate was washed with 1,000 mL of water, washed with 1,000 mL of acetone, and then dried, to thereby obtain 19 g of 3,5-dimethyl-1-(3,5-diethynyl phenyl) adamantane as a polymerizable compound X.

Hereinbelow, the appearance of the product and the results of the mass analysis and an elemental analysis are shown. These data indicates that the above obtained product is 3,5-dimethyl-1-(3,5-diethynyl phenyl) adamantane.

Appearance: White Solid
MS(FD)(m/z) : 288 (M+)
Elemental Analysis: Theoretical Value (/%) C; 91.61, H; 8.39, Actual Measured Value (/%) C; 91.59, H; 8.37

### (Synthesis Example B11)

A polymerizable compound X was obtained in the same manner as Synthesis Example B10 except that tetramethyl bromo biadamantane was prepared instead of the dimethyl bromo adamantane.

In this regard, it is to be noted that a structural formula of the polymerizable compound X obtained in each of Synthesis Examples B10 and B11 is shown in the following formula (1'). In the following formula (1'), n is an integral number of 1 to 2 and the number of n corresponds to (the figure of each Synthesis Example - 9).

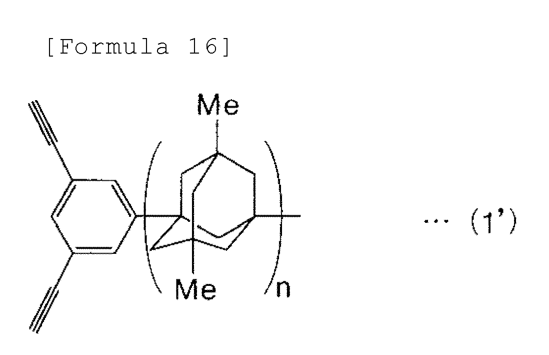

Here, the appearance of the polymerizable compound X in which n is 2 in the above formula (1') (Synthesis Example B11) and the results of the mass analysis and the elemental analysis are shown.

Appearance: White Solid
MS(FD)(m/z): 450 (M+)
Elemental Analysis: Theoretical Value (/%) C; 90.61, H; 9.39, Actual Measured Value (/%) C; 90.59, H; 9.36

### (Synthesis Example B12)

First, 50 g (187.1 mmol) of 4-bromo diamantane and 1,217 g (5161.6 mmol) of 1,3-dibromo benzene were put into a 2000 mL four neck flask provided with a thermometer, a stirrer and a reflux tube and stirred, and then 24.8 g (93.0 mmol) of aluminium bromide(III) was added thereto at 25°C under dry nitrogen little by little. The same was heated up to 60°C and stirred for 8 hours, and then returned to room temperature, to thereby obtain a reaction liquid.

Next, the reaction liquid was added to 700 mL of a 5% hydrochloric acid solution and stirred. A water phase was removed and an organic phase was added to 2,000 mL of acetone to obtain a precipitate. The precipitate was filtrated and washed three times with 1,000 mL of acetone, to thereby obtain 56 g of 4-(3,5-dibromo phenyl) diamantane. A molecular weight thereof was 422 by mass analysis. This result showed that the product was 4-(3,5-dibromo phenyl) diamantane.

Next, 50 g (118.4 mmol) of 4-(3,5-dibromo phenyl) diamantane obtained above, 6.66 g (9.5 mmol) of dichloro bistriphenyl phosphine palladium, 179.5 g (47.3 mmol) of triphenyl phosphine, 248.7 g (47.3 mmol) of copper iodide(II) and 750 mL of triethyl amine were put into the flask and stirred. The same was heated up to 75°C, and then 34.9 g (355.2 mmol) of trimethyl silyl acetylene was slowly added thereto. This was stirred at 75°C for 7 hours, and then heated up to 120°C to remove the triethyl amine therefrom.
Thereafter, this was returned to room temperature, 1,000 mL of dichloro methane was added to the reaction liquid and stirred for 20 minutes to obtain a precipitate. The precipitate was removed by filtration to obtain a filtrate, and then 1,000 mL of a 5% hydrochloric acid solution was added to the filtrate so that it was separated. An organic phase was washed three times with 1,000 mL of water, and then a solvent was removed from the organic phase under reduced pressure, to thereby obtain a compound.
The obtained compound was dissolved into 1,500 mL of hexane to produce an insoluble product. The insoluble product was removed by filtration to obtain a filtrate, and then the hexane was removed from the filtrate. 1,000 mL of acetone was added thereto to produce a precipitate, and then the precipitate was washed three times with acetone, to thereby obtain 41 g of 4-(3,5-ditrimethyl silyl ethynyl phenyl) diamantane. A molecular weight thereof was 456 by mass analysis. This result showed that the product was 4-(3,5-ditrimethyl silyl ethynyl phenyl) diamantane.

Further, 40 g (87.6 mmol) of the 4-(3,5-ditrimethyl silyl ethynyl phenyl) diamantane obtained above and 2.7 g (19.3 mmol) of potassium carbonate were reacted with each other in a mixture solvent containing 600 mL of tetrahydrofuran and 300 mL of methanol under nitrogen atmosphere at room temperature for 4 hours. The same was added to 1,000 mL of a 10% hydrochloric acid solution to obtain a precipitate, and then the precipitate was filtrated. Thereafter, the obtained precipitate was washed with 1,000 mL of water, washed with 1,000 mL of acetone, and then dried, to thereby obtain 23 g of 4-(3,5-diethynyl phenyl) diamantane as a polymerizable compound X.

Hereinbelow, the appearance of the product and the results of the mass analysis and an elemental analysis are shown. These data indicates that the above obtained product is 4-(3,5-diethynyl phenyl) diamantane.

Appearance: White Solid
MS(FD)(m/z) : 312 (M+)
Elemental Analysis: Theoretical Value (/%) C; 92.26, H; 7.74, Actual Measured Value (/%) C; 92.12, H; 7.70

### (Synthesis Example B13)

A polymerizable compound X was obtained in the same manner as Synthesis Example B12 except that bromo bi(diamantane) was prepared instead of the bromo diamantane.

In this regard, it is to be noted that a structural formula of the polymerizable compound X obtained in each of Synthesis Examples B12 and B13 is shown in the following formula (4'). In the following formula (4'), n is an integral number of 1 to 2 and the number of n corresponds to (the figure of each Synthesis Example - 11).

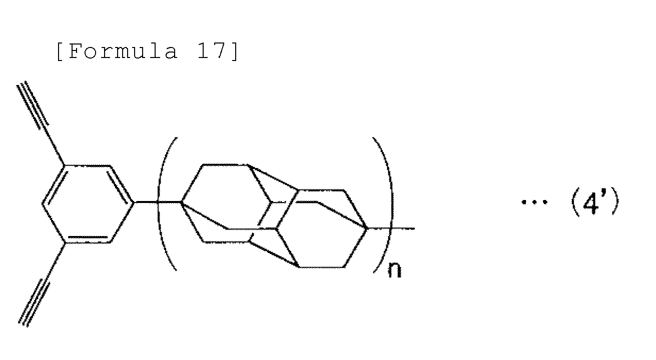

Here, the appearance of the polymerizable compound X in which n is 2 in the above formula (4') (Synthesis Example B13) and the results of the mass analysis and the elemental analysis are shown.

Appearance: White Solid
MS(FD)(m/z) : 498 (M+)
Elemental Analysis: Theoretical Value (/%) C; 91.51, H; 8.94, Actual Measured Value (/%) C; 91.49, H; 8.46

### (Synthesis Example B14)

14.4 g (34.9 mmol) of the 3,5-dimethyl-1,7-bis(3,5-diethynyl phenyl) adamantane obtained in Synthesis Example B1, 67.4 g (522 mmol) of quinoline, 0.37 g (0.174 mmol) of 5% palladium-calcium carbonate and 1,000 mL of tetrahydrofuran were put into a 5 L eggplant flask together with a stirring bar, and then stirring was started at room temperature while flowing hydrogen gas. When 3.35 L (139 mmol) of the hydrogen gas was consumed, the reaction was stopped by introducing nitrogen gas into the flask, to thereby obtain a reaction liquid.
Thereafter, the reaction liquid was filtrated to obtain a filtration, and then the solvent was removed from the filtration to obtain a solid. The obtained solid was purified using a silica gel chromatography, to thereby obtain 18.1 g of 3,5-dimethyl-1,7-bis(3,5-divinyl phenyl) adamantane as a polymerizable compound X.

Hereinbelow, the appearance of the product and the results of the mass analysis and an elemental analysis are shown. These data indicates that the above obtained product is 3,5-dimethyl-1,7-bis(3,5-divinyl phenyl) adamantane.

Appearance: White Solid
MS(FD)(m/z) : 420 (M+)
Elemental Analysis: Theoretical Value (/%) C; 91.37, H; 8.63, Actual Measured Value (/%) C; 91.35, H; 8.60

### (Synthesis Examples B15 to B22)

A polymerizable compound X was obtained in the same manner as Synthesis Example B14 except that the polymerizable compound obtained in each of Synthesis Examples B2 to B9 was prepared instead of the 3,5-dimethyl-1,7-bis(3,5-diethynyl phenyl) adamantane.

In this regard, it is to be noted that a structural formula of the polymerizable compound X obtained in each of Synthesis Examples B14 to B18 is shown in the above formula (5) and a structural formula of the polymerizable compound X obtained in each of Synthesis Examples B19 to B22 is shown in the following formula (6). Further, in the above formula (5), n is an integral number of 1 to 5 and the number of n corresponds to (the figure of each Synthesis Example - 13) and in the following formula (6), n is an integral number of 1 to 4 and the number of n corresponds to (the figure of each Synthesis Example - 18).

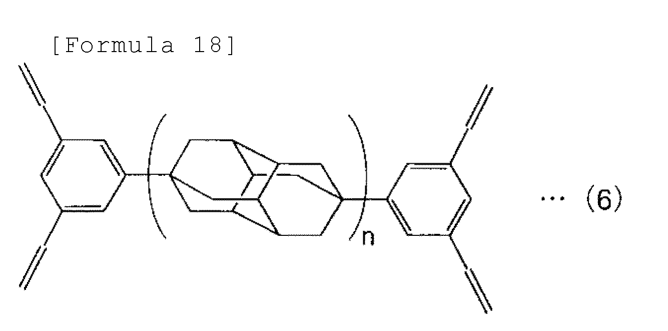

Here, the appearance of the polymerizable compound X in which n is 2 in the above formula (5) (Synthesis Example B15) and the results of the mass analysis and the elemental analysis are shown.

Appearance: White Solid
MS(FD) (m/z): 582 (M+)
Elemental Analysis: Theoretical Value (/%) C; 90.66, H; 9.34, Actual Measured Value (/%) C; 90.63, H; 9.31

Further, the appearance of the polymerizable compound X in which n is 3 in the above formula (5) (Synthesis Example B16) and the results of the mass analysis and the elemental analysis are shown.

Appearance: White Solid
MS(FD)(m/z) : 745(M+)
Elemental Analysis: Theoretical Value (/%) C; 90.26, H; 9.74, Actual Measured Value (/%) C; 90.24, H; 9.70

The appearance of the polymerizable compound X in which n is 4 in the above formula (5) (Synthesis Example B17) and the results of the mass analysis and the elemental analysis are shown.

Appearance: White Solid
MS(FD)(m/z) : 907(M+)
Elemental Analysis: Theoretical Value (/%) C; 90.00, H; 10.00, Actual Measured Value (/%) C; 89.96, H; 9.97

The appearance of the polymerizable compound X in which n is 5 in the above formula (5) (Synthesis Example B18) and the results of the mass analysis and the elemental analysis are shown.

Appearance: White Solid
MS(FD) (m/z): 1,069(M+)
Elemental Analysis: Theoretical Value (/%) C; 89.82, H; 10.18, Actual Measured Value (/%) C; 89.80, H; 10.14

The appearance of the polymerizable compound X in which n is 1 in the above formula (6) (Synthesis Example B19) and the results of the mass analysis and the elemental analysis are shown.

Appearance: White Solid
MS(FD)(m/z) : 444 (M+)
Elemental Analysis: Theoretical Value (/%) C; 91.84, H; 8.16, Actual Measured Value (/%) C; 91.81, H; 8.13

The appearance of the polymerizable compound X in which n is 2 in the above formula (6) (Synthesis Example B20) and the results of the mass analysis and the elemental analysis are shown.

Appearance: White Solid
MS(FD)(m/z) : 630 (M+)
Elemental Analysis: Theoretical Value (/%) C; 91.37, H; 8.63, Actual Measured Value (/%) C; 91.32, H; 8.61

The appearance of the polymerizable compound X in which n is 3 in the above formula (6) (Synthesis Example B21) and the results of the mass analysis and the elemental analysis are shown.

Appearance: White Solid
MS(FD) (m/z): 817 (M+)
Elemental Analysis: Theoretical Value (/%) C; 91.12, H; 8.88, Actual Measured Value (/%) C; 91.10, H; 8.84

The appearance of the polymerizable compound X in which n is 4 in the above formula (6) (Synthesis Example B22) and the results of the mass analysis and the elemental analysis are shown.

Appearance: White Solid
MS(FD)(m/z) : 1,003(M+)
Elemental Analysis: Theoretical Value (/%) C; 90.96, H; 9.04, Actual Measured Value (/%) C; 90.93, H; 9.01

### (Synthesis Example B23)

A product was obtained by carting out the reaction in the same manner as Synthesis Example B12 except that bromo tri(diamantane) was prepared instead of the bromo diamantane.

Here, the appearance of the product and the results of the mass analysis and the elemental analysis are shown. These data indicates that the above obtained product is a compound in which n is 3 in the above formula (4').

Appearance: White Solid
MS(FD)(m/z) : 684 (M+)
Elemental Analysis: Theoretical Value (/%) C; 91.17, H; 8.83, Actual Measured Value (/%) C; 91.14, H; 8.86

### [B2] Preparation of Composition for Film Formation

### (Prepared Example B1)

5 g of the 3,5-dimethyl-1,7-bis(3,5-diethynyl phenyl) adamantane synthesized in Synthesis Example A1 as the polymerizable compound was dissolved into 45 g of 1,3-dimethoxy benzene and reacted under dry nitrogen gas at 170°C for 3 hours to obtain a reaction liquid, and then the reaction liquid was once cooled down to room temperature. When a molecular weight of a product contained in the reaction liquid was measured using GPC, a number average molecular weight thereof was 46,000.
The reaction liquid was heated once again, the 3,5-dimethyl-1,7-bis(3,5-diethynyl phenyl) adamantane was reacted at 150°C for 6 hours. Thereafter, the reaction liquid was dropped into 10 times of volume of a mixture solution containing methanol/tetrahydrofuran = 3/1 to produce a precipitate, and then the precipitate was collected, to thereby 2.8 g of a prepolymer (yield: 56%). 2 g of the obtained prepolymer was dissolved into 18 g of cyclopentanone, and then filtrated by the filter, to thereby obtain a composition for film formation as a varnish for organic insulating film.

### (Prepared Examples B2 to B23)

The polymerization reaction was carried out in the same manner as Prepared Example B1 to obtain a prepolymer except that the polymerizable compound synthesized in each of Synthesis Examples B2 to B23 was used. Further, the same treatment as described in Prepared Example B1 was performed using 2 g of the obtained prepolymer, to thereby prepare a composition for film formation as a varnish for organic insulating film.

Here, with regard to the polymerizable compound contained in the composition for film formation prepared in each of Prepared Examples, the number of carbon atoms derived from the aromatic ring, the number of carbon atoms derived from the polymerizable reactive group, the number of carbon atoms derived from the partial structure and a ratio of the carbon atoms derived from the aromatic ring are, respectively, shown in Table 5.

[Table 5]

**Table 5**

| | Number of Carbon Atoms Derived from Aromatic Ring | Number of Carbon Atoms Derived from Polymerizable Reactive Group | Number of Carbon Atoms Derived from Partial Structure | Ratio of Carbon Atoms Derived from Aromatic Ring (%) |
|---|---|---|---|---|
| Pre. Ex. B1 | 12 | 20 | 12 | 38 |
| Pre. Ex. B2 | 12 | 20 | 24 | 27 |
| Pre. Ex. B3 | 12 | 20 | 36 | 21 |
| Pre. Ex. B4 | 12 | 20 | 48 | 18 |
| Pre. Ex. B5 | 12 | 20 | 60 | 15 |
| Pre. Ex. B6 | 12 | 20 | 14 | 35 |
| Pre. Ex. B7 | 12 | 20 | 28 | 25 |
| Pre. Ex. B8 | 12 | 20 | 42 | 19 |
| Pre. Ex. B9 | 12 | 20 | 56 | 16 |
| Pre. Ex. B10 | 6 | 10 | 12 | 27 |
| Pre. Ex. B11 | 6 | 10 | 24 | 18 |
| Pre. Ex. B12 | 6 | 10 | 14 | 25 |
| Pre. Ex. B13 | 6 | 10 | 28 | 16 |
| Pre. Ex. B14 | 12 | 20 | 12 | 38 |
| Pre. Ex. B15 | 12 | 20 | 24 | 27 |
| Pre. Ex. B16 | 12 | 20 | 36 | 21 |
| Pre. Ex. B17 | 12 | 20 | 48 | 18 |
| Pre. Ex. B18 | 12 | 20 | 60 | 15 |
| Pre. Ex. B19 | 12 | 20 | 14 | 35 |
| Pre. Ex. B20 | 12 | 20 | 28 | 25 |
| Pre. Ex. B21 | 12 | 20 | 42 | 19 |
| Pre. Ex. B22 | 12 | 20 | 56 | 16 |
| Pre. Ex. B23 | 6 | 10 | 42 | 12 |

### [B3] Formation of Insulating Film (Production of Substrate with Film)

A plurality of substrates with insulating films were produced as follows.

### (Examples B1 to B22)

A plurality of insulating films were formed using the composition for film formation as the varnish for organic insulating film obtained in each of Examples B1 to B22 as follows.

First, the composition for film formation as the varnish for organic insulating film was applied onto a silicon wafer using a spin coater to form a coating film. At this time, a rotation speed and a time of the spin coater was set so that a thickness of the insulating film after being subjected to a heat treatment would become 100 nm.

Next, the silicon wafer having the coating film formed in this way was placed on a hot plate heated at 200°C for 1 minute, to remove the solvent (cyclopentanone) from the coating film.

Thereafter, the silicon wafer having the dried coating film was subjected to a heat treatment (baking treatment) in which it was placed in an oven heated at 400°C under the nitrogen atmosphere for 30 minutes. In this way, an insulating film was formed by curing the prepolymer constituting the coating film, to thereby obtain a substrate with film (a substrate with insulating film).

### (Comparative Example B1)

Substrates with insulating films were produced in the same manner as the Examples except that the composition for film formation obtained in Prepared Example B23 was used.

### [B4] Evaluation of Insulating Film (Substrate with Insulating Film)

### [B4.1] Etching Rate Ratio

The insulating film of the substrate with insulating film of each of Examples and Comparative Examples produced in the above item [B3] was subjected to an etching treatment by a reactive ion etching method using a fluorine-based gas. Thereafter, a thickness of the insulating film before and after the etching was measured using a n&k Analyzer 1500 (produced by n&k Technology. Inc.). In this regard, in the case where a central coordinates was defined as (0, 0) and an orifla portion coordinates was (0, -38), 9 points existing in regular intervals on a line-coordinates from a coordinates (-38, 0) to a coordinates (38, 0) were selected as measurement points.
The etching rate (V₁ [nm/min]) was defined as a value obtained by dividing a changing ratio of an average value of the thicknesses in the 9 points after the etching to an average value of the thicknesses in the 9 points before the etching by the processing time of the reactive ion etching.

In this regard, it is to be noted that the reactive ion etching was carried out using L-201D-L (produced by ANELVA Corporation) at a frequency of 13.56 MHz, a pressure of 20 Pa, a power of 1,000 W and a flow rate (CF₄: 200 sccm, Argon gas: 400 sccm) for a treatment time of 10 seconds.

On the other hand, a SiO film having a thickness of 100 nm was formed onto a silicon wafer using a plasma CVD method to obtain a substrate with SiO film. The SiO film of the substrate with SiO film was etched by the reactive ion etching under the same conditions as the insulating film of the substrate with insulating film. In this way, an etching rate of the SiO film was obtained. The etching rate (V₂ [nm/min]) of the SiO film obtained as the result of measurement was 240 nm/min.

Thereafter, a value (V₁/V₂) obtained by dividing the etching rate (V₁) of the insulating film, which was formed in each of Examples and Comparative Examples, by the etching rate (V₂) of the SiO film was defined as the etching rate ratio.

### [B4.2] Permittivity

The permittivity was measured using an automatic mercury probe CV measuring apparatus ("SSM495" produced by JAPAN SSM corporation).

### [B4.3] Breakdown Voltage and Leak Current

The breakdown voltage and the leak current were measured using the automatic mercury probe CV measuring apparatus ("SSM495" produced by JAPAN SSM corporation) like the permittivity.

The breakdown voltage was defined as a voltage (MV) applied to the insulating film when a current of 1 × 10⁻² A flows therethrough, and was indicated by a field intensity (unit: MV/cm) which was a value obtained by dividing the voltage (MV) by a thickness of the insulating film.

The leak current was defined as a current value (A) flowing through the insulating film when a field intensity of 1 MV/cm was applied thereto, and was indicated by a field density (unit: A/cm²) which was a value obtained by dividing the current value (A) by an area of a mercury electrode provided in the automatic mercury probe CV measuring apparatus.

### [B4.4] Heat Resistance

The heat resistance was evaluated according to a thermal decomposition temperature of the obtained insulating film. A weight of the insulating film was measured using a TG/DTA measuring apparatus ("TG/DTA220" produced by Seiko Instruments, Inc.) under the nitrogen gas flow of 200 mL/min at a heating speed of 10°C/min, and then a temperature at which the weight of the insulating film decreased 5% was defined as the thermal decomposition temperature thereof.

### [B4.5] Etching Workability

A SiO film was formed onto the insulating film of the substrate with insulating film of each of Examples and Comparative Examples produced in the above item [B3] by a vapor phase film formation method so that a thickness thereof would become 50 nm as a cap layer. Next, a resist film was formed onto a surface of the cap layer, and then the resist film was subjected to an expose and development treatment using a photo mask to thereby form an opening portion (groove portion) into the resist film so as to correspond to a portion at which a groove for wiring would be formed. Next, the SiO film as the cap layer was subjected to an etching treatment by a reactive ion etching method using a mixture gas containing CF₄ and argon gas using the resist film as a mask, to thereby form a cap layer opening portion (groove portion) having a size of 130 nm.
In this regard, it is to be noted that the reactive ion etching was carried out using L-201D-L (produced by ANELVA Corporation) at a frequency of 13.56 MHz, a pressure of 20 Pa, a power of 1,000 W and a flow rate (CF₄: 200 sccm, Argon gas: 400 sccm). Further, the treatment time was controlled so that the cap layer was completely opened.

In the substrate with insulating film in which the above formed cap layer was opened, measured were an opening width of the cap layer and an opening width of the insulating film which was a lower layer of the cap layer and was obtained in each of Examples and Comparative Example based on SEM observation of a cross sectional view thereof. Thereafter, the presence or absence of a side-etching phenomenon, in which the opening width of the cap layer becomes larger than that of the opening width of the insulating film, was evaluated.

[Table 6]

**Table 6**

| | Etching Rate Ratio | Permittivity | Breakdown Voltage [MV/cm] | Leak Current [A/cm²] | Thermal Decomposition Temperature [°C] | Presence or Absence of Side-etching |
|---|---|---|---|---|---|---|
| Ex. B1 | 0.57 | 2.30 | 3.9 | 5.9×10⁻¹¹ | 486 | Absence |
| Ex. B2 | 0.48 | 2.24 | 4.2 | 1.8×10⁻¹¹ | 510 | Absence |
| Ex. B3 | 0.50 | 2.22 | 4.1 | 2.0×10⁻¹¹ | 504 | Absence |
| Ex. B4 | 0.53 | 2.18 | 4.1 | 3.8×10⁻¹¹ | 498 | Absence |
| Ex. B5 | 0.56 | 2.10 | 3.7 | 8.7×10⁻¹¹ | 463 | Absence |
| Ex. B6 | 0.57 | 2.25 | 4.1 | 2.3×10⁻¹⁰ | 502 | Absence |
| Ex. B7 | 0.52 | 2.23 | 4.0 | 2.1×10⁻¹⁰ | 498 | Absence |
| Ex. B8 | 0.56 | 2.21 | 3.9 | 3.5×10⁻¹⁰ | 479 | Absence |
| Ex. B9 | 0.57 | 2.13 | 3.4 | 6.7×10⁻¹⁰ | 448 | Absence |
| Ex. B10 | 0.51 | 2.32 | 3.9 | 3.2×10⁻¹¹ | 386 | Absence |
| Ex. B11 | 0.54 | 2.19 | 4.1 | 3.9×10⁻¹¹ | 496 | Absence |
| Ex. B12 | 0.58 | 2.37 | 1.9 | 8.3×10⁻⁸ | 367 | Absence |
| Ex. B13 | 0.57 | 2.32 | 1.9 | 8.6×10⁻⁸ | 352 | Absence |
| Ex. B14 | 0.59 | 2.33 | 3.6 | 4.7×10⁻¹¹ | 476 | Absence |
| Ex. B15 | 0.45 | 2.27 | 4.2 | 1.8×10⁻¹¹ | 510 | Absence |
| Ex. B16 | 0.49 | 2.21 | 4.0 | 2.6×10⁻¹¹ | 501 | Absence |
| Ex. B17 | 0.51 | 2.20 | 3.9 | 2.8×10⁻¹¹ | 492 | Absence |
| Ex. B18 | 0.52 | 2.11 | 3.4 | 6.8×10⁻¹¹ | 471 | Absence |
| Ex. B19 | 0.55 | 2.28 | 4.1 | 2.0×10⁻¹¹ | 501 | Absence |
| Ex. B20 | 0.49 | 2.21 | 4.0 | 2.0×10⁻¹¹ | 496 | Absence |
| Ex. B21 | 0.53 | 2.19 | 3.9 | 2.3×10⁻¹¹ | 476 | Absence |
| Ex. B22 | 0.55 | 2.11 | 3.7 | 5.9×10⁻¹¹ | 453 | Absence |
| Comp. Ex. B1 | 0.85 | 2.26 | 1.7 | 9.6×10⁻⁸ | 338 | Presence |

As evidenced by Table 6, in the present invention, excellent results are obtained. On the other hand, in Comparative Example, sufficient results are not obtained.

### <Example Group C>

### [C1] Synthesis of Polymerizable Compound

### (Synthesis Example C1)

First, 1,3-dimethyl adamantane was prepared, 700 mL of carbon tetrachloride and 35 g (0.22 mol) of bromine were put into a 2000 mL four neck flask provided with a thermometer, a stirrer and a reflux tube, and then 32.9 g (0.2 mol) of the prepared 1,3-dimethyl adamantane was added thereto little by little while stirring them. In this regard, while adding it, an inside temperature was kept at 20 to 30°C.
After the addition was finished, and then the temperature increase was stopped, they were reacted with each other for another hour. Thereafter, about 2000 mL of cold water was poured into the flask to produce a crude product, and then the crude product was filtrated and collected, washed with deionized water, and then dried.
Further, the crude product was recrystallized using heat ethanol to obtain a recrystallized product. The obtained recrystallized product was dried under reduced pressure to thereby obtain 37.4 g of a product. Absorption derived from a bromo group was observed within 690 to 515 cm⁻¹ by IR analysis and a molecular weight thereof was 322 by mass analysis. This result showed that the product was 3,5-dimethyl-1,7-dibromo adamantane.
Next, 33.2 g (103.2 mmol) of the above obtained 3,5-dimethyl-1,7-dibromo adamantane and 1,217 g (5,161.6 mmol) of 1,3-dibromo benzene were stirred in the flask, and then 24.8 g (93.0 mmol) of aluminium bromide(III) was added thereto at 25°C under dry nitrogen little by little. The same was heated up to 60°C and stirred for 8 hours, and then returned to room temperature, to thereby obtain a reaction liquid.
The reaction liquid was added to 700 mL of a 5% hydrochloric acid solution and stirred. A water phase was removed and an organic phase was added to 2,000 mL of acetone to obtain a precipitate. The precipitate was filtrated and washed three times with 1,000 mL of acetone, to thereby obtain 57 g of 3,5-dimethyl-1,7-bis(3,5-dibromo phenyl) adamantane. A molecular weight thereof was 632 by mass analysis. This result showed that the product was 3,5-dimethyl-1,7-bis(3,5-dibromo phenyl) adamantane.
Next, 39.8 g (62.9 mmol) of 3,5-dimethyl-1,7-bis(3,5-dibromo phenyl) adamantane obtained above, 3.53 g (5.0 mmol) of dichloro bistriphenyl phosphine palladium, 6.60 g (25.2 mmol) of triphenyl phosphine, 4.79 g (25.2 mmol) of copper iodide(II) and 750 mL of triethyl amine were put into the flask and stirred. The same was heated up to 75°C, and then 37.1 g (377.7 mmol) of trimethyl silyl acetylene was slowly added thereto. This was stirred at 75°C for 7 hours, and then heated up to 120°C to remove the triethyl amine therefrom.
Thereafter, this was returned to room temperature, 1,000 mL of dichloro methane was added to the reaction liquid and stirred for 20 minutes to obtain a precipitate. The precipitate was removed by filtration to obtain a filtrate, and then 1,000 mL of a 5% hydrochloric acid solution was added to the filtrate so that it was separated. An organic phase was washed three times with 1,000 mL of water, and then a solvent was removed from the organic phase under reduced pressure, to thereby obtain a compound.
The obtained compound was dissolved into 1,500 mL of hexane to produce an insoluble product. The insoluble product was removed by filtration to obtain a filtrate, and then the hexane was removed from the filtrate. 1,000 mL of acetone was added thereto to produce a precipitate, and then the precipitate was washed three times with acetone, to thereby obtain 36.1 g of 3,5-dimethyl-1,7-bis(3,5-ditrimethyl silyl ethynyl phenyl) adamantane. A molecular weight thereof was 701 by mass analysis. This result showed that the product was 3,5-dimethyl-1,7-bis(3,5-ditrimethyl silyl ethynyl phenyl) adamantane.
Further, 32.3 g (46.1 mmol) of the 3,5-dimethyl-1,7-bis(3,5-ditrimethyl silyl ethynyl phenyl) adamantane obtained above and 1.46 g (10.6 mmol) of potassium carbonate were reacted with each other in a mixture solvent containing 600 mL of tetrahydrofuran and 300 mL of methanol under nitrogen atmosphere at room temperature for 4 hours. The same was added to 1,000 mL of a 10% hydrochloric acid solution to obtain a precipitate, and then the precipitate was filtrated. Thereafter, the obtained precipitate was washed with 1,000 mL of water, washed with 1,000 mL of acetone, and then dried, to thereby obtain 15.0 g of 3,5-dimethyl-1,7-bis(3,5-diethynyl phenyl) adamantane as a polymerizable compound X.
Hereinbelow, the appearance of the product and the results of the mass analysis and an elemental analysis are shown. These data indicates that the above obtained product is 3,5-dimethyl-1,7-bis(3,5-diethynyl phenyl) adamantane.
Appearance: White Solid
MS(FD)(m/z) : 413 (M+)
Elemental Analysis: Theoretical Value (/%) C; 93.16, H; 6.84, Actual Measured Value (/%) C; 93.11, H; 6.82

### (Synthesis Examples C2 to C5)

A polymerizable compound X was obtained in the same manner as Synthesis Example C1 except that tetramethyl biadamantane, hexamethyl triadamantane, octamethyl tetraadamantane or decamethyl pentaadamantane was prepared instead of the dimethyl adamantane.
In this regard, it is to be noted that a structural formula of the polymerizable compound X obtained in each of Synthesis Examples C1 to C5 is shown in the following formula (1). In the following formula (1), n is an integral number of 1 to 5 and the number of n corresponds to the number (figure) of each Synthesis Example.

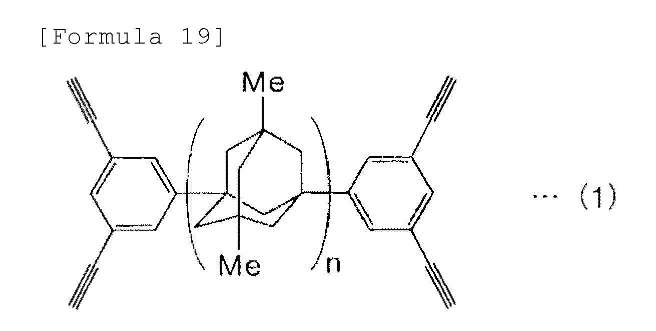

Here, the appearance of the polymerizable compound X in which n is 2 in the above formula (1) (Synthesis Example C2) and the results of the mass analysis and the elemental analysis are shown.
Appearance: White Solid
MS(FD)(m/z) : 574 (M+)
Elemental Analysis: Theoretical Value (/%) C; 91.93, H; 8.07, Actual Measured Value (/%) C; 91.87, H; 8.00
Further, the appearance of the polymerizable compound X in which n is 3 in the above formula (1) (Synthesis Example C3) and the results of the mass analysis and the elemental analysis are shown.
Appearance: White Solid
MS(FD)(m/z) : 737 (M+)
Elemental Analysis: Theoretical Value (/%) C; 91.25, H; 8.75, Actual Measured Value (/%) C; 91.21, H; 8.77
The appearance of the polymerizable compound X in which n is 4 in the above formula (1) (Synthesis Example C4) and the results of the mass analysis and the elemental analysis are shown.
Appearance: White Solid
MS(FD)(m/z) : 899(M+)
Elemental Analysis: Theoretical Value (/%) C; 90.81, H; 9.19, Actual Measured Value (/%) C; 90.75, H; 9.16
The appearance of the polymerizable compound X in which n is 5 in the above formula (1) (Synthesis Example C5) and the results of the mass analysis and the elemental analysis are shown.
Appearance: White Solid
MS(FD)(m/z) : 1,062(M+)
Elemental Analysis: Theoretical Value (/%) C; 90.51, H; 9.49, Actual Measured Value (/%) C; 90.49, H; 9.47

### (Synthesis Example C6)

First, according to a synthesis method described in Journal of Organic Chemistry., 39, 2987-3003 (1974), 4,9-dibromo diamantane was synthesized. Absorption derived from a bromo group was observed within 690 to 515 cm⁻¹ by IR analysis and a molecular weight thereof was 346 by mass analysis. This result showed that the product was 4,9-dibromo diamantane.
Next, in the synthesis of the 3,5-dimethyl-1,7-bis(3,5-dibromo phenyl) adamantane as the synthetic intermediate of Synthesis Example C1, the reaction was carried out in the same manner as Synthesis Example C1 except that 35.7 g (103.1 mmol) of the above obtained 4,9-dibromo diamantane was used instead of the 3,5-dimethyl-1,7-dibromo adamantane. In this way, 56 g of 4,9-bis(3,5-dibromo phenyl) diamantane was obtained. A molecular weight thereof was 656 by mass analysis. This result showed that the product was 4,9-bis(3,5-dibromo phenyl) diamantane.
Next, the reaction was carried out in the same manner as Synthesis Example C1 except that the above obtained 4,9-bis(3,5-dibromo phenyl) diamantane was used instead of the 3,5-dimethyl-1,7-bis(3,5-dibromo phenyl) adamantane, to thereby obtain 4,9-bis(3,5-ditrimethyl silyl ethynyl phenyl) diamantane.
Hereinbelow, the appearance of the product and the results of the mass analysis and an elemental analysis are shown. These data indicates that the above obtained product is 4,9-bis(3,5-diethynyl phenyl) diamantane.
Appearance: White Solid
MS(FD)(m/z) : 436(M+)
Elemental Analysis: Theoretical Value (/%) C; 93.54, H; 6.46, Actual Measured Value (/%) C; 93.46, H; 6.38

### (Synthesis Examples C7 to C9)

A polymerizable compound X was obtained in the same manner as Synthesis Example C6 except that dibromo di(diamantane), dibromo tri(diamantane) or dibromo tetra(diamantane) was prepared instead of the dibromo diamantane.
In this regard, it is to be noted that a structural formula of the polymerizable compound X obtained in each of Synthesis Examples C6 to C9 is shown in the following formula (4). In the following formula (4), n is an integral number of 1 to 4 and the number of n corresponds to (the figure of each Synthesis Example - 5).

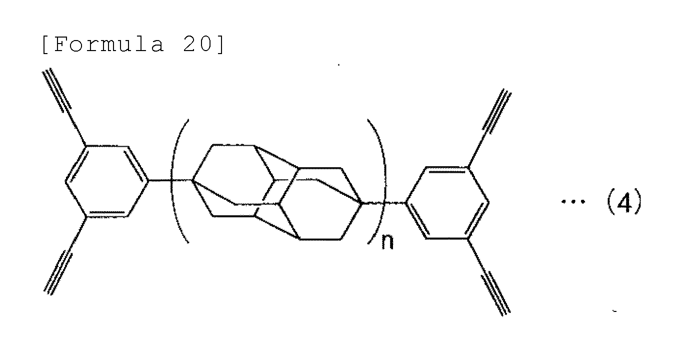

Here, the appearance of the polymerizable compound X in which n is 2 in the above formula (4) (Synthesis Example C7) and the results of the mass analysis and the elemental analysis are shown.
Appearance: White Solid
MS (FD) (m/z): 622 (M+)
Elemental Analysis: Theoretical Value (/%) C; 92.56, H; 7.44, Actual Measured Value (/%) C; 92.53, H; 7.41
Further, the appearance of the polymerizable compound X in which n is 3 in the above formula (4) (Synthesis Example C8) and the results of the mass analysis and the elemental analysis are shown.
Appearance: White Solid
MS(FD)(m/z) : 809(M+)
Elemental Analysis: Theoretical Value (/%) C; 92.03, H; 7.97, Actual Measured Value (/%) C; 92.01, H; 7.94
The appearance of the polymerizable compound X in which n is 4 in the above formula (4) (Synthesis Example C9) and the results of the mass analysis and the elemental analysis are shown.
Appearance: White Solid
MS(FD)(m/z) : 995(M+)
Elemental Analysis: Theoretical Value (/%) C; 91.70, H; 8.30, Actual Measured Value (/%) C; 91.67, H; 8.28

### (Synthesis Example C10)

14.4 g (34.9 mmol) of the 3,5-dimethyl-1,7-bis(3,5-diethynyl phenyl) adamantane obtained in Synthesis Example C1, 67.4 g (522 mmol) of quinoline, 0.37 g (0.174 mmol) of 5% palladium-calcium carbonate and 1,000 mL of tetrahydrofuran were put into a 5 L eggplant flask together with a stirring bar, and then stirring was started at room temperature while flowing hydrogen gas. When 3.35 L (139 mmol) of the hydrogen gas was consumed, the reaction was stopped by introducing nitrogen gas into the flask, to thereby obtain a reaction liquid.
Thereafter, the reaction liquid was filtrated to obtain a filtration, and then the solvent was removed from the filtration to obtain a solid. The obtained solid was purified using a silica gel chromatography, to thereby obtain 18.1 g of 3,5-dimethyl-1,7-bis(3,5-divinyl phenyl) adamantane as a polymerizable compound X.
Hereinbelow, the appearance of the product and the results of the mass analysis and an elemental analysis are shown. These data indicates that the above obtained product is 3,5-dimethyl-1,7-bis(3,5-divinyl phenyl) adamantane.
Appearance: White Solid
MS(FD)(m/z) : 420 (M+)
Elemental Analysis: Theoretical Value (/%) C; 91.37, H; 8.63, Actual Measured Value (/%) C; 91.35, H; 8.60

### (Synthesis Examples C11 to C18)

A polymerizable compound X was obtained in the same manner as Synthesis Example C10 except that the polymerizable compound obtained in each of Synthesis Examples C2 to C9 was prepared instead of the 3,5-dimethyl-1,7-bis(3,5-diethynyl phenyl) adamantane.
In this regard, it is to be noted that a structural formula of the polymerizable compound X obtained in each of Synthesis Examples C10 to C14 is shown in the following formula (5) and a structural formula of the polymerizable compound X obtained in each of Synthesis Examples C15 to C18 is shown in the following formula (6). Further, in the following formula (5), n is an integral number of 1 to 5 and the number of n corresponds to (the figure of each Synthesis Example - 9) and in the following formula (6), n is an integral number of 1 to 4 and the number of n corresponds to (the figure of each Synthesis Example - 14).

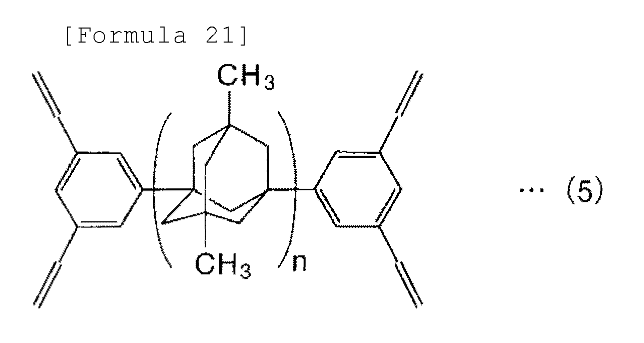

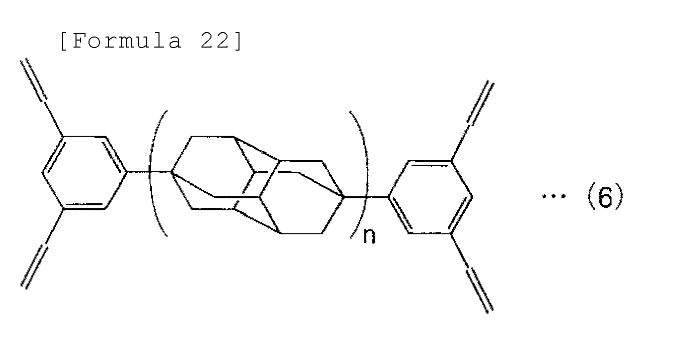

Here, the appearance of the polymerizable compound X in which n is 2 in the above formula (5) (Synthesis Example C11) and the results of the mass analysis and the elemental analysis are shown.
Appearance: White Solid
MS(FD)(m/z) : 582 (M+)
Elemental Analysis: Theoretical Value (/%) C; 90.66, H; 9.34, Actual Measured Value (/%) C; 90.63, H; 9.31
Further, the appearance of the polymerizable compound X in which n is 3 in the above formula (5) (Synthesis Example C12) and the results of the mass analysis and the elemental analysis are shown.
Appearance: White Solid
MS(FD)(m/z) : 745(M+)
Elemental Analysis: Theoretical Value (/%) C; 90.26, H; 9.74, Actual Measured Value (/%) C; 90.24, H; 9.70
The appearance of the polymerizable compound X in which n is 4 in the above formula (5) (Synthesis Example C13) and the results of the mass analysis and the elemental analysis are shown.
Appearance: White Solid
MS (FD) (m/z): 907(M+)
Elemental Analysis: Theoretical Value (/%) C; 90.00, H; 10.00, Actual Measured Value (/%) C; 89.96, H; 9.97
The appearance of the polymerizable compound X in which n is 5 in the above formula (5) (Synthesis Example C14) and the results of the mass analysis and the elemental analysis are shown.
Appearance: White Solid
MS(FD)(m/z) : 1,069(M+)
Elemental Analysis: Theoretical Value (/%) C; 89.82, H; 10.18, Actual Measured Value (/%) C; 89.80, H; 10.14
The appearance of the polymerizable compound X in which n is 1 in the above formula (6) (Synthesis Example C15) and the results of the mass analysis and the elemental analysis are shown.
Appearance: White Solid
MS(FD)(m/z) : 444 (M+)
Elemental Analysis: Theoretical Value (/%) C; 91.84, H; 8.16, Actual Measured Value (/%) C; 91.81, H; 8.13
The appearance of the polymerizable compound X in which n is 2 in the above formula (6) (Synthesis Example C16) and the results of the mass analysis and the elemental analysis are shown.
Appearance: White Solid
MS(FD)(m/z) : 630 (M+)
Elemental Analysis: Theoretical Value (/%) C; 91.37, H; 8.63, Actual Measured Value (/%) C; 91.32, H; 8.61
The appearance of the polymerizable compound X in which n is 3 in the above formula (6) (Synthesis Example C17) and the results of the mass analysis and the elemental analysis are shown.
Appearance: White Solid
MS(FD)(m/z) : 817 (M+)
Elemental Analysis: Theoretical Value (/%) C; 91.12, H; 8.88, Actual Measured Value (/%) C; 91.10, H; 8.84
The appearance of the polymerizable compound X in which n is 4 in the above formula (6) (Synthesis Example C18) and the results of the mass analysis and the elemental analysis are shown.
Appearance: White Solid
MS(FD)(m/z) : 1,003(M+)
Elemental Analysis: Theoretical Value (/%) C; 90.96, H; 9.04, Actual Measured Value (/%) C; 90.93, H; 9.01

A polymerizable compound X was obtained according to a synthesis method described in Macromolecules., 5266 (1991) except that dodecamethyl hexa-adamantane was prepared instead of the diadamantane.
The appearance of the obtained product and the results of the mass analysis and an elemental analysis are shown.
Appearance: White Solid
MS(FD)(m/z) : 1,023(M+)
Elemental Analysis: Theoretical Value (/%) C; 89.17, H; 10.83, Actual Measured Value (/%) C; 89.15, H; 10.80
These data indicates that the above obtained product is a compound represented by the following formula (7).

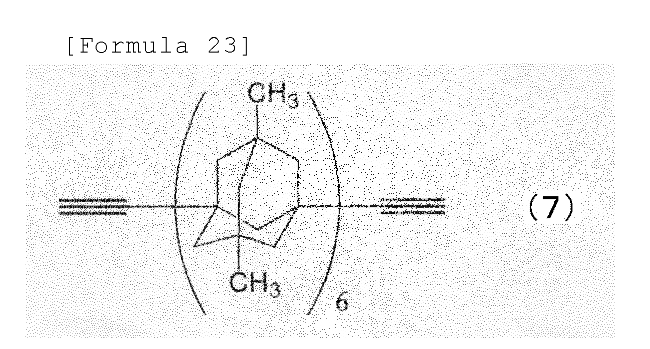

A polymerizable compound X was obtained according to a synthesis method described in Macromolecules., 5266 (1991) except that dodecamethyl hexa(diamantane) was prepared in stead of the diadamantane.
The appearance of the obtained product and the results of the mass analysis and an elemental analysis are shown.
Appearance: White Solid
MS (FD) (m/z): 1,167(M+)
Elemental Analysis: Theoretical Value (/%) C; 90.51, H; 9.49, Actual Measured Value (/%) C; 90.49, H; 9.47
These data indicates that the above obtained product is a compound represented by the following formula (8).

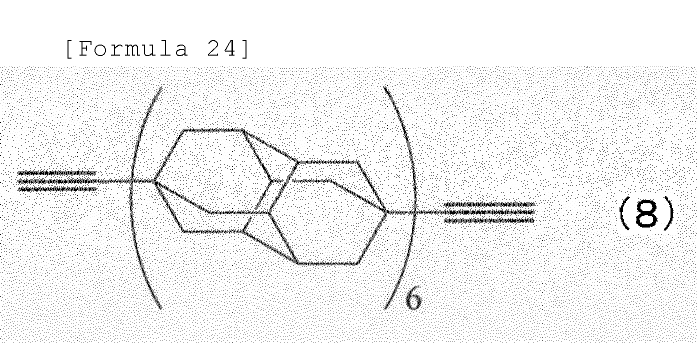

### [C2] Preparation of Composition for Film Formation

### (Example C1)

5 g of the 3,5-dimethyl-1,7-bis(3,5-diethynyl phenyl) adamantane synthesized in Synthesis Example C1 as the polymerizable compound was dissolved into 45 g of 1,3-dimethoxy benzene and reacted under dry nitrogen gas at 170°C for 3 hours to obtain a reaction liquid, and then the reaction liquid was once cooled down to room temperature. When a molecular weight of a product contained in the reaction liquid was measured using GPC, a number average molecular weight thereof was 46,000.
The reaction liquid was heated once again, the 3,5-dimethyl-1,7-bis(3,5-diethynyl phenyl) adamantane was reacted at 150°C for 6 hours. Thereafter, the reaction liquid was dropped into 10 times of volume of a mixture solution containing methanol/tetrahydrofuran = 3/1 to produce a precipitate, and then the precipitate was collected, to thereby 2.8 g of a prepolymer (yield: 56%). 2 g of the obtained prepolymer was dissolved into 18 g of cyclopentanone, and then filtrated by the filter, to thereby obtain a composition for film formation as a varnish for organic insulating film.

### (Examples C2 to C18)

The polymerization reaction was carried out in the same manner as Example C1 to obtain a prepolymer except that the polymerizable compound synthesized in each of Synthesis Examples C2 to C18 was used. Further, the same treatment as described in Example C1 was performed using 2 g of the obtained prepolymer, to thereby prepare a composition for film formation as a varnish for organic insulating film.

### (Comparative Examples C1 and C2)

The polymerization reaction was carried out in the same manner as Example C1 to obtain a prepolymer except that the polymerizable compound synthesized in each of Synthesis Examples C19 and C20 was used. Further, the same treatment as described in Example C1 was performed using 2 g of the obtained prepolymer, to thereby prepare a composition for film formation as a varnish for organic insulating film.
Here, with regard to the polymerizable compound contained in the composition for film formation prepared in each of Examples and Comparative Examples, the number of carbon atoms derived from the aromatic ring, the number of carbon atoms derived from the polymerizable reactive group, the number of carbon atoms derived from the partial structure and a ratio of the carbon atoms derived from the aromatic ring are, respectively, shown in Table 7.

[Table 7]

**Table 7**

| | Synthesis Example | Number of Carbon Atoms Derived from Aromatic Ring | Number of Carbon Atoms Derived from Polymerizable Reactive Group | Number of Carbon Atoms Derived from Partial Structure | Ratio of Carbon Atoms Derived from Aromatic Ring (%) | Baking Temperature [°C] |
|---|---|---|---|---|---|---|
| Ex. C1 | C1 | 12 | 20 | 12 | 38 | 350 |
| Ex. C2 | C2 | 12 | 20 | 24 | 27 | 350 |
| Ex. C3 | C3 | 12 | 20 | 36 | 21 | 330 |
| Ex. C4 | C4 | 12 | 20 | 48 | 18 | 350 |
| Ex. C5 | C5 | 12 | 20 | 60 | 15 | 350 |
| Ex. C6 | C6 | 12 | 20 | 14 | 35 | 350 |
| Ex. C7 | C7 | 12 | 20 | 28 | 25 | 350 |
| Ex. C8 | C8 | 12 | 20 | 42 | 19 | 350 |
| Ex. C9 | C9 | 12 | 20 | 56 | 16 | 330 |
| Ex. C10 | C10 | 12 | 20 | 12 | 38 | 350 |
| Ex. C11 | C11 | 12 | 20 | 24 | 27 | 350 |
| Ex. C12 | C12 | 12 | 20 | 36 | 21 | 330 |
| Ex. C13 | C13 | 12 | 20 | 48 | 18 | 350 |
| Ex. C14 | C14 | 12 | 20 | 60 | 15 | 350 |
| Ex. C15 | C15 | 12 | 20 | 14 | 36 | 350 |
| Ex. C16 | C16 | 12 | 20 | 28 | 25 | 350 |
| Ex. C17 | C17 | 12 | 20 | 42 | 19 | 350 |
| Ex. C18 | C18 | 12 | 20 | 56 | 16 | 330 |
| Comp. Ex. C1 | C19 | 0 | 4 | 72 | 0 | 350 |
| Comp. Ex. C2 | C20 | 0 | 4 | 84 | 0 | 350 |

### [C3] Formation of Insulating Film (Production of Substrate with Film)

A plurality of insulating films were formed using the composition for film formation as the varnish for organic insulating film obtained in each of Examples and Comparative Examples as follows.
First, for evaluation of permittivity, a breakdown voltage, a leak current and heat resistance, the composition for film formation as the varnish for organic insulating film was applied onto a silicon wafer using a spin coater to form a coating film. At this time, a rotation speed and a time of the spin coater was set so that a thickness of the insulating film after being subjected to a heat treatment would correspond to each evaluation method. Next, the silicon wafer having the coating film formed in this way was placed on a hot plate heated at 200°C for 1 minute, to remove the solvent (cyclopentanone) from the coating film.
For evaluation of a m-ELT and a tape test, the application and the removal of the solvent were carried out in the same manner as the formation of the insulating film for the evaluation of the permittivity, the breakdown voltage, the leak current and the heat resistance, except that used was a wafer with SiCN film obtained by forming a SiCN film having a thickness of 50 nm onto a silicon wafer by a vapor phase film formation method instead of the silicon wafer.
Thereafter, for the evaluation of the m-ELT, the tape test and the heat resistance, each dried coating film was subjected to a heat treatment (baking treatment) in an oven heated at a temperature shown in Table 7 under the nitrogen atmosphere for 30 minutes. In this way, an insulating film was formed by curing the prepolymer constituting the coating film, to thereby obtain a substrate with film (a substrate with insulating film).
Further, for the evaluation of the permittivity, the breakdown voltage and the leak current, each dried coating film was subjected to a heat treatment (baking treatment) in an oven heated at 400°C under the nitrogen atmosphere for 30 minutes. In this way, an insulating film was formed by curing the prepolymer constituting the coating film, to thereby obtain a substrate with film (a substrate with insulating film). An evaluation method of hillock resistance was described in an item [C5].

### [C4] Evaluation of Insulating Film (Substrate with Film)

### [C4.1] Permittivity

The permittivity was measured using an automatic mercury probe CV measuring apparatus ("SSM495" produced by JAPAN SSM corporation).
A thickness of the insulating film was 100 nm.

### [C4.2] m-ELT

A m-ELT was carried out by evaluating the substrate with film of each of Examples and Comparative Examples produced in the above item [C3] using Laminar Series2 (produced by FSM (Frontier Semiconductor, Inc)).
A thickness of the insulating film was 150 nm.

### [C4.3] Tape Test

An adhesive property of the substrate with film of each of Examples and Comparative Examples produced in the above item [C3] was evaluated using a tape test according to adhesion (cross-cut method) described in JIS K 5600-5-6. Namely, 100 cells each having a size of 1 mm square were formed into the insulating film using a cutter knife, and then Sellotape (registered trademark) was attached thereonto. After 1 minute, the Sellotape was peeled off from the substrate, while being fixed. The number of the cells peeled off from the substrate was counted.
A thickness of the insulating film was 100 nm.

### [C4.4] Breakdown Voltage and Leak Current

The breakdown voltage and the leak current were measured using the automatic mercury probe CV measuring apparatus ("SSM495" produced by JAPAN SSM corporation) like the permittivity.
The breakdown voltage was defined as a voltage (MV) applied to the insulating film when a current of 1 × 10⁻² A flows therethrough, and was indicated by a field intensity (unit: MV/cm) which was a value obtained by dividing the voltage (MV) by a thickness of the insulating film.
The leak current was defined as a current value (A) flowing through the insulating film when a field intensity of 1 MV/cm was applied thereto, and was indicated by a field density (unit: A/cm²) which was a value obtained by dividing the voltage value (A) by an area of a mercury electrode provided in the automatic mercury probe CV measuring apparatus.

### [C4.5] Heat Resistance

The heat resistance was evaluated according to a thermal decomposition temperature of the obtained insulating film. A weight of the insulating film was measured using a TG/DTA measuring apparatus ("TG/DTA220" produced by Seiko Instruments, Inc.) under the nitrogen gas flow of 200 mL/min at a heating speed of 10°C/min, and then a temperature at which the weight of the insulating film decreased 5% was defined as the thermal decomposition temperature thereof.

### [C5] Anti Hillock Property

### [C5] Hillock Resistance

A semiconductor device having two layer including wirings with a half pitch of 65 nm was manufactured according to the steps described in the explanation of the above method for manufacturing a semiconductor device (see FIGs. 3 to 5). At this time, a silicon substrate was used as the semiconductor substrate, a SiCN film having a thickness of 30 nm and formed by a CVD method was used as the barrier insulating film, a film having a thickness of 100 nm and formed using each composition for film formation prepared in the above item [C2] by the same method as described in the above item [C3] was used as the interlayer insulating film.
Further, a SiO film having a thickness of 60 nm and formed by a CVD method was used as the cap film, a TaN film and a Ta film, which are formed by a PVD method so as to become a total thickness 20 nm, respectively, were used as the barrier metal film. Thereafter, the semiconductor device was subjected to a heat treatment at 400°C for 30 minutes, and then the presence of absence of copper hillock was confirmed.

[Table 8]

**Table 8**

| | Synthesis Example | Permittivity | m-ELT [Mpa·m^{(1/2)}] | Tape Test | Hillock |
|---|---|---|---|---|---|
| Ex. C1 | C1 | 2.30 | 0.15 | No peel off | Absence |
| Ex. C2 | C2 | 2.24 | 0.22 | No peel off | Absence |
| Ex. C3 | C3 | 2.22 | 0.23 | No peel off | Absence |
| Ex. C4 | C4 | 2.18 | 0.23 | No peel off | Absence |
| Ex. C5 | C5 | 2.10 | 0.21 | No peel off | Absence |
| Ex. C6 | C6 | 2.25 | 0.19 | No peel off | Absence |
| Ex. C7 | C7 | 2.23 | 0.18 | No peel off | Absence |
| Ex. C8 | C8 | 2.21 | 0.20 | No peel off | Absence |
| Ex. C9 | C9 | 2.13 | 0.17 | No peel off | Absence |
| Ex. C10 | C10 | 2.33 | 0.17 | No peel off | Absence |
| Ex. C11 | C11 | 2.27 | 0.29 | No peel off | Absence |
| Ex. C12 | C12 | 2.21 | 0.25 | No peel off | Absence |
| Ex. C13 | C13 | 2.20 | 0.24 | No peel off | Absence |
| Ex. C14 | C14 | 2.11 | 0.24 | No peel off | Absence |
| Ex. C15 | C15 | 2.28 | 0.21 | No peel off | Absence |
| Ex. C16 | C16 | 2.21 | 0.18 | No peel off | Absence |
| Ex. C17 | C17 | 2.19 | 0.19 | No peel off | Absence |
| Ex. C18 | C18 | 2.11 | 0.17 | No peel off | Absence |
| Comp. Ex. C1 | C19 | 2.41 | 0.12 | No peel off | Presence |
| Comp. Ex. C2 | C20 | 2.39 | 0.11 | No peel off | Presence |

[Table 9]

**Table 9**

| | Synthesis Example | Breakdown Voltage [MV/cm] | Leak Current [A/cm²] | Thermal Decomposition Temperature [°C] |
|---|---|---|---|---|
| Ex. C1 | C1 | 3.9 | 5.9×10⁻¹¹ | 485 |
| Ex. C2 | C2 | 4.2 | 1.8×10⁻¹¹ | 510 |
| Ex. C3 | C3 | 4.1 | 2.0×10⁻¹¹ | 501 |
| Ex. C4 | C4 | 4.1 | 3.8×10⁻¹¹ | 496 |
| Ex. C5 | C5 | 3.7 | 8.7×10⁻¹¹ | 460 |
| Ex. C6 | C6 | 4.1 | 2.3×10⁻¹⁰ | 501 |
| Ex. C7 | C7 | 4.0 | 2.1×10⁻¹⁰ | 497 |
| Ex. C8 | C8 | 3.9 | 3.5×10⁻¹⁰ | 477 |
| Ex. C9 | C9 | 3.4 | 6.7×10⁻¹⁰ | 445 |
| Ex. C10 | C10 | 3.6 | 4.7×10⁻¹¹ | 475 |
| Ex. C11 | C11 | 4.2 | 1.8×10⁻¹¹ | 510 |
| Ex. C12 | C12 | 4.0 | 2.6×10⁻¹¹ | 498 |
| Ex. C13 | C13 | 3.9 | 2.8×10⁻¹¹ | 490 |
| Ex. C14 | C14 | 3.4 | 6.8×10⁻¹¹ | 468 |
| Ex. C15 | C15 | 4.1 | 2.0×10⁻¹¹ | 500 |
| Ex. C16 | C16 | 4.0 | 2.0×10⁻¹¹ | 495 |
| Ex. C17 | C17 | 3.9 | 2.3×10⁻¹¹ | 473 |
| Ex. C18 | C18 | 3.4 | 5.9×10⁻¹¹ | 450 |
| Comp. Ex. C1 | C19 | 3.5 | 9.0×10⁻¹¹ | 311 |
| Comp. Ex. C2 | C20 | 3.3 | 7.0×10⁻¹⁰ | 306 |

As evidenced by Tables 8 and 9, in each of Examples C1 to C18, the adhesive property evaluated by the m-ELT method is excellent and the generation of the hillock is suppressed. Further, superior results are obtained in the permittivity, the breakdown voltage, the leak current and the heat resistance defined by the thermal decomposition temperature.
On the other hand, in each of Comparative Examples, there is no problem in the adhesive property according to a conventional tape test. However, the adhesive property evaluated by the m-ELT method is low and the generation of the hillock is remarkably observed.

### INDUSTRIAL APPLICABILITY

According to the present invention, since an insulating film formed using a composition for film formation hardly suffers damages during an etching step, it does not have high permittivity to thereby maintain properties thereof. Further, it is possible to provide a semiconductor device including the insulating film and having excellent reliability. Therefore, the film for semiconductor of the present invention provides industrial applicability.

## Claims

1. A composition for film formation comprising:
polymerizable compounds each having at least one polymerizable functional group,
wherein each of the polymerizable compounds includes a partial structure containing an adamantane type cage structure and at least one polymerizable reactive group contributing to polymerization reaction in one molecule thereof,
wherein the polymerizable reactive group contains an aromatic ring and at least one ethynyl or vinyl group directly bonded to the aromatic ring as the polymerizable functional group, and
wherein the number of carbon atoms derived from the aromatic ring is in the range of 15 to 38% with respect to the number of total carbon atoms of the polymerizable compound.

2. The composition for film formation as claimed in claim 1, wherein the at least one polymerizable reactive group comprises two polymerizable reactive groups which are symmetrically located about the partial structure.

3. The composition for film formation as claimed in claim 1, wherein the aromatic ring is directly bonded to the cage structure.

4. The composition for film formation as claimed in claim 1, wherein the at least one ethynyl or vinyl group of the polymerizable reactive group comprises two ethynyl or vinyl groups, and one of the ethynyl or vinyl groups is located in a meta position relative to the other ethynyl or vinyl group.

5. The composition for film formation as claimed in claim 4, wherein both the two ethynyl or vinyl groups are located in meta positions relative to a position of the aromatic ring to which the cage structure is bonded.

6. The composition for film formation as claimed in claim 4, wherein some of the polymerizable compounds are polymerized with each other via the one ethynyl or vinyl groups to form a polymer.

7. The composition for film formation as claimed in claim 1, wherein the partial structure contains an adamantane structure as the adamantane type cage structure.

8. The composition for film formation as claimed in claim 7, wherein the adamantane structure has a methyl group as a substituent thereof.

9. The composition for film formation as claimed in claim 8, wherein the polymerizable compound has a structure represented by the following formula (1): 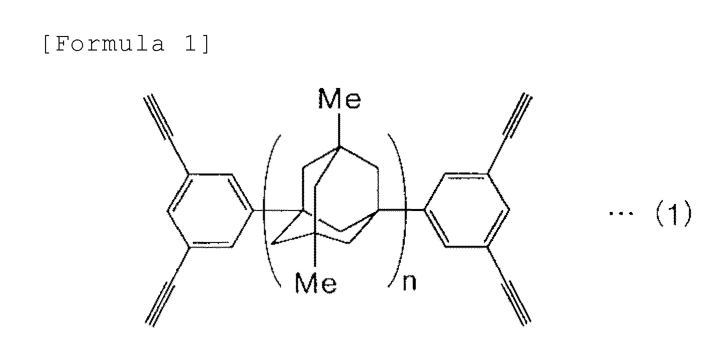 where n is an integral number of 1 to 5.

10. The composition for film formation as claimed in claim 1, wherein the partial structure contains a diamantane structure as the adamantane type cage structure.

11. The composition for film formation as claimed in claim 1, wherein the composition does not contain any pore generation agent having a function of generating pores into an obtained insulating film due to thermal decomposition thereof.

12. An insulating film formed using the composition for film formation defined by claim 1.

13. The insulating film as claimed in claim 12, wherein in the case where a surface of the insulating film is etched by a reactive ion etching method using a mixture gas of nitrogen gas and hydrogen gas or ammonia gas as a treatment gas, a changing ratio of permittivity of the surface before and after being etched is 10% or less.

14. The insulating film as claimed in claim 12, wherein in the case where the insulating film is etched by a reactive ion etching method using a mixture gas of nitrogen gas and hydrogen gas or ammonia gas, an etching rate thereof is in the range of 10 to 90 Å/sec.

15. The insulating film as claimed in claim 12, wherein permittivity of the insulating film is in the range of 1.80 to 2.30.

16. The insulating film as claimed in claim 12, wherein in the case where the insulating film and a SiO film are etched using a fluorine-based gas, an etching rate of the insulating film is 0.75 times or less that of the SiO film.

17. The insulating film as claimed in claim 12, wherein adhesive strength between the insulating film and a SiCN film, which is measured by a m-ELT method (Modified-Edge Lift off Test), is in the range of 0.15 to 0.35 MPa·m^{(1/2)}.

18. A semiconductor device comprising the insulating film defined by claim 12.
